(19) Europäisches Patentamt
European Patent Office
Office européen des brevets

(11) EP 2 960 691 B1

(12) **EUROPEAN PATENT SPECIFICATION**

(45) Date of publication and mention of the grant of the patent:
**27.09.2017 Bulletin 2017/39**

(21) Application number: **14754459.7**

(22) Date of filing: **13.02.2014**

(51) Int Cl.:
*G02B 5/22* (2006.01) *G03B 11/00* (2006.01)
*G02B 13/00* (2006.01) *G02B 1/04* (2006.01)
*H01L 27/146* (2006.01) *H04N 5/33* (2006.01)
*G02B 5/20* (2006.01) *H04N 5/335* (2011.01)

(86) International application number:
**PCT/JP2014/053246**

(87) International publication number:
**WO 2014/129366 (28.08.2014 Gazette 2014/35)**

(54) **NEAR-INFRARED ABSORBING COMPOSITION, NEAR-INFRARED BLOCKING FILTER, METHOD FOR PRODUCING NEAR-INFRARED BLOCKING FILTER, CAMERA MODULE AND METHOD FOR MANUFACTURING CAMERA MODULE**

NAHINFRAROT-ABSORBIERENDE ZUSAMMENSETZUNG, NAHINFRAROT-SPERRFILTER, VERFAHREN ZUR HERSTELLUNG EINES NAHINFRAROT-SPERRFILTERS, KAMERAMODUL UND VERFAHREN ZUR HERSTELLUNG EINES KAMERAMODULS

COMPOSITION D'ABSORPTION PROCHE INFRAROUGE, FILTRE DE BLOCAGE PROCHE INFRAROUGE, PROCÉDÉ DE PRODUCTION DE FILTRE DE BLOCAGE PROCHE INFRAROUGE, MODULE DE CAMERA ET PROCÉDÉ DE FABRICATION DE MODULE DE CAMERA

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.02.2013 JP 2013030489**
**24.07.2013 JP 2013153989**

(43) Date of publication of application:
**30.12.2015 Bulletin 2015/53**

(73) Proprietor: **Fujifilm Corporation**
**Minato-ku**
**Tokyo 106-8620 (JP)**

(72) Inventors:
- **NARA Yuki**
  **Haibara-gun**
  **Shizuoka 421-0396 (JP)**
- **BAK Seongmu**
  **Haibara-gun**
  **Shizuoka 421-0396 (JP)**
- **EZOE Toshihide**
  **Haibara-gun**
  **Shizuoka 421-0396 (JP)**
- **KAWASHIMA Takashi**
  **Haibara-gun**
  **Shizuoka 421-0396 (JP)**
- **HITOMI Seiichi**
  **Haibara-gun**
  **Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 790 701** **WO-A1-2006/035756**
**JP-A- H11 302 308** **JP-A- 2000 310 948**
**JP-A- 2003 262 719** **JP-A- 2005 345 680**
**JP-A- 2008 091 535** **JP-A- 2010 002 825**
**JP-A- 2012 126 144** **US-A1- 2001 011 719**
**US-A1- 2004 082 460** **US-A1- 2007 099 787**
**US-A1- 2012 243 077**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## BACKGROUND OF THE INVENTION

1. Field of the Invention

The present invention relates to a near-infrared absorbing composition, a near-infrared blocking filter, a method for producing the near-infrared blocking filter, a camera module, and a method for manufacturing the camera module.

2. Description of the Related Art

In recent years, a CCD or CMOS image sensor that is a solid-state imaging element for color images has been used for video cameras, digital still cameras, mobile phones equipped with a camera function, and the like. In the solid-state imaging element, since a silicon photodiode having sensitivity to near-infrared rays is used in the light-receiving section, it is necessary to revise the luminosity factor and a near-infrared blocking filter (hereinafter, also referred to as the IR blocking filter) is frequently used.

As a material for the near-infrared blocking filter, JP2010-134457A discloses an infrared shielding film that includes an infrared shielding resin obtained by adding a metallic compound to a copolymer of a reactant of (meth)acrylamide and phosphoric acid or a hydrolysate thereof and a compound having an ethylenic unsaturated bond.

## SUMMARY OF THE INVENTION

In the technique disclosed in JP2010-134457A, the infrared shielding film has a thick film thickness and a low visible light transmissivity and is an unsatisfactory near-infrared blocking filter.

An object of the present invention is to provide a near-infrared blocking filter in which strong near-infrared shielding properties can be achieved, the film thickness can be decreased, and the visible light transmissivity is high.

Specifically, the above-described object has been achieved by means <1> described below and preferably means <2> to <16>.

<1> A near-infrared blocking filter, including a near-infrared absorbing substance,
in which a film thickness is 300 μm or less, and a visible light transmissivity in a wavelength range of 450 nm to 550 nm is 85% or more.

<2> The near-infrared blocking filter according to <1>, in which the near-infrared absorbing substance is a copper compound.

<3> The near-infrared blocking filter according to <2>, in which the copper compound is a phosphorous-containing copper complex or a sulfonic acid copper complex.

<4> The near-infrared blocking filter according to any one of <1> to <3>, further including a water-soluble binder.

<5> The near-infrared blocking filter according to <4>, in which the water-soluble binder is at least one of
a water-soluble epoxy resin,
a sol-gel cured substance obtained by hydrolyzing and polycondensing at least one of alkoxide compounds of an element selected from a group consisting of Si, Ti, Zr, and Al, and
gelatin.

<6> The near-infrared blocking filter according to any one of <1> to <5>, in which the film thickness is 200 μm or less.

<7> The near-infrared blocking filter according to any one of <1> to <6>, in which the visible light transmissivity in a wavelength range of 400 nm to 575 nm is 85% or more.

<8> The near-infrared blocking filter according to any one of <1> to <7>, in which the visible light transmissivity in the wavelength range of 450 nm to 550 nm is 90% or more.

<9> The near-infrared blocking filter according to any one of <1> to <8>, in which a light transmissivity in a wavelength range of 700 nm to 1100 nm is 20% or less.

<10> The near-infrared blocking filter according to any one of <1> to <9>, in which a light transmissivity in a wavelength range of 800 nm to 900 nm is 10% or less.

<11> The near-infrared blocking filter according to any one of <1> to <10>, further including a subsidiary near-infrared absorbing substance that absorbs a near-infrared ray.

<12> The near-infrared blocking filter according to <11>, in which the subsidiary near-infrared absorbing substance is cesium tungsten oxide.

<13> A method for producing a near-infrared blocking filter having a film thickness of 300 μm or less and a visible light transmissivity in a wavelength range of 450 nm to 550 nm of 85% or more, including:

a step of applying a near-infrared absorbing composition including a copper compound which is a near-infrared absorbing substance and a water-soluble binder to a support; and
a step of drying the near-infrared absorbing composition applied to the support so as to form the near-infrared blocking filter.

<14> A camera module including: a solid-state imaging element substrate; and the near-infrared blocking filter according to any one of <1> to <12> disposed on a light-receiving side of the solid-state imaging element substrate.
<15> A method for manufacturing a camera module including a solid-state imaging element substrate and the near-infrared blocking filter according to any one of <1> to <12> disposed on a light-receiving side of the solid-state imaging element substrate, including a step of applying the near-infrared absorbing substance to the light-receiving side of the solid-state imaging element substrate so as to form the near-infrared blocking filter.
<16> A near-infrared absorbing composition including a near-infrared absorbing substance, in which a visible light transmissivity in a wavelength range of 450 nm to 550 nm is 85% or more when a film having a film thickness of 300 $\mu$m or less is formed.

According to the present invention, it is possible to provide a near-infrared blocking filter in which strong near-infrared shielding properties can be achieved, the film thickness can be decreased, and the visible light transmissivity is high.

## BRIEF DESCRIPTION OF THE DRAWINGS

Fig. 1 is a schematic sectional view illustrating a configuration of a camera module including a solid-state imaging element according to an embodiment of the present invention.
Fig. 2 is a schematic sectional view of a solid-state imaging element substrate according to the embodiment of the present invention.
Fig. 3 is a graph illustrating spectral transmissivities of near-infrared blocking filters of Examples 1, 2, and 4.
Fig. 4 is a graph illustrating spectral transmissivities of near-infrared blocking filters of Examples 3 and 5.

## DESCRIPTION OF THE PREFERRED EMBODIMENTS

Hereinafter, the contents of the present invention will be described in detail. In the present specification, "to" used to express numerical ranges will be used with a meaning that numerical values before and after the "to" are included in the numerical ranges as the lower limit value and the upper limit value.
In the present specification, "(meth)acrylates" represent acrylates and methacrylates, "(meth)acrylic" represents acrylic and methacrylic, and "(meth)acryloyl" represents acryloyl and methacryloyl. In addition, in the present specification, "monomers" and "monomers" refer to the same thing. The monomers are classified into oligomers and polymers and refer to compounds having a weight-average molecular weight of 2,000 or less.
In the present specification, polymerizing compounds refer to compounds having a polymerizable functional group and may be monomers or polymers. Polymerizable functional groups refer to groups that participate in polymerization reactions.
Regarding the denotation of groups (atomic groups) in the present specification, groups with no denotation of 'substituted' and 'unsubstituted' include both groups (atomic groups) having no substituent and groups (atomic groups) having a substituent.
Near-infrared rays refer to light rays (electromagnetic rays) in a wavelength range of 700 nm to 2500 nm.

<Near-infrared absorbing composition>

A near-infrared absorbing composition of the present invention (hereinafter, also referred to as "the composition of the present invention") includes a near-infrared absorbing substance and has a visible light transmissivity of 85% or more in a wavelength range of 450 nm to 550 nm when a near-infrared blocking filter having a film thickness of 300 $\mu$m or less is formed. According to the composition of the present invention, it is possible to obtain a near-infrared blocking filter capable of realizing strong near-infrared shielding properties while maintaining a high transmissivity in a visible light range. In addition, according to the present invention, it is possible to decrease the film thickness of the near-infrared blocking filter and contribute to the reduction of the profile of a camera module. The near-infrared absorbing composition of the present invention includes a specific near-infrared absorbing substance described below and a binder and thus it is possible to provide a cured film (preferably a near-infrared blocking filter) having an excellent characteristic of a

visible light transmissivity of 85% or more in a wavelength range of 450 nm to 550 nm by producing a film thickness of 300 μm or less and maintaining high near-infrared shielding properties. In addition, the visible light transmissivity of the near-infrared blocking filter of the present invention is preferably 92% or more in the entire wavelength range of 450 nm to 550 nm and more preferably 95% or more in the entire wavelength range of 450 nm to 550 nm. The visible light range with a high transmissivity is preferably wide and a high transmissivity is preferably maintained in a wavelength range of 400 nm to 550 nm.

In the near-infrared blocking filter of the present invention, the film thickness is preferably set to 200 μm or less and more preferably set to 100 μm or less. In addition, the lower limit of the film thickness of the near-infrared blocking filter of the present invention is not particularly limited but is, for example, preferably 1 μm or more, more preferably 5 μm or more, and more preferably 20 μm or more.

The near-infrared blocking filter of the present invention has a film thickness of 300 μm or less and has a visible light transmissivity of 85% or more in a wavelength range of 400 nm to 575 nm. The visible light transmissivity is preferably 85% or more and more preferably 90% or more in the entire wavelength range of 400 nm to 575 nm.

In addition, the near-infrared blocking filter of the present invention has a film thickness of 300 μm or less and has a transmissivity of 20% or less in a wavelength range of 700 nm to 1100 nm. The transmissivity is preferably 20% or less in at least one point in a wavelength range of 700 nm to 1100 nm and more preferably 20% or less in the entire wavelength range of 700 nm to 1100 nm. In addition, the near-infrared blocking filter of the present invention has a film thickness of 300 μm or less and has a transmissivity of 10% or less in a wavelength range of 800 nm to 900 nm. The transmissivity is preferably 10% or less in at least one point in a wavelength range of 800 nm to 900 nm and more preferably 10% or less in the entire wavelength range of 800 nm to 900 nm.

In the near-infrared blocking filter of the present invention, the transmissivity preferably satisfies at least one of the following conditions and particularly preferably satisfies all the conditions.

- The transmissivity at a wavelength of 400 nm is preferably 80% or more, more preferably 90% or more, still more preferably 92% or more, and particularly preferably 95% or more.
- The transmissivity at a wavelength of 450 nm is preferably 80% or more, more preferably 90% or more, still more preferably 92% or more, and particularly preferably 95% or more.
- The transmissivity at a wavelength of 500 nm is preferably 80% or more, more preferably 90% or more, still more preferably 92% or more, and particularly preferably 95% or more.
- The transmissivity at a wavelength of 550 nm is preferably 80% or more, more preferably 90% or more, still more preferably 92% or more, and particularly preferably 95% or more.
- The transmissivity at a wavelength of 700 nm is preferably 20% or less, more preferably 15% or less, still more preferably 10% or less, and particularly preferably 5% or less.
- The transmissivity at a wavelength of 750 nm is preferably 20% or less, more preferably 15% or less, still more preferably 10% or less, and particularly preferably 5% or less.
- The transmissivity at a wavelength of 800 nm is preferably 20% or less, more preferably 15% or less, still more preferably 10% or less, and particularly preferably 5% or less.
- The transmissivity at a wavelength of 850 nm is preferably 20% or less, more preferably 15% or less, still more preferably 10% or less, and particularly preferably 5% or less.
- The transmissivity at a wavelength of 900 nm is preferably 20% or less, more preferably 15% or less, still more preferably 10% or less, and particularly preferably 5% or less.

The near-infrared blocking filter of the present invention is formed by, for example, directly applying (preferably applying) and drying the near-infrared absorbing composition of the present invention on a support.

The conditions for drying a coated film vary depending on the kind, fractions, and the like of individual components and a solvent; however, generally, the coated film is dried at a temperature in a range of 60°C to 150°C for 30 seconds to 15 minutes.

According to the near-infrared absorbing composition of the present invention, it is possible to obtain a near-infrared blocking filter in which the visible light transmissivity is 85% or more when the transmissivity in a wavelength range of 450 nm to 550 nm is measured using a spectrophotometer (for example, U-4100 (manufactured by Hitachi

High-Technologies Corporation)) with a film thickness set to, for example, 300 μm or less.

Hereinafter, preferred components configuring the near-infrared absorbing composition of the present invention will be described. The near-infrared absorbing composition of the present invention preferably includes a near-infrared absorbing substance and a water-soluble binder.

<<Near-infrared absorbing substance>>

The near-infrared absorbing substance used in the present invention is not particularly limited as long as the near-infrared absorbing substance has higher near-infrared shielding properties and a copper compound is preferably used. A water-soluble copper compound is frequently used and the water-soluble copper compound is sufficiently dispersed in a water-soluble binder and thus strong near-infrared shielding properties can be obtained.

<<Copper compound>>

Copper in the copper compound used in the present invention is preferably monovalent or divalent copper and more preferably divalent copper.

The content of copper in the copper compound used in the present invention is preferably in a range of 2% by mass to 40% by mass and more preferably in a range of 5% by mass to 40% by mass.

The copper compound used in the present invention is not particularly limited as long as the copper compound has the maximum absorption wavelength in a wavelength range of 700 nm to 1000 nm (near-infrared range).

The copper compound used in the present invention is preferably a copper complex.

In a case in which the copper compound used in the present invention is a copper complex, there is no particular limitation regarding a ligand L that coordinates copper as long as the ligand is capable of forming a coordination bond with a copper ion and examples thereof include a compound having phosphoric acid, a phosphoric ester, phosphonic acid, a phosphonic ester, phosphinic acid, substituted phosphinic acid, sulfonic aid, carboxylic acid, a carbonyl (ester or ketone), an amine, an amide, sulfonamide, urethane, urea, an alcohol, a tiol, and the like. Among these, phosphoric acid, a phosphoric ester, phosphonic acid, a phosphonic ester, phosphinic acid, substituted phosphinic acid, and sulfonic acid are preferred and a phosphoric ester, a phosphonic ester, substituted phosphinic acid, or sulfonic acid are more preferred.

Specific examples of the copper compound used in the present invention include a phosphorous-containing copper compound, a sulfonic acid copper compound, and a copper compound represented by Formula (A) described below. Regarding the phosphorous-containing copper compound, specifically, for example, the compounds described in Row 27 on Page 5 to Row 20 on Page 7 of WO2005/030898 can be referenced.

The copper compound used in the present invention is preferably a copper compound represented by Formula (A) described below.

$$Cu(L)_{n1}\cdot(X)_{n2} \qquad \text{Formula (A)}$$

In Formula (A), L represents a ligand that coordinates copper and X is not present or represents a halogen atom, $H_2O$, $NO_3$, $ClO_4$, $SO_4$, CN, SCN, $BF_4$, $PF_6$, $BPh_4$ (Ph represents a phenyl group), or an alcohol. Each of n1 and n2 independently represents an integer from 1 to 4.

The ligand L has a substituent including C, N, O, or S as an atom that can coordinate copper and more preferably has a group having a lone electron pair of N, O, S, or the like. The number of kinds of the group that can coordinate copper in the molecule may be one or more and the group may or may not be dissociated. In a case in which the group is not dissociated, X is not present.

A copper complex as the near-infrared absorbing substance is in a form of a copper complex (copper compound) in which the ligand coordinates copper which is the central metal. In the copper complex of the present invention, copper is divalent copper and the copper can be obtained by, for example, mixing and reacting a compound or a salt thereof, which serves as the ligand, with a copper component. Therefore, an "infrared absorbing composition including copper and a ligand" is expected to form a copper complex in a composition.

There is no particular limitation regarding the compound or the salt thereof which serves as the ligand and preferred examples thereof include organic acid compounds (for example, sulfonic acid compounds, carboxylic acid compounds, and phosphoric acid compounds) and salts thereof.

The compound or the salt thereof which serves as the ligand is preferably a compound including an acid group or a salt thereof and is preferably represented by General Formula (i) described below.

$$R^1\{X^1)_n \qquad \text{General Formula (i)}$$

(In General Formula (i), $R^1$ represents an n-valent organic group, $X^1$ represents an acid group, and n represents an integer from 1 to 6.)

In General Formula (i), the n-valent organic group is preferably a hydrocarbon group or an oxyalkylene group and more preferably an aliphatic hydrocarbon group or an aromatic hydrocarbon group. The hydrocarbon group may have a substituent and examples of the substituent include a halogen atom (preferably a fluorine atom), a (meth)acryloyl group, and a group having an unsaturated double bond.

In the case of a monovalent hydrocarbon group, an alkyl group or an aryl group is preferred and an aryl group is more preferred. In the case of a divalent hydrocarbon group, an alkylene group, an arylene group, or an oxyalkylene group is preferred and an arylene group is more preferred. In the case of a tri- or more-valent hydrocarbon group, trivalent hydrocarbon groups that correspond to the above-described hydrocarbon groups are preferred.

The number of carbon atoms in the alkyl group and the alkylene group is preferably in a range of 1 to 20 and more preferably in a range of 1 to 10.

The number of carbon atoms in the aryl group and the arylene group is preferably in a range of 6 to 18 and more preferably in a range of 6 to 12.

In General Formula (i), $X^1$ is preferably at least one of a sulfonic acid group, a carboxylic acid group, and an acid group having a phosphorous atom. The number of $X^1$s may be one or more and is preferably two or more.

In General Formula (i), n is preferably in a range of 1 to 3, more preferably 2 or 3, and still more preferably 3.

The molecular weight of the compound or the salt thereof (the compound including an acid group or a salt thereof) which serves as the ligand is preferably 1000 or less, preferably in a range of 70 to 1000, and more preferably 70 to 500.

A preferred aspect of the compound including an acid group or a salt thereof is (1) a compound having at least one of a sulfonic acid group, a carboxylic acid group, and an acid group including a phosphorous atom, a more preferred aspect is (2) a compound having 2 or more acid groups, and a still more preferred aspect is (3) a compound having a sulfonic acid group and a carboxylic acid group. In the above-described aspects, an infrared absorbing function that is the capability of absorbing near-infrared rays is more effectively exhibited. Furthermore, when a compound having a sulfonic acid group and a carboxylic acid group is used, it is possible to further improve color valency.

(1) Specific examples of the compound having at least one of a sulfonic acid group, a carboxylic acid group, and an acid group including a phosphorous atom are as described below. In addition, specific examples of the compound having a sulfonic acid group also include the specific examples of sulfonic acid compounds described below. In addition, among compounds described in the aspects (2) and (3) described below, compounds that correspond to the present aspect can also be preferred examples.

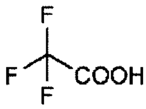 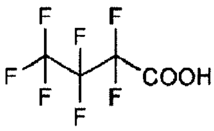 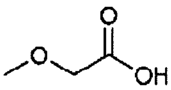 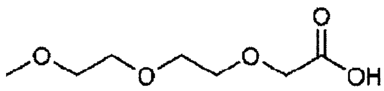

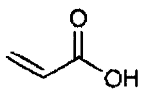 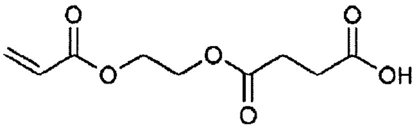

(2) Specific examples of the compound having at least two acid groups are as described below. In addition, among compounds described in the aspect (3) described below, compounds that correspond to the present aspect can also be preferred examples.

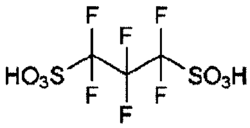 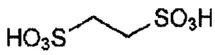

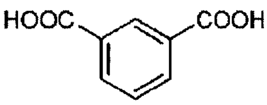

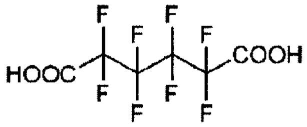

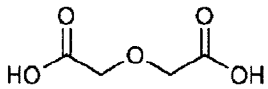

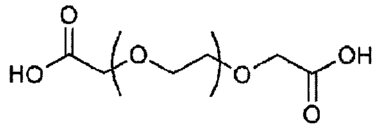

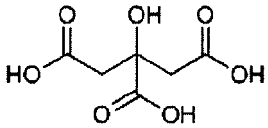

(3) Specific examples of the compound having a sulfonic acid group and a carboxylic acid group are as described below. In addition, specific examples of the compound having a sulfonic acid group and a carboxylic acid group represented by Formula (1) described below can also be the specific examples.

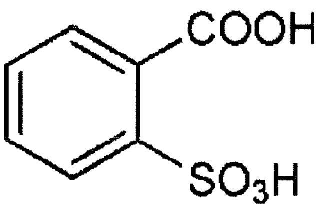

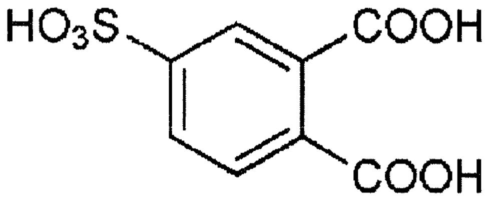

Hereinafter, the copper compound used in the present invention and the compound forming the ligand L will be described in detail.

<<Phosphorous-containing copper complex>>

A phosphorous-containing copper complex is may be any complex that has a ligand containing a phosphorous compound, but is preferably a phosphoric acid copper complex, a phosphoric ester copper complex, a phosphonic acid copper complex, a phosphonic ester copper complex, a phosphinic acid copper complex, or a substituted phosphinic acid copper complex and more preferably a phosphoric ester copper complex, a phosphonic ester copper complex, or a substituted phosphinic acid copper complex.

<<<Phosphoric ester copper complex>>>

The phosphoric ester copper complex has copper as the central metal and a phosphoric ester compound as the ligand.

The phosphoric ester compound that forms the ligand L is more preferably a compound represented by Formula (B) described below.

$(HO)_n\text{-}P(=O)\text{-}(OR^2)_{3-n}$ Formula (B)

In Formula (B), $R^2$ represents an organic group and n represents 1 or 2.

(In the formula, $R^2$ represents an alkyl group having 1 to 18 carbon atoms, an aryl group having 6 to 18 carbon atoms, an aralkyl group having 1 to 18 carbon atoms, or an alkenyl group having 1 to 18 carbon atoms, $-OR^2$ represents a polyoxyalkyl group having 4 to 100 carbon atoms, a (meth)acryloyloxy alkyl group having 4 to 100 carbon atoms, or a (meth)acryloyl polyoxyalkyl group having 4 to 100 carbon atoms, and n represents 1 or 2.)

When n is 1, $R^2$s may be identical to or different from each other.

Examples of the phosphoric ester compound used in the present invention include a phosphoric monoester (n=2 in Formula (B)) and a phosphoric diester (n=1 in Formula (B)) and, from the viewpoint of near-infrared shielding properties and solubility, a phosphoric diester is preferred and a compound represented by Formula (C) is preferred.

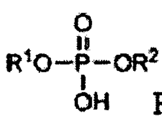
Formula (C)

(In Formula (C), each of $R^1$ and $R^2$ independently represents a monovalent organic group or a divalent organic

group and may form a ring structure.)

The compound represented by Formula (C) and a salt thereof act as a ligand that coordinates copper. Here, the ligand refers to an atom, an ion, an atomic group, a group, a neutral molecule, or the like which is sterically disposed around a copper atom in the copper complex and is bonded to the copper atom.

Each of $R^1$ and $R^2$ in Formula (C) independently represents a monovalent organic group or a divalent organic group and may form a ring structure. The monovalent organic group is preferably an organic group having 3 or more carbon atoms, more preferably an organic group having 5 or more carbon atoms, and still more preferably an organic group having 5 to 20 carbon atoms.

In addition, in Formula (C), $R^1$ and $R^2$ may be bonded together and thus form a ring structure. In this case, both $R^1$ and $R^2$ are divalent organic groups. The total number of carbon atoms in a group (divalent organic group) having a bonded ring structure is 3 or more, preferably 5 or more, and still more preferably in a range of 5 to 20.

There is no particular limitation regarding specific monovalent organic groups and examples thereof include linear, branched or cyclic alkyl groups, aryl groups, and heteroaryl groups. Here, the above-described groups may be formed through a divalent linking group (for example, a linear, branched, or cyclic alkylene group, arylene group, heteroarylene group, -O-, -S-, -CO-, -COO-, -OCO-, $-SO_2-$, -NR- (R represents a hydrogen atom or an alkyl group), or the like). In addition, the monovalent organic group may have a substituent.

The linear or branched alkyl group is preferably an alkyl group having 3 to 20 carbon atoms, more preferably an alkyl group having 3 to 10 carbon atoms, and still more preferably an alkyl group having 3 to 8 carbon atoms.

The cyclic alkyl group may be a single ring or may be polycyclic. The cyclic alkyl group is preferably a cycloalkyl group having 3 to 20 carbon atoms, more preferably a cycloalkyl group having 4 to 10 carbon atoms, and still more preferably a cycloalkyl group having 6 to 10 carbon atoms.

The aryl group is preferably an aryl group having 6 to 18 carbon atoms, more preferably an aryl group having 6 to 14 carbon atoms, and still more preferably an aryl group having 6 to 10 carbon atoms.

The heteroaryl group is preferably a 5-membered ring or a 6-membered ring. In addition, the heteroaryl group may be a single ring or a condensed ring, is preferably a single ring or a condensed ring having 2 to 8 condensations, and more preferably a single ring or a condensed ring having 2 to 4 condensations.

Specifically, a single ring containing at least one of nitrogen, oxygen, and sulfur atoms or a heteroaryl group derived from a polycyclic aromatic ring is used. Examples of a heteroaryl ring in the heteroaryl group include an oxazol ring, a thiophene ring, a thianthrene ring, a furan ring, a pyran ring, an isobenzofuran ring, a chromene ring, a xanthene ring, a phenoxazine ring, a pyrrol ring, a pyrazole ring, an isothiazole ring, an isoxazole ring, a pyrazine ring, a pyrimidine ring, a pyridazine ring, an indolizine ring, an isoindolizine ring, an indole ring, an indazole ring, a purine ring, a quinolizine ring, an isoquinolizine ring, a phthalazine ring, a naphthyridine ring, a quinazoline ring, a sinoline ring, a pteridine ring, a carbazole ring, a carboline ring, a phenanthrene ring, an acridine ring, a perimidine ring, a phenanthroline ring, a phthalazine ring, a phenalxazine ring, a phenoxazine ring, a furazan ring, and the like.

Examples of the linear, branched, or cyclic alkylene group, arylene group, or heteroarylene group, which is a divalent linking group, include divalent linking groups derived by removing a hydrogen atom from the above-described linear, branched, or cyclic alkyl group, aryl group, or heteroaryl group.

Examples of the substituent that the monovalent organic group may have include an alkyl group, a polymerizable group (for example, a vinyl group, a (meth)acryloyl group, an epoxy group, an oxetane group, or the like), a halogen atom, a carboxyl group, a carboxylic ester group (for example, $-CO_2CH_3$ or the like), a hydroxyl group, an amide group, a halogenated alkyl group (for example, a fluoroalkyl group or a chloroalkyl group), and the like.

In addition, the phosphoric diester copper complex of the present invention has a structure represented by Formula (D) described below.

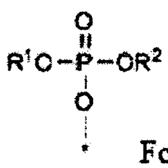

Formula (D)

(In Formula (D), each of $R^1$ and $R^2$ independently represents a monovalent organic group or a divalent organic group and may form a ring structure. "*" indicates a portion at which a coordination bond with copper is formed.)

In Formula (D), $R^1$ and $R^2$ have the same meaning and preferred range as $R^1$ and $R^2$ in Formula (C).

The molecular weight of the phosphoric ester compound represented by Formula (C) is preferably in a range of 200 to 1000, more preferably in a range of 250 to 750, and still more preferably in a range of 300 to 500.

Specific examples of the phosphoric ester compound are as illustrated below.

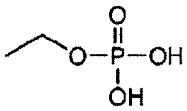
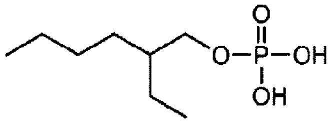
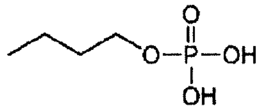

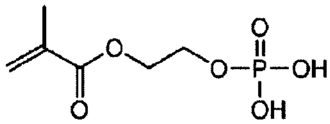
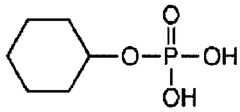
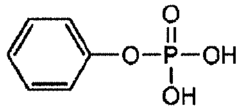

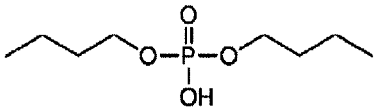
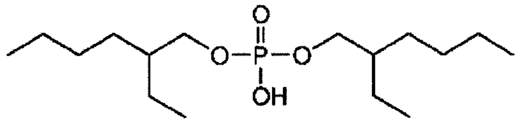

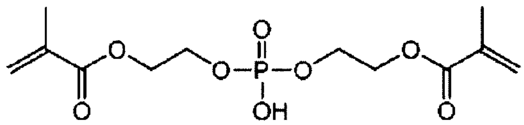
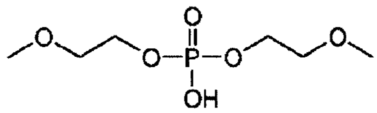

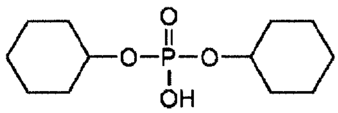
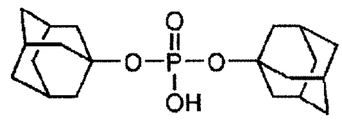

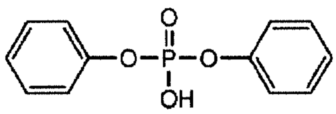
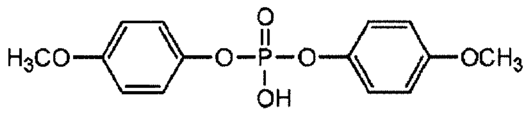

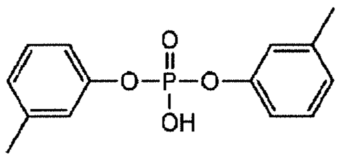
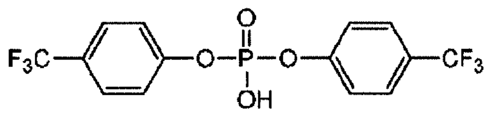

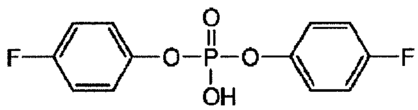
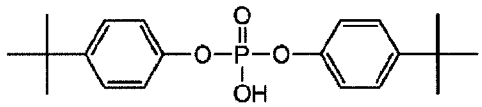

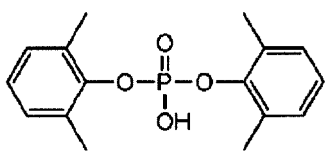
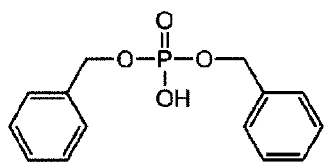

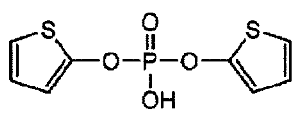
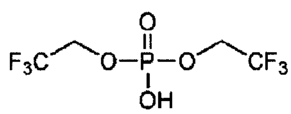

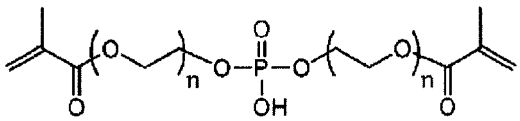

(L-1: n=2)
(L-2: n=4)
(L-3: n=9)

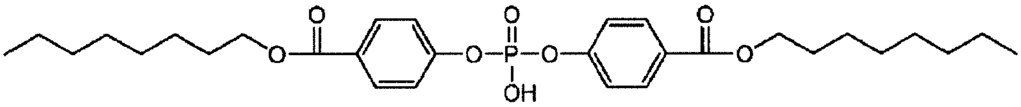

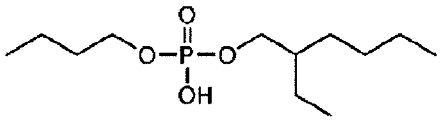

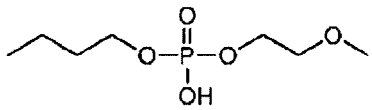

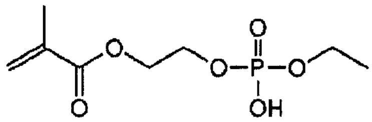

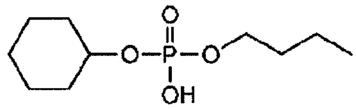

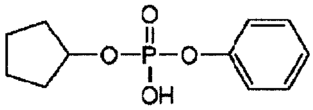

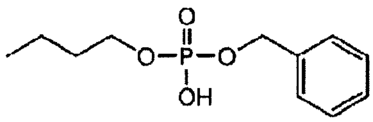

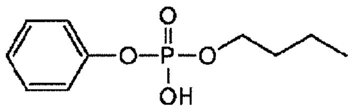

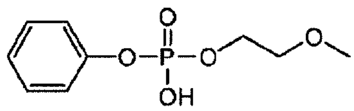

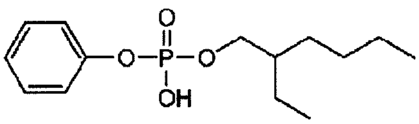

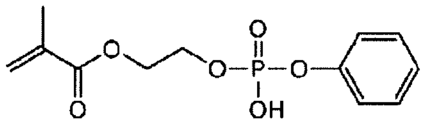

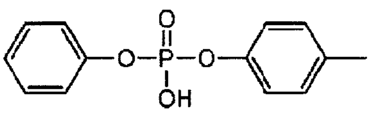

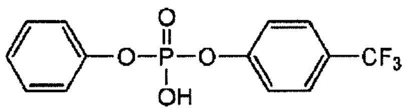

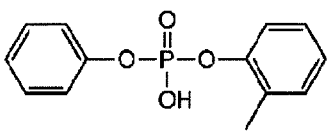

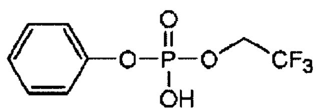

<<<Phosphonic ester copper complex>>>

The phosphonic ester copper complex used in the present invention may have copper as the central metal and a phosphonic ester compound as the ligand.

The phosphonic ester compound forming the ligand L is more preferably a compound represented by Formula (E) described below.

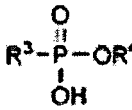

Formula (E)

(In Formula (E), each of $R^3$ and $R^4$ independently represents a monovalent organic group.)

The compound represented by Formula (E) and a salt thereof act as the ligand that coordinates copper.

In Formula (E), each of $R^3$ and $R^4$ independently represents a monovalent organic group. There is no particular limitation regarding specific monovalent organic groups and examples thereof include linear, branched, or cyclic alkyl groups, alkenyl groups, aryl groups, and heteroaryl groups. Here, the above-described groups may be formed through a divalent linking group (for example, an alkylene group, a cycloalkylene group, an arylene group, a heteroarylene group, -O-, -S-, -CO-, -COO-, -OCO-, $-SO_2-$, -NR- (R represents a hydrogen atom or an alkyl group), or the like) in the middle. In addition, the monovalent organic group may have a substituent.

The linear or branched alkyl group is preferably an alkyl group having 1 to 20 carbon atoms, more preferably an alkyl group having 1 to 10 carbon atoms, and still more preferably an alkyl group having 1 to 8 carbon atoms.

The cyclic alkyl group, aryl group, and heteroaryl group have the same meaning and preferred range as the cyclic alkyl group, aryl group, and heteroaryl group in Formula (C).

The alkenyl group is preferably an alkenyl group having 2 to 10 carbon atoms, more preferably an alkenyl group having 2 to 8 carbon atoms, and still more preferably an alkenyl group having 2 to 4 carbon atoms. Specific examples thereof include a vinyl group, a 1-propenyl group, a 1-butenyl group, and the like.

Examples of the linear, branched, or cyclic alkylene group, arylene group, or heteroarylene group, which is a divalent linking group, include divalent linking groups described in Formula (C).

Examples of the substituent that the monovalent organic group may have include substituents described in Formula (C).

In addition, the phosphoric ester copper complex used in the present invention has a structure represented by Formula (F).

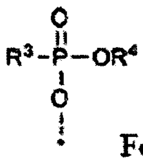

Formula (F)

(In Formula (F), each of $R^3$ and $R^4$ independently represents a monovalent organic group. "*" indicates a portion at which a coordination bond with copper is formed.)

In Formula (F), $R^3$ and $R^4$ have the same meaning and preferred range as $R^3$ and $R^4$ in Formula (E).

The molecular weight of the phosphonic ester compound represented by Formula (E) is preferably in a range of 200 to 1000, more preferably in a range of 250 to 750, and still more preferably in a range of 300 to 500.

Specific examples of the phosphonic ester compound are as illustrated below.

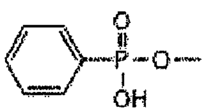
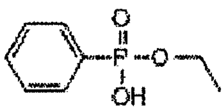
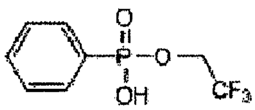

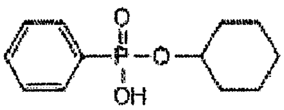
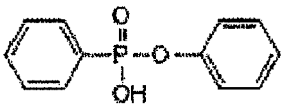
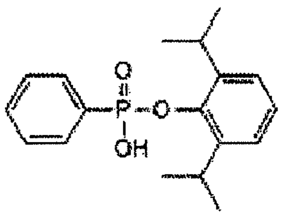

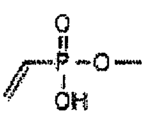
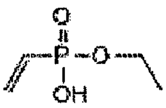
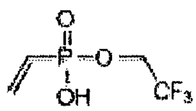

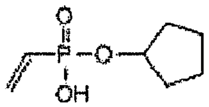
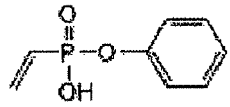
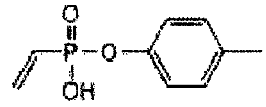

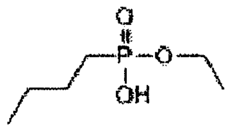
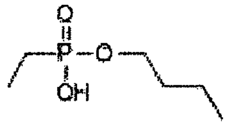
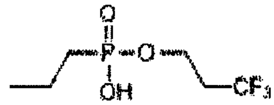

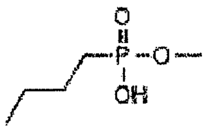
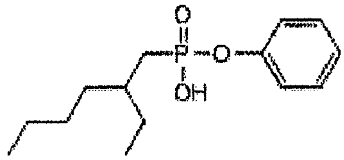
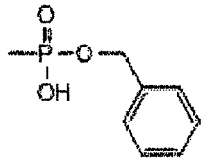

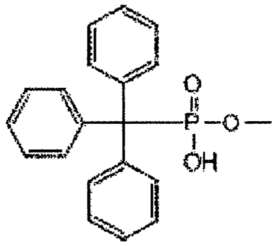
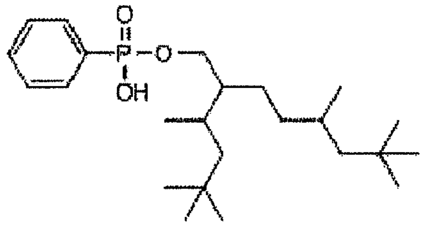

<<<Substituted phosphinic acid copper complex>>>

The substituted phosphinic acid copper complex used in the present invention has copper as the central metal and a substituted phosphinic acid compound as the ligand. The substituted phosphinic acid compound forming the ligand L is more preferably a compound represented by Formula (G) described below.

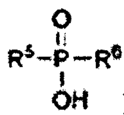
Formula (G)

(In Formula (G), each of $R^5$ and $R^6$ independently represents a monovalent organic group.)
The compound represented by Formula (G) and a salt thereof act as the ligand that coordinates copper.
In Formula (G), each of $R^5$ and $R^6$ independently represents a monovalent organic group. There is no particular limitation regarding specific monovalent organic groups and examples thereof include linear, branched, or cyclic alkyl groups, aryl groups, and heteroaryl groups. Here, the above-described groups may be formed through a divalent linking group (for example, an alkylene group, a cycloalkylene group, an arylene group, a heteroarylene group, -O-, -S-, -CO-, -COO-, -OCO-, $-SO_2-$, -NR- (R represents a hydrogen atom or an alkyl group), or the like) in the middle. In addition, the monovalent organic group may have a substituent.
The linear or branched alkyl group is preferably an alkyl group having 1 to 20 carbon atoms, more preferably an alkyl group having 1 to 10 carbon atoms, and still more preferably an alkyl group having 1 to 8 carbon atoms. Specific examples thereof include a methyl group, an n-butyl group, 2-ethylhexyl group, and the like.
The cyclic alkyl group, aryl group, and heteroaryl group have the same meaning and preferred range as the cyclic alkyl group, aryl group, and heteroaryl group in Formula (C).
Examples of the linear, branched, or cyclic alkylene group, arylene group, or heteroarylene group, which is a divalent linking group, include divalent linking groups described in Formula (C).
Examples of the substituent that the monovalent organic group may have include substituents described in Formula (C).
In addition, the substituted phosphinic acid copper complex used in the present invention has a structure represented by Formula (H).

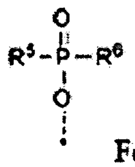

Formula (H)

(In Formula (H), each of $R^5$ and $R^6$ independently represents a monovalent organic group. "*" indicates a portion at which a coordination bond with copper is formed.)

In Formula (H), $R^5$ and $R^6$ have the same meaning and preferred range as $R^5$ and $R^6$ in Formula (G).

The molecular weight of the substituted phosphinic acid compound represented by Formula (G) is preferably in a range of 50 to 750, more preferably in a range of 50 to 500, and still more preferably in a range of 80 to 300.

Specific examples of the substituted phosphinic acid compound are as illustrated below.

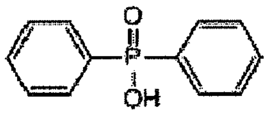

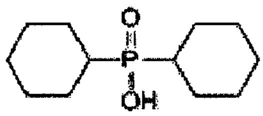

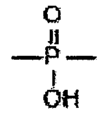

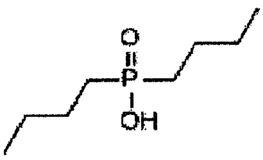

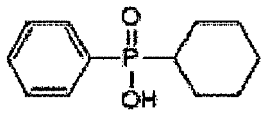

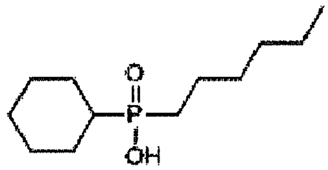

The phosphorous-containing copper complex used in the present invention can be obtained by reacting a copper component and the phosphorous-containing compound (for example, a phosphoric ester, a phosphonic ester, a substituted phosphinic acid, or the like) which serves as a ligand or a salt thereof.

As the above-described copper component, it is possible to use copper or a copper-containing compound. As the copper-containing compound, it is possible to use, for example, copper oxide or a copper salt. The copper salt is preferably monovalent or divalent copper and more preferably divalent copper. The copper salt is more preferably copper acetate, copper chloride, copper formate, copper stearate, copper benzoate, copper ethyl acetoacetate, copper pyrophosphate, copper naphthenate, copper citrate, cupric nitrate, copper sulfate, copper carbonate, copper chlorate, copper (meth)acrylate, or copper perchlorate and still more preferably copper acetate, copper chloride, copper sulfate, copper benzoate, or copper (meth)acrylate.

The phosphorous-containing compound used in the present invention can be synthesized with reference to, for example, a well-known method.

For example, the phosphoric ester compound can be obtained by reacting 2-hydroxyethyl methacrylate, phenyl phosphate ester, and 1,3,5-triisopropyl sulfonate chloride in a pyridine solvent.

The salt of the phosphorous-containing compound used in the present invention is preferably, for example, a metallic salt and specific examples thereof include a sodium salt, a potassium salt, a magnesium salt, a calcium salt, a borate salt, and the like.

When the copper component and the above-described phosphorous-containing compound or a salt thereof are reacted together, the reaction ratio is preferably in a range of 1:1.5 to 1:4 in terms of molar ratio.

In addition, when the copper component and the above-described phosphorous-containing compound or a salt thereof are reacted together, the reaction conditions are preferably set to, for example, 20°C to 50°C for 0.5 hours or longer.

The phosphorous-containing copper complex of the present invention has the maximum absorption wavelength ($\lambda_{max}$) in a near-infrared wavelength range of 700 nm to 2500 nm, preferably has the maximum absorption wavelength in a range of 700 nm to 2500 nm, more preferably has the maximum absorption wavelength in a range of 720 nm to 890 nm, and still more preferably has the maximum absorption wavelength in a range of 730 nm to 880 nm. The maximum absorption wavelength can be measured using, for example, a Cary 5000 UV-Vis-NIR (spectrophotometer, manufactured by Agilent Technologies Japan, Ltd.).

In addition, the phosphorous-containing copper complex of the present invention preferably has a gram absorbance of 0.04 or more (g/mL), more preferably has a gram absorbance of 0.06 or more (g/mL), and still more preferably has a gram absorbance of 0.08 or more (g/mL).

The gram absorbance can be computed using, for example, a Cary 5000 UV-Vis-NIR (spectrophotometer, manufactured by Agilent Technologies Japan, Ltd.) instrument.

<<Sulfonic acid copper complex>>

The sulfonic acid copper complex used in the present invention has copper as the central metal and a sulfonic acid compound as the ligand.
The sulfonic acid compound as the ligand is more preferably a compound represented by Formula (I) described below.

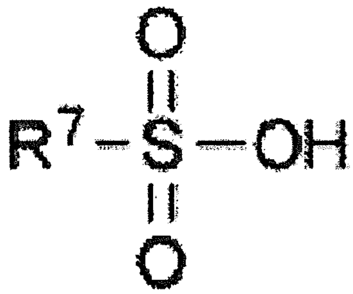

Formula (I)

(In Formula (I), $R^7$ represents a monovalent organic group.)
The sulfonic acid compound represented by Formula (I) and a salt thereof act as the ligand that coordinates copper.
There is no particular limitation regarding specific monovalent organic groups and examples thereof include linear, branched or cyclic alkyl groups, alkenyl groups, and aryl groups. Here, these groups may be formed through a divalent linking group (for example, an alkylene group, a cycloalkylene group, an arylene group, -O-, -S-, -CO-, -COO-, -OCO-, $-SO_2-$, -NR- (R represents a hydrogen atom or an alkyl group), or the like). In addition, the monovalent organic group may have a substituent.
The linear or branched alkyl group is preferably an alkyl group having 1 to 20 carbon atoms, more preferably an alkyl group having 1 to 12 carbon atoms, and still more preferably an alkyl group having 1 to 8 carbon atoms.
The cyclic alkyl group may be a single ring or may be polycyclic. The cyclic alkyl group is preferably a cycloalkyl group having 3 to 20 carbon atoms, more preferably a cycloalkyl group having 4 to 10 carbon atoms, and still more preferably a cycloalkyl group having 6 to 10 carbon atoms. The alkenyl group is preferably an alkenyl group having 2 to 10 carbon atoms, more preferably an alkenyl group having 2 to 8 carbon atoms, and still more preferably an alkenyl group having 2 to 4 carbon atoms.
The aryl group is preferably an aryl group having 6 to 18 carbon atoms, more preferably an aryl group having 6 to 14 carbon atoms, and still more preferably an aryl group having 6 to 10 carbon atoms.
Examples of the alkylene group, cycloalkylene group, or arylene group, which is a divalent linking group, include divalent linking groups derived by removing a hydrogen atom from the above-described alkyl group, cycloalkylene group, or aryl group.
Examples of the substituent that the monovalent organic group may have include an alkyl group, a polymerizable group (for example, a vinyl group, a (meth)acryloyl group, an epoxy group, an oxetane group, or the like), a halogen atom, a carboxyl group, a carboxylic ester group (for example, $-CO_2CH_3$ or the like), a hydroxyl group, an amide group, a halogenated alkyl group (for example, a fluoroalkyl group or a chloroalkyl group), and the like.
In addition, the sulfonic acid copper complex of the present invention includes a structure represented by Formula (J) described below.

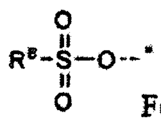

Formula (J)

(In Formula (J), $R^8$ represents a monovalent organic group. "*" indicates a portion at which a coordination bond with copper is formed.)
In Formula (J), $R^8$ has the same meaning and preferred range as $R^7$ in Formula (I).
The molecular weight of the sulfonic acid copper complex represented by Formula (I) is preferably in a range of 80 to 750, more preferably in a range of 80 to 600, and still more preferably in a range of 80 to 450.
Specific examples of the sulfonic acid compound represented by Formula (I) will be illustrated below, but the present invention is not limited thereto.

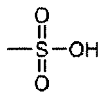
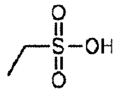
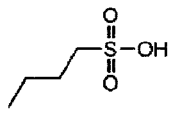
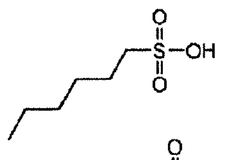

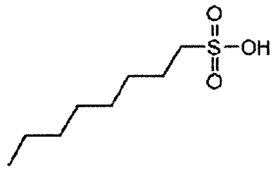
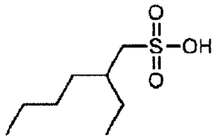
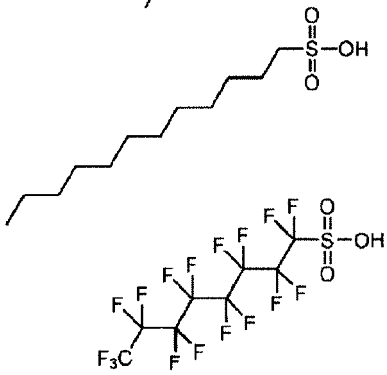

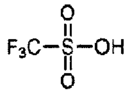
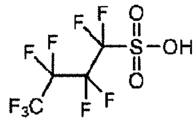

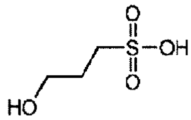
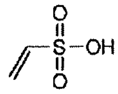
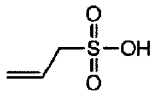
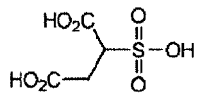

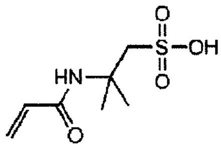
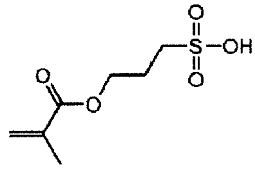
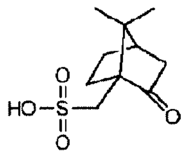

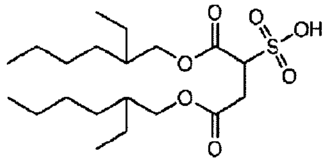

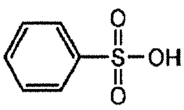
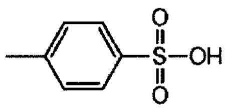
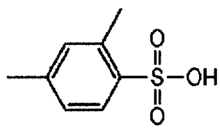
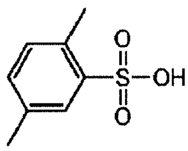

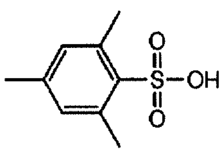
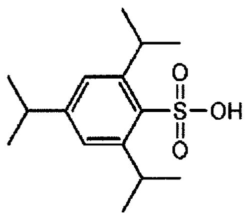
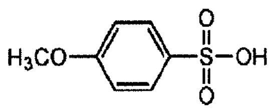

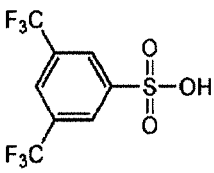
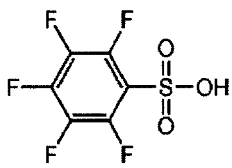
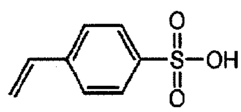

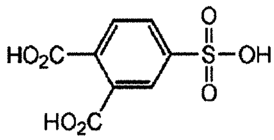
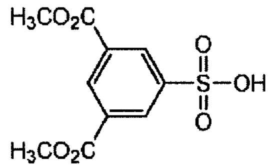

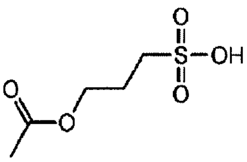
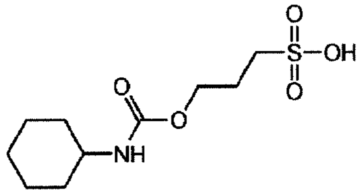

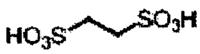
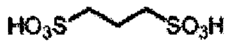

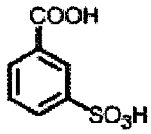
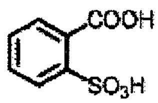
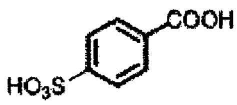

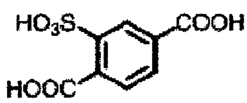
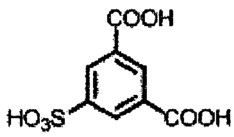
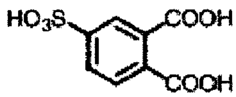

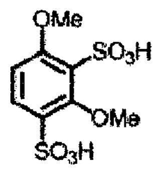
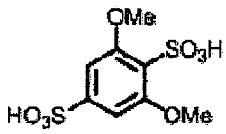
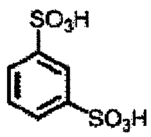
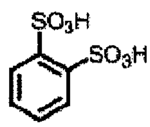
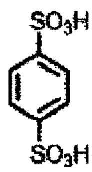

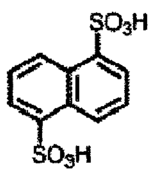
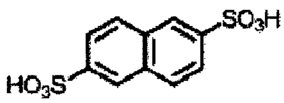
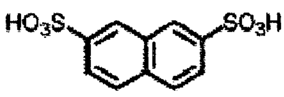
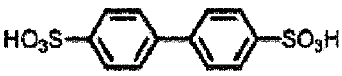

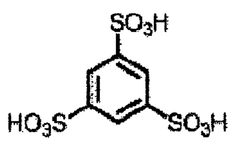

The sulfonic acid copper complex used in the present invention can be obtained by reacting a copper component and the sulfonic acid compound which serves as a ligand or a salt thereof.

The above-described copper component has the same meaning and preferred range as the copper component for the above-described phosphorous-containing copper complex.

As the sulfonic acid compound used in the present invention, it is also possible to use a commercially available sulfonic acid and the sulfonic acid compound can also be synthesized with reference to a well-known method.

The salt of the sulfonic acid compound used in the present invention is preferably, for example, a metallic salt and specific examples thereof include a sodium salt, a potassium salt, and the like.

When the copper component and the above-described sulfonic acid compound or a salt thereof are reacted together, the reaction ratio is preferably in a range of 1:1.5 to 1:4 in terms of molar ratio. At this time, the number of kinds of the sulfonic acid compound or the salt thereof being used may be one or more.
In addition, when the copper component and the above-described sulfonic acid compound or a salt thereof are reacted together, the reaction conditions are preferably set to, for example, 20°C to 50°C for 0.5 hours or longer.
The maximum absorption wavelength and gram absorbance of the sulfonic acid copper complex of the present invention are identical to those for the above-described phosphorous-containing copper complex and the preferred range is also identical.

<<Other copper compounds>>

As the copper compound used in the present invention, in addition to the above-described compounds, a copper compound having a carboxylic acid ester as the ligand may be used. Meanwhile, it is needless to say that the present invention is not limited thereto. For example, a compound represented by Formula (K) described below is preferred.

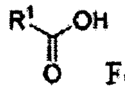
Formula (K)

(In Formula (K), $R^1$ represents a monovalent organic group.)
In Formula (K), $R^1$ represents a monovalent organic group. The monovalent organic group is not particularly limited and is identical to, for example, the monovalent organic group in Formula (C) described above.
The content of the copper compound used in the present invention is $3\times10^{-3}$ mol to 1 mol, preferably in a range of $3\times10^{-3}$ mol to 0.2 mol, and more preferably in a range of $3\times10^{-3}$ mol to 0.05 mol in relation to 1 g of the compound having a partial structure represented by Formula (1) described below. When the content of the copper compound is set to 1 mol or less in relation to 1 g of the compound having the partial structure represented by Formula (1), the formation of a crosslinked structure originating from the copper compound is further suppressed when the near-infrared absorbing composition of the present invention is cured. Therefore, even in a case in which a certain amount or more of the copper compound is added to the near-infrared absorbing composition of the present invention, it is possible to more effectively form a thin film. For example, it is possible to form a thin film of 200 μm or less as the near-infrared blocking filter for which the near-infrared absorbing composition of the present invention is used.
The near-infrared absorbing composition of the present invention preferably includes the above-described copper complex. According to an aspect of the composition of the present invention, when the above-described copper complex is used, it is possible to maintain strong near-infrared shielding properties when a cured film is produced and to provide a near-infrared absorbing composition including the copper complex which has excellent solubility in water or an aqueous solvent.
The copper in the copper complex of the present invention is generally divalent copper and can be obtained by, for example, mixing and reacting the above-described compound or a salt thereof, which serves as the ligand, and the copper component (copper or a copper-containing compound). Here, when the structure of a compound which serves as the ligand and the copper component can be detected from the composition of the present invention, it is possible to say that the copper complex is formed in the composition of the present invention. For example, as a method for detecting copper and the phosphoric ester compound from the composition of the present invention, ICP emission spectrometry can be used and copper and the phosphoric ester compound can be detected using this method.
Regarding the amount of the copper complex blended in the composition of the present invention, the composition of the present invention preferably includes the copper complex at a ratio in a range of 5% by mass to 60% by mass and more preferably includes the copper complex at a ratio in a range of 10% by mass to 40% by mass.
The amount of the copper complex blended in the solid content of the composition of the present invention is preferably in a range of 30% by mass to 90% by mass, more preferably in a range of 35% by mass to 85% by mass, and still more preferably in a range of 40% by mass to 80% by mass.
The near-infrared absorbing composition of the present invention may include a near-infrared absorbing substance other than the above-described copper compound.

<<Other near-infrared absorbing substances>>

As other near-infrared absorbing substances that can be used in the present invention, a copper compound obtained by reacting a polymer containing an acid group or a salt thereof and a copper component can be used. The copper compound is, for example, a polymer-type copper compound containing a polymer having an acid group ion site

and a copper ion and a preferred aspect thereof is a polymer-type copper compound having an acid group ion site in the polymer as a ligand. Generally, the polymer-type copper compound has an acid group ion site at the side chain of the polymer, the acid group ion site is bonded (for example, through a coordination bond) to copper, and a crosslinked structure is formed among the side chains from copper as the starting point.

The copper component is preferably a compound containing divalent copper. The content of copper in the copper component is preferably in a range of 2% by mass to 40% by mass and more preferably in a range of 5% by mass to 40% by mass. The number of the copper components being used may be one or more. As the copper-containing compound, it is possible to use, for example, copper oxide or a copper salt. The copper salt is more preferably divalent copper. The copper salt is particularly preferably copper hydroxide, copper acetate, or copper sulfate.

There is no particular limitation regarding the acid group that the polymer containing an acid group or a salt thereof has as long as the acid group is capable of reacting with the above-described copper component, but an acid group capable of forming a coordination bond with the copper component is preferred. Specific examples thereof include an acid group having an acid dissociation constant (pKa) of 12 or less and a sulfonic acid group, a carboxylic acid group, a phosphoric acid group, a phosphonic acid group, a phosphinic acid group, an imidic acid group, and the like are preferred. The number of the acid groups included in the polymer may be one or more.

Examples of an atom or an atomic group that configures a salt of the acid group used in the present invention include metal atoms such as sodium (particularly, alkali metal atoms) and atomic groups such as tetrabutylammonium. Furthermore, in the polymer containing the acid group or a salt thereof, the acid group or a salt thereof may be included in at least one of the main chain and the side chain and is preferably included in at least the side chain.

The polymer containing the acid group or a salt thereof is preferably a polymer containing a carboxylic acid group or a salt thereof and/or a sulfonic acid group or a salt thereof and more preferably a polymer containing a sulfonic acid group or a salt thereof.

<<<First embodiment>>>

A preferred example of the polymer containing the acid group or a salt thereof is a structure having a carbon-carbon bond in the main chain and preferably has a configuration unit represented by Formula (A1-1) described below.

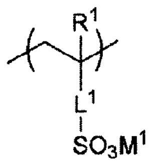

(A 1 − 1)

(In Formula (A1-1), $R^1$ represents a hydrogen atom or a methyl group, $L^1$ represents a single bond or a divalent linking group, and $M^1$ represents a hydrogen atom or an atom or atomic group that configures a salt with a sulfonic acid group.)

In Formula (A1-1), $R^1$ is preferably a hydrogen atom.

In Formula (A1-1), in a case in which $L^1$ represents a divalent linking group, the divalent linking group is not particularly limited and examples thereof include a divalent hydrocarbon group, a heteroarylene group, -O-, -S-, -CO-, -COO-, -OCO-, $-SO_2-$, -NX- (X represents a hydrogen atom or an alkyl group and is preferably a hydrogen atom), and groups obtained by a combination thereof.

Examples of the divalent hydrocarbon group include linear, branched, or cyclic alkylene groups or arylene groups. The hydrocarbon group may have a substituent, but is preferably an unsubstituted group.

The number of carbon atoms in the linear alkylene group is preferably in a range of 1 to 30, more preferably in a range of 1 to 15, and still more preferably in a range of 1 to 6. In addition, the number of carbon atoms in the branched alkylene group is preferably in a range of 3 to 30, more preferably in a range of 3 to 15, and still more preferably in a range of 3 to 6.

The cyclic alkylene group may be a single ring or may be polycyclic. The number of carbon atoms in the cyclic alkylene group is preferably in a range of 3 to 20, more preferably in a range of 4 to 10, and still more preferably in a range of 6 to 10.

The number of carbon atoms in the arylene group is preferably in a range of 6 to 18, more preferably in a range of 6 to 14, and still more preferably in a range of 6 to 10 and a phenylene group is particularly preferred.

The heteroarylene group is not particularly limited, but is preferably a 5-membered ring or a 6-membered ring. In addition, the heteroarylene group may be a single ring or a condensed ring, is preferably a single ring or a condensed ring having 2 to 8 condensations, and more preferably a single ring or a condensed ring having 2 to 4 condensations.

In Formula (A1-1), the atom or atomic group that configures a salt with a sulfonic acid group, which is represented

by $M^1$, is identical to the above-described atom or atomic group that configures a salt of the acid group and is preferably a hydrogen atom or an alkali metal atom.

Regarding configuration units other than the configuration unit represented by Formula (A1-1), the description of the copolymer components disclosed in Paragraphs [0068] to [0075] in JP2010-106268A (Paragraphs [0112] to [0118] in the specification of the corresponding US2011/0124824A) can be referenced.

Preferred examples of the other configuration units include configuration units represented by Formula (A1-2) described below.

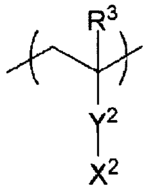

(A 1 − 2)

In Formula (A1-2), $R^3$ represents a hydrogen atom or a methyl group and is preferably a hydrogen atom.

$Y^2$ represents a single bond or a divalent linking group and the divalent linking group is identical to the divalent linking group in Formula (A1-1). Particularly, $Y^2$ is preferably -COO-, -CO-, -NH-, a linear or branched alkylene group, a group obtained by a combination thereof, or a single bond.

In Formula (A1-2), $X^2$ represents $-PO_3H$, $-PO_3H_2$, -OH, or -COOH and is preferably -COOH.

In a case in which the polymer having the configuration unit represented by Formula (A1-1) has another configuration unit (preferably the configuration unit represented by Formula (A1-2)), the molar ratio between the configuration unit represented by Formula (A1-1) and the configuration unit represented by Formula (A1-2) is preferably in a range of 95:5 to 20:80 and more preferably in a range of 90:10 to 40:60.

<<<Second embodiment>>>

As the copper compound that can be used in the present invention, a polymer-type copper compound obtained by reacting a polymer which has an acid group or a salt thereof and has an aromatic hydrocarbon group and/or an aromatic heterocyclic group in the main chain (hereinafter, referred to as the aromatic group-containing polymer) and a copper component may be used. The aromatic group-containing polymer needs to have either or both an aromatic hydrocarbon group and an aromatic heterocyclic group in the main chain and may have two or more thereof. The acid group or the salt thereof is identical to that in the above-described copper compound obtained by reacting a polymer containing the acid group described above or a salt thereof and a copper component and the preferred range thereof is also identical.

The aromatic hydrocarbon group is preferably, for example, an aryl group. The number of carbon atoms in the aryl group is preferably in a range of 6 to 20, more preferably in a range of 6 to 15, and still more preferably in a range of 6 to 12. Particularly, a phenyl group, a naphthyl group, or a biphenyl group is preferred. The aromatic hydrocarbon group may be a single ring or may be polycyclic, but is preferably a single ring.

As the aromatic heterocyclic group, it is possible to use, for example, an aromatic heterocyclic group having 2 to 30 carbon atoms. The aromatic heterocyclic group is preferably a 5-membered ring or a 6-membered ring. In addition, the aromatic heterocyclic group may be a single ring or a condensed ring and is, for example, a single ring or a condensed ring having 2 to 8 condensations. Examples of the hetero atom included in the heterocycle include a nitrogen atom, an oxygen atom, and a sulfur atom and is preferably nitrogen or oxygen.

In a case in which the aromatic hydrocarbon group and/or the aromatic heterocyclic group has a substituent T, examples of the substituent T include an alkyl group, a polymerizable group (preferably a polymerizable group having a carbon-carbon double bond), a halogen atom (a fluorine atom, a chlorine atom, a bromine atom, or an iodine atom), a carboxylic ester group, a halogenated alkyl group, an alkoxy group, a methacryloyloxy group, an acryloyloxy group, an ether group, a sulfonyl group, a sulfide group, an amide group, an acyl group, a hydroxyl group, a carboxyl group, an aralkyl group, and the like and an alkyl group (particularly an alkyl group having 1 to 3 carbon atoms) is preferred.

Particularly, the aromatic group-containing polymer is preferably at least one polymer selected from polyether sulfone-based polymers, polysulfone-based polymers, polyether ketone-based polymers, polyphenylene ether-based polymers, polyimide-based polymers, polybenzimidazole-based polymers, polyphenylene-based polymers, phenol resin-based polymers, polycarbonate-based polymers, polyamide-based polymers, and polyester-based polymers. Hereinafter, examples of the respective polymers will be described.

Polyether sulfone-based polymers: polymers having a main chain structure represented by $(-O-Ph-SO_2-Ph-)$ (Ph

represents a phenylene group, which shall apply below)
Polysulfone-based polymers: polymers having a main chain structure represented by (-O-Ph-Ph-O-Ph-$SO_2$-Ph-)
Polyether ketone-based polymers: polymers having a main chain structure represented by (-O-Ph-O-Ph-C(=O)-Ph-)
Polyphenylene ether-based polymer: polymers having a main chain structure represented by (-Ph-O-, -Ph-S-)
Polyphenylene-based polymers: polymers having a main chain structure represented by (-Ph-)
Phenol resin-based polymers: polymers having a main chain structure represented by (-Ph(OH)-$CH_2$-)
Polycarbonate-based polymers: polymers having a main chain structure represented by (-Ph-O-C(=O)-O-)
Polyamide-based polymers, for example, polymers having a main chain structure represented by (-Ph-C(=O)-NH-)
Polyester-based polymers, for example, polymers having a main chain structure represented by (-Ph-C(=O)-O-)

Regarding the polyether sulfone-based polymers, the polysulfone-based polymers and the polyether ketone-based polymers, for example, the main chain structures described in Paragraph [0022] in JP2006-310068A and Paragraph [0028] in JP2008-27890A can be referenced and the content thereof is incorporated into the specification of the present application by reference.
Regarding the polyimide-based polymers, the main chain structures described in Paragraphs [0047] to [0058] in JP2002-367627A and Paragraphs [0018] and [0019] in JP2004-35891A can be referenced.
A preferred example of the aromatic group-containing polymer preferably has a configuration unit represented by Formula (A1-3) described below.

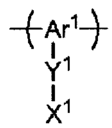
(A 1 − 3)

(In Formula (A1-3), $Ar^1$ represents an aromatic hydrocarbon group and/or an aromatic heterocyclic group, $Y^1$ represents a single bond or a divalent linking group, and $X^1$ represents an acid group or a salt thereof.)
In Formula (A1-3), in a case in which $Ar^1$ represents an aromatic hydrocarbon group, the aromatic hydrocarbon group is identical to the aromatic hydrocarbon group described above and the preferred range is also identical. In a case in which $Ar^1$ represents an aromatic heterocyclic group, the aromatic heterocyclic group is identical to the aromatic heterocyclic group described above and the preferred range is also identical.
$Ar^1$ may have a substituent other than -$Y^1$-$X^1$ in Formula (A1-3). In a case in which $Ar^1$ has a substituent, the substituent is identical to the substituent T described above and the preferred range is also identical.
In Formula (A1-3), $Y^1$ is preferably a single bond. In a case in which $Y^1$ represents a divalent linking group, examples of the divalent linking group include a hydrocarbon group, an aromatic heterocyclic group, -O-, -S-, -$SO_2$-, -CO-, -C(=O)-O-, -O-C(=O)-, -$SO_2$-, -NX- (X represents a hydrogen atom or an alkyl group and is preferably a hydrogen atom), -C($R^{Y1}$)($R^{Y2}$)-, and groups obtained by a combination thereof. Here, each of $R^{Y1}$ and $R^{Y2}$ independently represents a hydrogen atom, a fluorine atom, or an alkyl group.
Examples of the hydrocarbon group include linear, branched, or cyclic alkylene groups or arylene groups. The number of carbon atoms in the linear alkylene group is preferably in a range of 1 to 20, more preferably in a range of 1 to 10, and still more preferably in a range of 1 to 6. The number of carbon atoms in the branched alkylene group is preferably in a range of 3 to 20, more preferably in a range of 3 to 10, and still more preferably in a range of 3 to 6. The cyclic alkylene group may be a single ring or may be polycyclic. The number of carbon atoms in the cyclic alkylene group is preferably in a range of 3 to 20, more preferably in a range of 4 to 10, and still more preferably in a range of 6 to 10. In the linear, branched, or cyclic alkylene groups, the hydrogen atom in the alkylene group may be substituted with a fluorine atom.
The arylene group is identical to the arylene group described above which is the divalent linking group in Formula (A1-1).
The aromatic heterocyclic group is not particularly limited, but is preferably a 5-membered ring or a 6-membered ring. In addition, the aromatic heterocyclic group may be a single ring or a condensed ring, is preferably a single ring or a condensed ring having 2 to 8 condensations, and more preferably a single ring or a condensed ring having 2 to 4 condensations.
In Formula (A1-3), the acid group represented by $X^1$ or a salt thereof is identical to the acid group described above or a salt thereof and the preferred range is also identical.
The weight-average molecular weight of the polymer having the configuration unit represented by Formula (A1-1), (A1-2), or (A1-3) is preferably 1,000 or more, more preferably in a range of 1000 to 10,000,000, still more preferably in a range of 3000 to 1,000,000, and particularly preferably in a range of 4000 to 400,000.
Specific examples of the polymer having the configuration unit represented by Formula (A1-1), (A1-2), or (A1-3)

include compounds described below and salts of the compounds described below, but the polymer is not limited thereto.

[Table 1]

| | | | |
|---|---|---|---|
| P-1 | 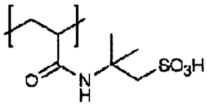 Mw=100,000 | P-9 | 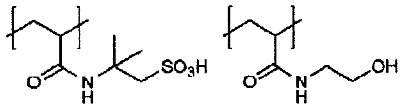 Mw=30,000 |
| P-2 | 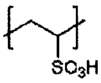 Mw=10,000 | P-10 | 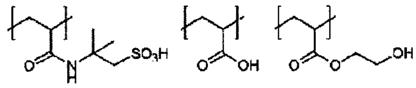 Mw=30,000 |
| P-3 | 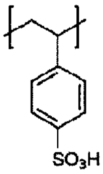 Mw=30,000 | P-11 | 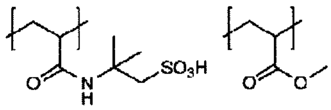 Mw-30,000 |
| P-4 | 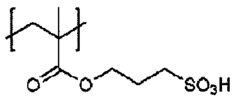 Mw=20,000 | P-12 | 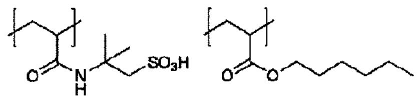 Mw=30,000 |
| P-5 | 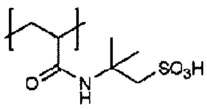 Mw=5,000 | P-13 | 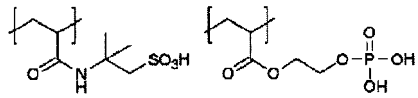 Mw=30,000 |
| P-6 | 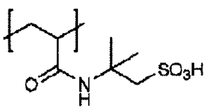 Mw=20,000 | P-14 | 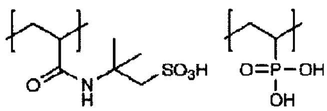 Mw=30,000 |
| P-7 | 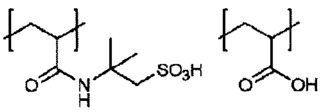 Mw=100,000 | P-15 | 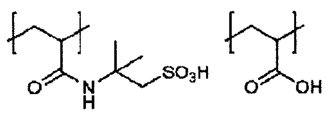 Mw=20,000 |
| P-8 | 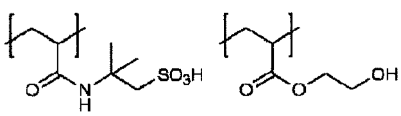 Mw=30,000 | | |

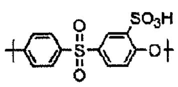
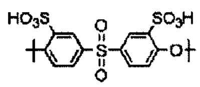
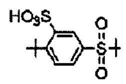
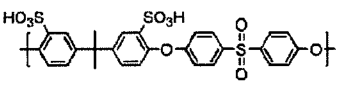

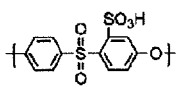
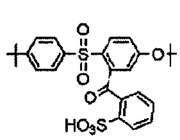
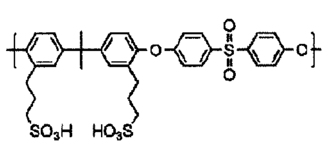
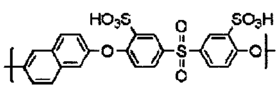

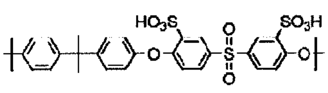
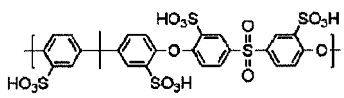
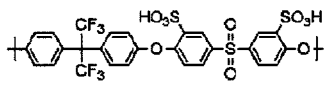

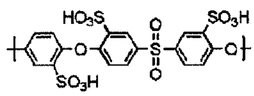
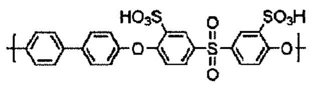
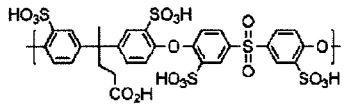

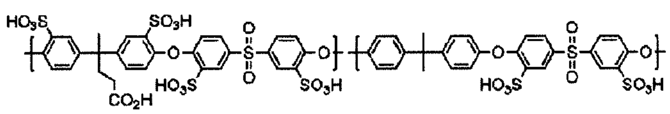
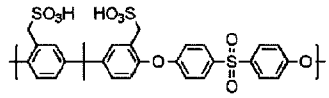

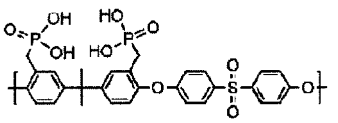
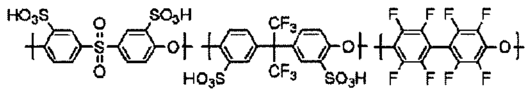

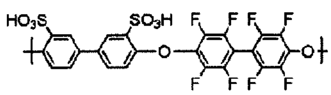
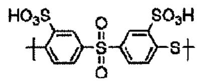
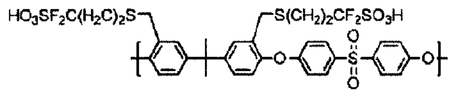

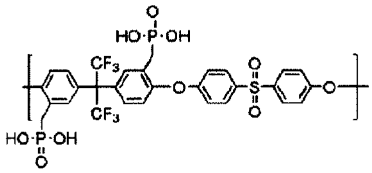
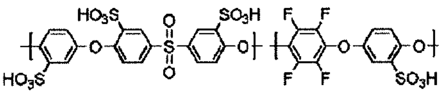
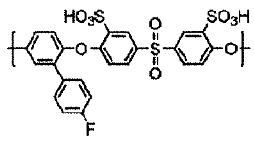

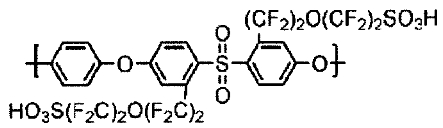
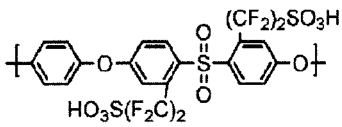

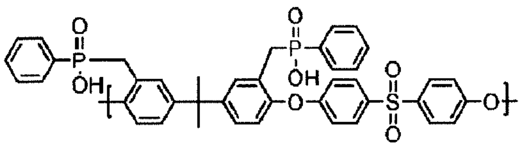
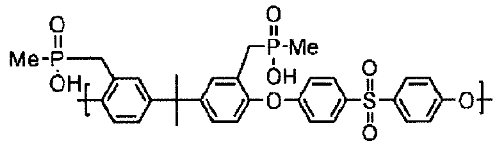

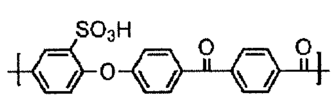
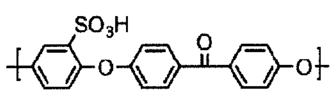
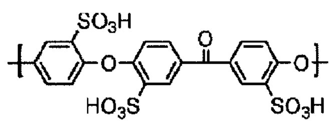

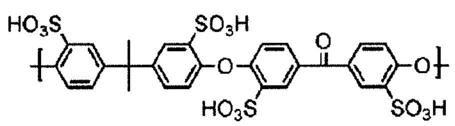
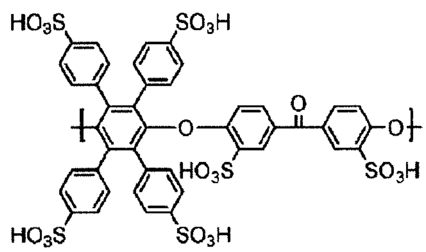

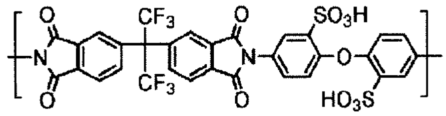
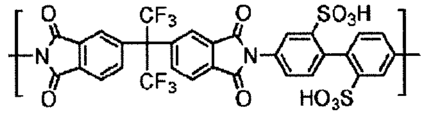
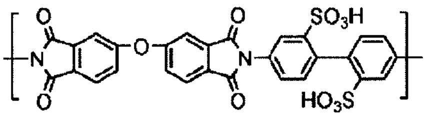
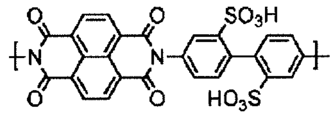
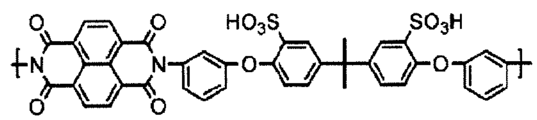
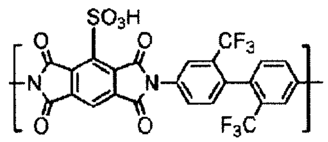
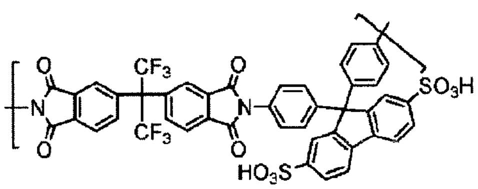
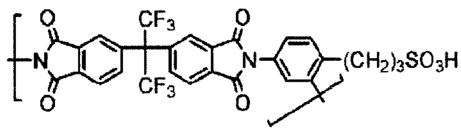
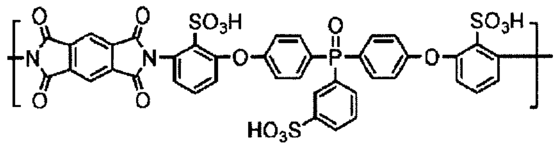
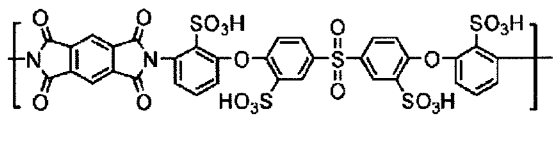
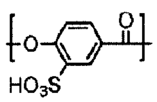
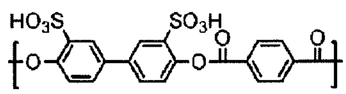
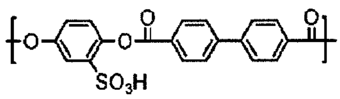
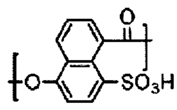
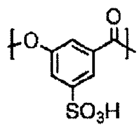
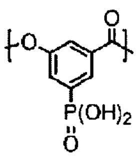
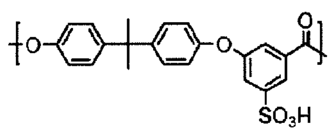
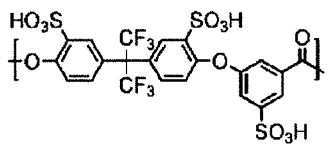
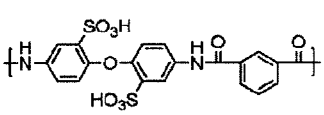
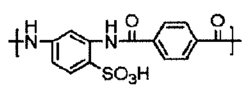
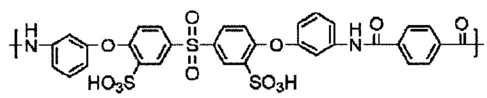
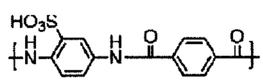
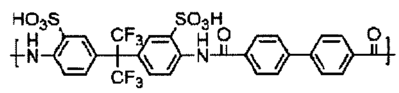
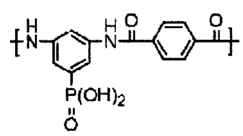
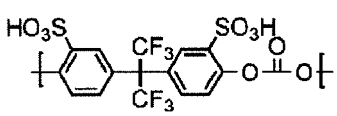
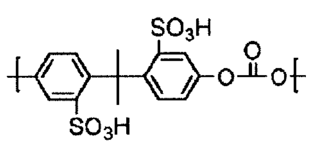
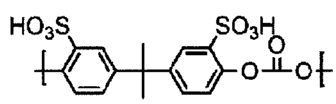

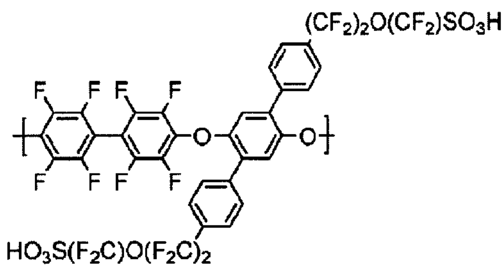
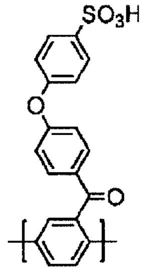
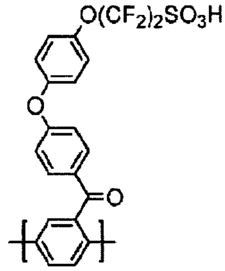

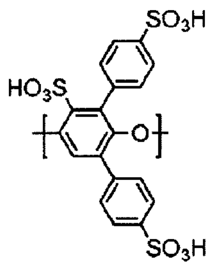
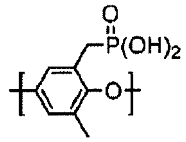
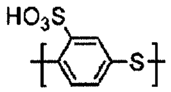
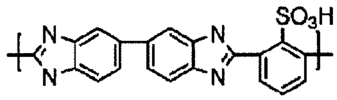
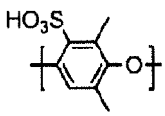
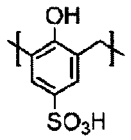
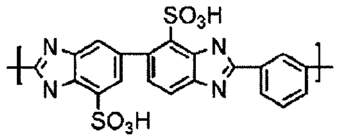

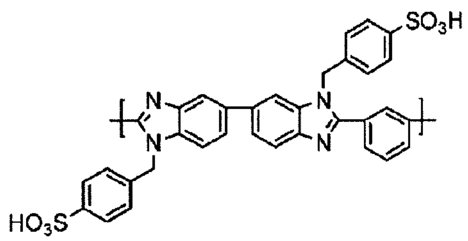
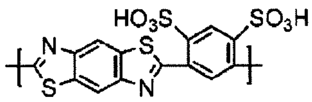
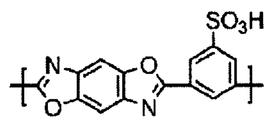
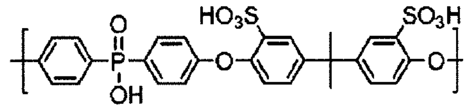

<Water-soluble binder>

The composition of the present invention preferably further includes a water-soluble binder. Particularly, the composition of the present invention preferably includes the above-described copper compound (preferably the copper complex, more preferably the phosphorous-containing copper complex or the sulfonic acid copper complex, and still more preferably the sulfonic acid copper complex) and a water-soluble binder. The above-described copper compound has high solubility in water or an aqueous solvent, can be jointly used with a water-soluble binder, and is capable of providing the above-described near-infrared blocking filter having excellent characteristics.

Any water-soluble binder that can achieve the effects of the present invention may be used, but is preferably, for example, a water-soluble polymer, a water-soluble epoxy resin, or a sol-gel cured substance obtained by hydrolyzing and polycondensing at least one of the alkoxide compounds of an element selected from the group consisting of Si, Ti, Zr, and Al.

<Water-soluble polymer>

Examples of the water-soluble polymer used in the present invention include water-soluble polymers that are derived from animal protein and water-soluble polymers that are not derived from animal protein.

The water-soluble polymers that are derived from animal protein refer to natural water-soluble polymers such as glue, casein, gelatin, or egg white or chemically-modified water-soluble polymers and the water-soluble polymers are particularly preferably gelatin.

Gelatin can be classified into acid-treated gelatin and alkali-treated gelatin (a lime treatment or the like) depending on the synthesis method and both types of gelatin can be preferably used. The molecular weight of the gelatin is preferably in a range of 10,000 to 1,000,000. In addition, denatured gelatin that has been denaturation-treated using an amino group or a carboxyl group in gelatin can also be used (for example, phthalated gelatin or the like). As the

gelatin, inert gelatin (for example, Nitta Gelatin 750), phthalated gelatin (for example, Nitta Gelatin 801), and the like can be used.

GEL820 also can be used as the gelatin. GEL820 is obtained by deionizing and succinylating American Green Bone (AGB) from Nitta Co., Ltd. (100%, extracted only once=GEL770). In addition, in a case in which the gelatin is used, it is preferable to jointly use a special crosslinking agent VS-C or VS-B manufactured by Fujifilm Finechemicals Co., Ltd. from the viewpoint of the strength or the surface shape of a film.

The water-soluble polymers that are not derived from animal protein refer to natural macromolecules (polysaccharide-based, microbe-based, and animal-based macromolecules) other than animal protein such as gelatin, semisynthetic macromolecules (cellulose-based, starch-based, and alginic acid-based macromolecules), and synthetic macromolecules (vinyl-based and other macromolecules) and examples thereof include synthetic polymers such as polyvinyl alcohols described below and natural or semisynthetic polymers for which plant-derived cellulose or the like is used as a raw material.

The water-soluble polymers that are not derived from animal protein are preferably polyvinyl alcohols and acrylic acid-vinyl alcohol copolymerized polymers. Specifically, polyacrylamide and polyvinyl alcohols are preferred.

<Water-soluble epoxy resin>

The water-soluble epoxy resin refers to a compound having at least one hydrophilic site and two or more epoxy groups in the molecule. Particularly, the water-soluble epoxy resin preferably has an ether bond or a hydroxyl group as the hydrophilic site.

Preferred examples of the water-soluble epoxy resin include sorbitol polyglycidyl ether, polyglycerol polyglycidyl ether, glycerol polyglycidyl ether, diglycerol polyglycidyl ether, trimethylol propane polyglycidyl ether, ethylene glycol diglycidyl ether, polyethylene glycol diglycidyl ether, propylene glycol diglycidyl ether, polypropylene glycol diglycidyl ether, phenoxy pentaethyleneoxy glycidyl ether, and lauryloxy pentadecaethyleneoxy glycidyl ether.

Among these, sorbitol polyglycidyl ether, glycerol polyglycidyl ether, and diglycerol polyglycidyl ether are more preferred.

Examples of the commercially available product of the water-soluble epoxy resin include "DENACOL (registered trademark)" series EX-313, EX-421, EX-614B, EX-810, EX-811, EX-851, EX-821, EX-830, EX-832, EX-841, EX-861, EX-911, EX-941, EX-920, EX-921, and EX-931 manufactured by Nagase ChemteX Corporation.

In addition, examples thereof include "EPOLITE" series 40E, 100E, 200E, 400E, 70P, 200P, and 400P manufactured by Kyoeisha Chemical Co., Ltd.

In addition, examples thereof include diglycidyl ethers of ethylene glycol or polyethylene glycol such as "EPOLEAD (registered trademark) NT" series 212 and 214, diglycidyl ethers of propylene glycol or polypropylene glycol such as "EPOLEAD (registered trademark) NT" series 228 which are manufactured by Daicel Corporation, and the like.

<Sol-gel cured substance>

The sol-gel cured substance is preferably a sol-gel cured substance obtained by hydrolyzing and polycondensing at least one of the alkoxide compounds of an element selected from the group consisting of Si, Ti, Zr, and Al (hereinafter, also referred to as the "specific alkoxide compounds") and, furthermore, heating and drying the alkoxide compounds as desired since it is possible to easily produce a sol-gel cured substance that is highly resistant to scratches and abrasion.

[Specific alkoxide compound]

The specific alkoxide compound is preferably a compound represented by General Formula (II) described below in terms of easy procurement thereof.

$$M^2(OR^1)_aR^2_{4-a} \qquad (II)$$

(In General Formula (II), $M^2$ represents an element selected from Si, Ti, and Zr, each of $R^1$ and $R^2$ independently represents a hydrogen atom or a hydrocarbon group, and a represents an integer from 2 to 4.)

Each hydrocarbon group of $R^1$ and $R^2$ in General Formula (II) is preferably an alkyl group or an aryl group.

In a case in which each of $R^1$ and $R^2$ represents an alkyl group, the number of carbon atoms is preferably in a range of 1 to 18, more preferably in a range of 1 to 8, and still more preferably in a range of 1 to 4. In addition, in a case in which each of $R^1$ and $R^2$ represents an aryl group, a phenyl group is preferred.

The alkyl group or the aryl group may have a substituent and examples of an introducible substituent include a halogen atom, an amino group, a mercapto group, and the like. Meanwhile, the compound is a low-molecular compound and preferably has a molecular weight of 1000 or less.

Regarding the specific examples of the compound represented by General Formula (II), the description of Paragraphs [0041] to [0045] in JP2012-238579A can be referenced. The present invention is not limited thereto.

In a case in which $M^2$ is Si and a is 2, that is, the specific alkoxide compound is a difunctional alkoxysilane, from the viewpoint of easy procurement thereof and adhesiveness to other layers, examples thereof include dimethyl dimethoxysilane, diethyl dimethoxysilane, dimethyl diethoxysilane, diethyl diethoxysilane, and the like.

In a case in which $M^2$ is Si and a is 3, that is, the specific alkoxide compound is a trifunctional alkoxysilane, from the viewpoint of easy procurement thereof and adhesiveness to other layers, examples thereof include methyl trimethoxysilane, ethyl trimethoxysilane, methyl triethoxysilane, ethyl triethoxysilane, and the like.

In a case in which $M^2$ is Si and a is 4, that is, the specific alkoxide compound is a tetrafunctional alkoxysilane, examples thereof include tetramethoxysilane, tetraethoxysilane, and the like.

Specific alkoxides can be easily procured as commercially available products and can also be obtained using a well-known synthesis method, for example, a reaction between each metal chloride and an alcohol.

As the specific alkoxide, one compound may be used singly or a combination of two or more compounds may be used.

In order to accelerate a sol-gel reaction, the joint use of an acidic catalyst or a basic catalyst is practically preferred since the joint use thereof can increase the reaction efficiency. Regarding specific examples thereof, the description of Paragraphs [0048] to [0056] in JP2012-238579A can be referenced and the content thereof is incorporated into the specification of the present application by reference.

The amount of the water-soluble binder added to the composition of the present invention is preferably in a range of 1% by mass to 80% by mass, more preferably in a range of 5% by mass to 50% by mass, and particularly preferably in a range of 7% by mass to 40% by mass in relation to the total solid content excluding the solvent.

Only one water-soluble binder or two or more water-soluble binders may be added and, in a case in which two or more binders are added, the total amount thereof needs to fall into the above-described range. In addition, the water-soluble binder is preferably jointly used with a compound having a partial structure represented by Formula (1) described below in terms of the prevention of the cracking of films or the shapes of film surfaces.

<Compound having partial structure represented by Formula (1)>

The near-infrared absorbing composition according to an embodiment of the present invention includes a compound having the partial structure represented by Formula (1), that is, $-C(=O)NR^1-$ ($R^1$ represents a hydrogen atom or an organic group). The blending of the compound having the above-described partial structure in the near-infrared absorbing composition improves the near-infrared shielding properties when a cured film is produced using the near-infrared absorbing composition of the present invention and improves humidity resistance.

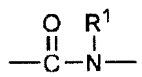

式（1）

Formula (1)

(In Formula (1), $R^1$ represents a hydrogen atom or an organic group.)

In Formula (1), $R^1$ represents a hydrogen atom or an organic group. Examples of the organic group include hydrocarbon groups and specifically include alkyl groups and aryl groups. An alkyl group having 1 to 20 carbon atoms, an aryl group having 6 to 20 carbon atoms, or a group obtained by combining the above-described group and a divalent linking group is preferred.

Specific examples of the preferred organic group described above include -OR', -SR', and combinations of the above-described group and at least one of $-(CH_2)_m-$ (m is an integer from 1 to 10), a cyclic alkylene group having 5 to 10 carbon atoms, -O-, -CO-, -COO-, and -NH-. Here, R' is preferably a hydrogen atom, a linear alkyl group having 1 to 10 carbon atoms, a branched alkyl group having 3 to 10 carbon atoms, a cyclic alkyl group having 3 to 10 carbon atoms (preferably a linear alkyl group having 1 to 7 carbon atoms, a branched alkyl group having 3 to 7 carbon atoms, a cyclic alkyl group having 3 to 7 carbon atoms), an aryl group having 6 to 10 carbon atoms (preferably a phenyl group), or a combination of an aryl group having 6 to 10 carbon atoms and an alkylene group having 1 to 10 carbon atoms.

In addition, in Formula (1), $R^1$ and C may be bonded together and thus form a ring structure (heterocyclic structure). A hetero atom in the heterocyclic structure is a nitrogen atom in Formula (1). The heterocyclic structure is preferably a 5- or 6-membered ring structure and more preferably a 5-membered ring structure. The heterocyclic structure may be a condensed ring, but is preferably a single ring.

Specific examples of particularly preferred $R^1$ include a hydrogen atom, an alkyl group having 1 to 3 carbon atoms (preferably a methyl group), groups obtained by combining -OR' (R' is a liner alkyl group having 1 to 5 carbon

atoms) and $-(CH_2)_m-$ (m is an integer from 1 to 10 and preferably an integer from 1 to 5), and groups in which $R^1$ and C in Formula (1) are bonded together and thus form a heterocyclic structure (preferably a 5-membered ring structure).

The compound having the partial structure represented by Formula (1) is preferably represented by (the main chain structure of the polymer-the partial structure (1)-$R^1$) or (A- the partial structure (1)-B). Here, A is a linear alkyl group having 1 to 10 carbon atoms, a branched alkyl group having 3 to 10 carbon atoms, or a cyclic alkyl group having 3 to 10 carbon atoms. In addition, B is a group obtained by combining $-(CH_2)_m-$ (m is an integer from 1 to 10 and preferably an integer from 1 to 5), the partial structure (1), and a polymerizable group.

In addition, the compound having the partial structure represented by Formula (1) preferably has a structure represented by any one of Formulae (1-1) to (1-5) described below.

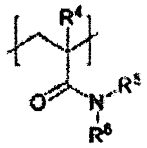 Formula (1-1) 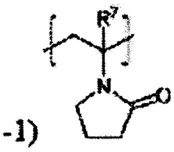 Formula (1-2) 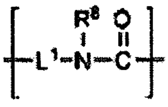 Formula (1-3)

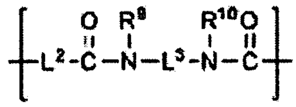 Formula (1-4) 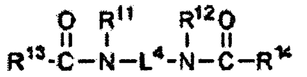 Formula (1-5)

(In Formula (1-1), $R^4$ represents a hydrogen atom or a methyl group and each of $R^5$ and $R^6$ independently represents a hydrogen atom or an organic group. In Formula (1-2), $R^7$ represents a hydrogen atom or a methyl group. In Formula (1-3), $L^1$ represents a divalent linking group and $R^8$ represents a hydrogen atom or an organic group. In Formula (1-4), each of $L^2$ and $L^3$ independently represents a divalent linking group and each of $R^9$ and $R^{10}$ independently represents a hydrogen atom or an organic group. In Formula (1-5), $L^4$ represents a divalent linking group and each of $R^{11}$ to $R^{14}$ independently represents a hydrogen atom or an organic group.)

In Formula (1-1), each of $R^5$ and $R^6$ independently represents a hydrogen atom or an organic group. The organic group is identical to $R^1$ in Formula (1) and the preferred range thereof is also identical.

In Formulae (1-3) to (1-5), $L^1$ to $L^4$ represent divalent linking groups. The divalent linking group is preferably a divalent linking group obtained through a combination with at least one of $-(CH_2)_m-$ (m is an integer from 1 to 10), a cyclic alkylene group having 5 to 10 carbon atoms, -O-, -CO-, -COO-, and -NH- and more preferably $-(CH_2)_m-$ (m is an integer from 1 to 8).

In Formulae (1-3) to (1-5), each of $R^8$ to $R^{14}$ independently represents a hydrogen atom or an organic group. The organic group is preferably a hydrocarbon group, specifically, an alkyl group or an alkenyl group.

The alkyl group may be substituted. In addition, the alkyl group may have a linear shape, a branched shape, or a ring shape, but preferably has a linear shape or a ring shape. The alkyl group is preferably an alkyl group having 1 to 10 carbon atoms, more preferably an alkyl group having 1 to 8 carbon atoms, and more preferably an alkyl group having 1 to 6 carbon atoms.

The alkenyl group may be substituted. The alkenyl group is preferably an alkenyl group having 1 to 10 carbon atoms, more preferably an alkenyl group having 1 to 4 carbon atoms, and particularly preferably a vinyl group.

Examples of the substituent include a polymerizable group, a halogen atom (a fluorine atom, a chlorine atom, a bromine atom, or an iodine atom), an alkyl group, a carboxylic ester group, a halogenated alkyl group, an alkoxy group, a methacryloyloxy group, an acryloyloxy group, an ether group, a sulfonyl group, a sulfide group, an amide group, an acyl group, a hydroxyl group, a carboxyl group, or the like. Among the above-described substituents, a polymerizable group (for example, a vinyl group, a (meth)acryloyloxy group), a (meth)acryloyl group, an epoxy group, an aziridinyl group, or the like) is preferred and a vinyl group is more preferred.

In addition, the compound having the partial structure represented by Formula (1) may be a monomer or a polymer, but is preferably a polymer. The compound having the partial structure represented by Formula (1) is preferably a compound represented by Formula (1-1) or (1-2).

In addition, in a case in which the compound having the partial structure represented by Formula (1) is a polymer, the compound preferably has the partial structure at the side chain of the polymer.

The molecular weight of the compound having the partial structure represented by Formula (1) is preferably in a range of 50 to 1,000,000 and more preferably in a range of 500 to 500,000. When the molecular weight is set in the above-described range, it is possible to more effectively achieve the effects of the present invention.

The content of the compound having the partial structure represented by Formula (1) is preferably in a range of 5% by mass to 80% by mass and more preferably in a range of 10% by mass to 60% by mass in the composition of the present invention.

Specific examples of the compound having the partial structure represented by Formula (1) include compounds having structures described below or exemplary compounds described below, but the compound is not limited thereto. In the present invention, particularly, the compound having the partial structure represented by Formula (1) is preferably polyacrylamide.

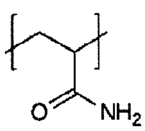
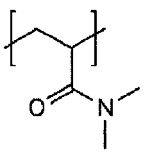
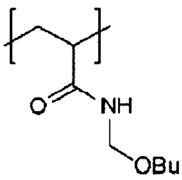
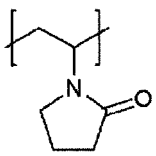

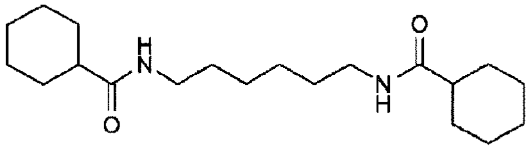
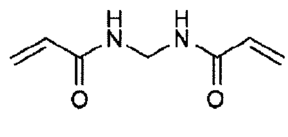

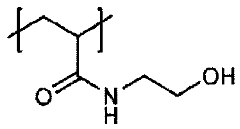
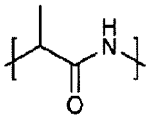

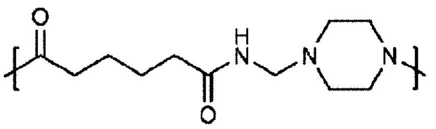
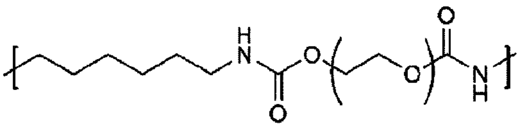

In addition, specific examples of the compound having the partial structure represented by Formula (1) include water-soluble polymers and examples of the preferred main chain structure include polyvinylpyrrolidone, poly(meth)acrylamide, polyamide, polyvinylpyrrolidone, polyurethane, and polyuria. The water-soluble polymer may be a copolymer and the copolymer may be a random copolymer.

As the polyvinylpyrrolidone, trade names K-30, K-85, K-90, K-30W, K-85W, and K-90W (manufactured by Nippon Shokubai Co., Ltd.) can be used.

Examples of the poly(meth)acrylamide include polymers and copolymers of (meth)acrylamide. Specific examples of the acrylamide include acrylamide, N-methylacrylamide, N-ethylacrylamide, N-propylacrylamide, N-butylacrylamide, N-hexylacrylamide, N-hydroxyethylacrylamide, N-phenylacrylamide, N-tolylacrylamide, N-(hydroxyphenyl)acrylamide, N-(sulfamoylphenyl)acrylamide, N-(phenylsulfonyl)acrylamide, N-(tolylsulfonyl)acrylamide, N,N-dimethylacrylamide, N-methyl-N-phenylacrylamide, N-hydroxyethyl-N-methylacrylamide, and the like. In addition, methacrylamides corresponding to the above-described poly(meth)acrylamides can also be used in a similar manner.

Examples of the water-soluble polyamide resin particularly include compounds obtained by copolymerizing a polyamide resin and a hydrophilic compound. A derivative of the water-soluble polyamide resin refers to a compound in which the structure of an amid bond is changed by the substitution or addition reaction of an atom in the water-soluble polyamide resin molecule such as a compound in which a water-soluble polyamide resin is used as a raw material and a hydrogen atom in an amid bond (-CONH-) is substituted with a methoxymethyl group ($-CH_2OCH_3$).

Examples of the polyamide resin include so-called "n-nylon" that is synthesized by the polymerization of $\omega$ amino acids and so-called "n,m-nylon" that is synthesized by the copolymerization of a diamine and dicarboxylic acid. Among these, from the viewpoint of imparting hydrophilic properties, a copolymer of a diamine and dicarboxylic acid is preferred and a reaction product of $\varepsilon$-caprolactam and dicarboxylic acid is more preferred.

Examples of a hydrophilic compound include hydrophilic nitrogen-containing cyclic compounds, polyalkylene glycols, and the like.

Here, the hydrophilic nitrogen-containing cyclic compound refers to a compound including a ternary amine component at the side chain or the main chain and examples thereof include aminoethyl piperazine, bisaminopropyl piperazine, $\alpha$-dimethylamino $\varepsilon$-caprolactam, and the like.

Meanwhile, in the compound in which the polyamide resin and the hydrophilic compound are copolymerized together, for example, at least one selected from the group consisting of hydrophilic nitrogen-containing cyclic compounds

and polyalkylene glycols is copolymerized at the main chain of the polyamide resin. Therefore, the hydrogen bond capability at the amide-bonded portion in the polyamide resin is strong with respect to N-methoxymethylated nylon.

Among the compounds in which the polyamide resin and the hydrophilic compound are copolymerized together, 1) the reaction products of ε-caprolactam, the hydrophilic nitrogen-containing cyclic compound, and dicarboxylic acid and 2) the reaction products of ε-caprolactam, polyalkylene glycol, and dicarboxylic acid are preferred.

The above-described compounds are commercially available under a trademark of, for example, "AQ NYLON" from Toray Fine Chemicals Co., Ltd. The reaction products of ε-caprolactam, the hydrophilic nitrogen-containing cyclic compound, and dicarboxylic acid can be procured from AQ NYLON-90 manufactured by Toray Fine Chemicals Co., Ltd., and the reaction products of ε-caprolactam, polyalkylene glycol, and dicarboxylic acid can be procured from AQ NYLON-70 manufactured by Toray Fine Chemicals Co., Ltd. AQ NYLON A-90, P-70, P-95, and T-70 (manufactured by Toray Fine Chemicals Co., Ltd.) can be used.

The composition of the present invention preferably includes a polymer having a crosslinked group such as an unsaturated double bond, an epoxy group, or an oxetanyl group. Therefore, it is possible to further improve film-forming properties (the suppression of cracking or warping) and humidity resistance when a cured film is produced. Specific examples thereof include polymers (copolymers) having a repeating unit described below. The polymer having the following repeating unit is preferably a polymer having an epoxy group.

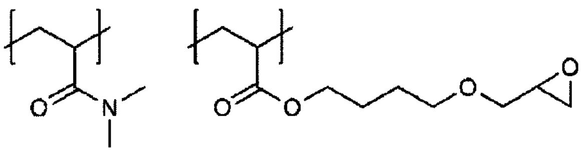

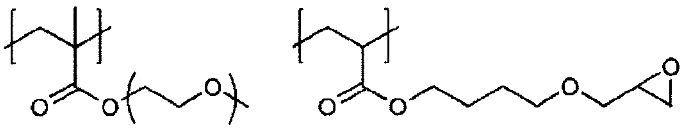

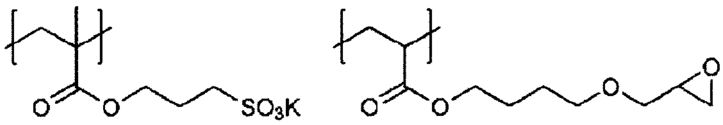

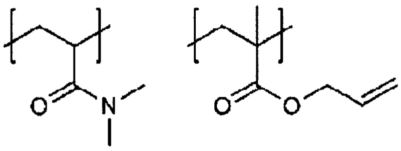

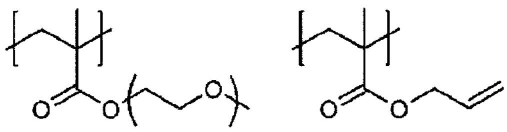

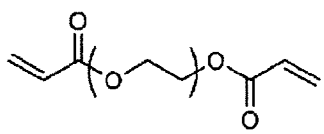

The molar ratio between a repeating unit that includes the partial structure represented by Formula (1) described above and a polymer having a repeating unit that includes an epoxy group is preferably in a range of 10/90 to 90/10 and more preferably in a range of 30/70 to 70/30. The weight-average molecular weight of the copolymer is preferably in a range of 3,000 to 1,000,000 and more preferably in a range of 5,000 to 200,000.

<Subsidiary near-infrared absorbing substance>

The composition of the present invention may further include a substance different from the above-described near-infrared absorbing substance (subsidiary near-infrared absorbing substance) in addition to the near-infrared absorbing substance. In addition, a subsidiary near-infrared absorbing layer including the subsidiary near-infrared absorbing substance may be separately formed. Since the composition of the present invention includes the subsidiary near-infrared absorbing substance in addition to the near-infrared absorbing substance, it is possible to provide a composition having superior visible light transmissivity in the entire wavelength range of 450 nm to 550 nm when a film having a film thickness of 300 $\mu$m or less is formed. In addition, it is possible to provide a near-infrared blocking filter having high light-shielding properties (near-infrared shielding properties) in the near-infrared range and a high transmissivity (visible light transmissivity) in the visible light range.
The near-infrared absorbing composition of the present invention preferably includes a metallic oxide as the subsidiary near-infrared absorbing substance. The metallic oxide is preferably a metallic oxide having the maximum absorption wavelength in a wavelength range of 800 nm to 2000 nm.
The metallic oxide used in the near-infrared absorbing composition of the present invention is not particularly limited as long as the metallic oxide has the maximum absorption wavelength ($\lambda_{max}$) in a wavelength range of 800 nm to 2000 nm, and examples thereof include metallic oxides such as cesium tungsten oxide ($CsWO_x$), silica ($SiO_2$), magnetite ($Fe_3O_4$), alumina ($Al_2O_3$), titania ($TiO_2$), zirconia ($ZrO_2$), and spinel ($MgAl_2O_4$), and cesium tungsten oxide is preferred.
Tungsten oxide-based compounds are infrared shielding materials that strongly absorb infrared rays (particularly light rays having a wavelength in a range of approximately 800 nm to 1200 nm) (that is, has high light shielding properties (shielding properties) to infrared rays) and slightly absorb visible light rays. Therefore, when the composition of the present invention includes a tungsten compound, it is possible to manufacture a near-infrared blocking filter having high light shielding properties in the infrared range (infrared shielding properties) and high near-infrared transmitting properties in the visible light range (visible light transmitting properties).
According to the near-infrared absorbing composition of the present invention, when the above-described near-infrared absorbing substance and the subsidiary near-infrared absorbing substance are blended together, it is possible to form a near-infrared blocking filter having high shielding properties to near-infrared rays. Since the metallic oxide is used as the subsidiary near-infrared absorbing substance, it is possible to form a near-infrared blocking filter having favorable transmitting properties to visible light rays.
The tungsten oxide-based compound is preferably a tungsten oxide-based compound represented by General Formula (Composition Formula) (I) described below.

$$M_xW_yO_z \cdots \quad (I)$$

M represents metal, W represents tungsten, and O represents oxygen.

$$0.001 \leq x/y \leq 1.1$$

$$2.2 \leq z/y \leq 3.0$$

Examples of the metal M include alkali metals, alkali earth metals, Mg, Zr, Cr, Mn, Fe, Ru, Co, Rh, Ir, Ni, Pd, Pt, Cu, Ag, Au, Zn, Cd, Al, Ga, In, Tl, Sn, Pb, Ti, Nb, V, Mo, Ta, Re, Be, Hf, Os, and Bi and alkali metals are preferred. The number of the metals M may be one or more.
M is preferably an alkali metal, preferably Rb or Cs, and more preferably Cs.
The metal oxide is more preferably cesium tungsten oxide.
When x/y is 0.001 or more, it is possible to sufficiently shield infrared rays and, when x/y is 1.1 or less, it is possible to more reliably avoid the generation of impurity phases in the tungsten oxide-based compound.
When z/y is 2.2 or more, it is possible to further improve chemical stability as a material and, when z/y is 3.0 or less, it is possible to sufficiently shield infrared rays.
Specific examples of the tungsten oxide-based compound represented by Formula (I) include $Cs_{0.33}WO_3$, $Rb_{0.33}WO_3$, $K_{0.33}WO_3$, $Ba_{0.33}WO_3$, and the like, $Cs_{0.33}WO_3$ or $Rb_{0.33}WO_3$ is preferred, and $Cs_{0.33}WO_3$ is more preferred.
The metal oxide preferably has a fine particle form. The average particle diameter of the fine particles of the metal oxide is preferably 800 nm or less, more preferably 400 nm or less, and still more preferably 200 nm or less. When the average particle diameter is in the above-described range, the metal oxide is not capable of easily shielding visible

light through light scattering and thus it is possible to more reliably transmit light in the visible light range. From the viewpoint of avoiding light scattering, the average particle diameter is preferably small; however, in consideration of ease of handling during the manufacturing of the metal oxide, the average particle diameter of the metal oxide is generally 1 nm or more.

The metal oxide can be procured from commercially available products. In a case in which the metal oxide is, for example, a tungsten oxide-based compound, the tungsten oxide-based compound can be obtained using a method in which a tungsten compound is thermally treated in an inert gas atmosphere or a reducing gas atmosphere (refer to JP4096205B).

In addition, the tungsten oxide-based compound can be procured in a form of, for example, a dispersion of tungsten fine particles such as YMF-02 manufactured by Sumitomo Metal mining Co., Ltd.

The content of the subsidiary near-infrared absorbing substance is preferably in a range of 20% by mass to 85% by mass, more preferably in a range of 30% by mass to 80% by mass, and still more preferably in a range of 40% by mass to 75% by mass in relation to the total solid content mass of the composition of the present invention.

In addition, two or more tungsten compounds can be used.

<Solvent>

The composition of the present invention may include water or an aqueous solvent. The kinds of water or the aqueous solvents included may be one or more. In the composition of the present invention, the solid content of the near-infrared absorbing composition is preferably in a range of 10% by mass to 80% by mass and more preferably in a range of 15% by mass to 70% by mass. That is, the composition of the present invention preferably includes water or the aqueous solvent in a range of 20% by mass to 90% by mass and more preferably includes water or the aqueous solvent in a range of 30% by mass to 85% by mass.

Regarding the solvent used in the present invention, there is no particular limitation and any solvent can be appropriately selected depending on the purpose as long as the solvent is capable of uniformly dissolving or dispersing the respective components of the composition of the present invention. Preferred examples of the solvent include water and aqueous solvents such as alcohols.

Specific examples of the alcohols include the alcohols described in Paragraph [0136] and the like in JP2012-194534A.

<Curable compound>

The composition of the present invention may further include a curable compound other than the above-described components. However, in a case in which the copper complex is a curable compound having a polymerizable group, the composition does not necessarily include the curable compound. The curable compound may be a polymerizing compound or a non-polymerizing compound such as a binder. In addition, the curable compound may be a thermosetting compound or a photocurable compound and is preferably a thermosetting composition due to its high reaction rate.

<<Compound having polymerizable group>>

The composition preferably includes a compound having a polymerizable group (hereinafter, in some cases, referred to as the "polymerizing compound") as a curable composition. The above-described compound group is widely known in the corresponding industrial field and, in the present invention, the above-described compounds can be used without any particular limitation. The compounds may have any chemical form of, for example, a monomer, an oligomer, a prepolymer, a polymer, and the like.

The polymerizing compound may be monofunctional or polyfunctional and is preferably polyfunctional. The inclusion of the polyfunctional compound makes it possible to improve near-infrared shielding properties and heat resistance. The number of the functional groups is not particularly specified, but is preferably in a range of 2 to 8.

<<A: Polymerizing monomer and polymerizing oligomer>>

A first preferred embodiment of the composition of the present invention includes a monomer having a polymerizable group (polymerizing monomer) or an oligomer having a polymerizable group (polymerizing oligomer) (hereinafter, in some cases, the polymerizing monomer and the polymerizing oligomer will be collectively referred to as "the polymerizing monomer and the like") as the polymerizing compound.

Examples of the polymerizing monomer and the like include unsaturated carboxylic acids (for example, acrylic acid, methacrylic acid, itaconic acid, crotonic acid, isocrotonic acid, maleic acid, and the like), esters thereof, and amides thereof and esters of an unsaturated carboxylic acid and an aliphatic polyvalent alcohol compound, and amides of an

unsaturated carboxylic acid and an aliphatic polyvalent amine compound are preferred.

Addition reactants of an unsaturated carboxylic ester or amide having a nucleopetal substituent such as a hydroxyl group, an amino group, or a mercapto group and a monofunctional or polyfunctional isocyanate or epoxy, dehydration and condensation reactants of the unsaturated carboxylic ester or amide and a monofunctional or polyfunctional carboxylic acid, and the like are also preferably used. In addition, addition reactants of an unsaturated carboxyl ester or an amide having an electrophilic substituent such as an isocyanate group or an epoxy group and a monofunctional or polyfunctional alcohol, amine, or thiol and, furthermore, substitution reactants of an unsaturated carboxylic ester or amide having a desorbable substituent such as a halogen group or a tosyloxy group and a monofunctional or polyfunctional alcohol, amine, or thiol are also preferred. As additional examples, it is also possible to use a compound group in which the above-described unsaturated carboxylic acid is substituted with an unsaturated phosphonic acid, a vinyl benzene derivative such as styrene, a vinyl ether, an aryl ether, or the like.

As the specific compounds thereof, the compounds described in Paragraphs [0095] to [0108] in JP2009-288705A can be preferably used even in the present invention.

In addition, the polymerizing monomer and the like are also preferably compounds having an ethylenic unsaturated group which has at least one addition-polymerizing ethylene group and a boiling point of 100°C or higher at normal pressure. Specifically, the polymerizing monomer and the like are preferably monofunctional (meth)acrylates, difunctional (meth)acrylates, or tri- or more-functional (meth)acrylates (for example, tri- to hexafunctional (meth)acrylate).

Examples thereof include monofunctional acrylates or methacrylates such as polyethylenen glycol mono(meth)acrylate, polypropylene glycol mono(meth)acrylate, and phenoxyethyl (meth)acrylate;
monomers and oligomers obtained by adding ethylene oxide or propylene oxide to a polyfunctional alcohol such as polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl) ether, tri(acryloyloxyethyl) isocyanurate, glycerin, or trimethylolethane and then (meth)acrylating the mixture;
polyfunctional acrylate or methacrylate such as urethane (meth)acrylates as respectively described in JP1973-41708B (JP-S48-41708B), and JP1975-6034B (JP-S50-6034B), JP1976-37193B (JP-S51-37193B), polyester acrylates respectively described in JP1973-64183B (JP-S48-64183B), JP1974-43191B (JP-S49-43191B), and JP1977-30490B (JP-S52-30490B), epoxy acrylates that are reaction products of an epoxy polymer and (meth)acrylic acid and mixtures thereof.

Among these, the polymerizing compound is preferably ethyleneoxy-denatured pentaerythritol tetraacrylate (NK ester ATM-35E as a commercially available product: manufactured by Shin-Nakamura Chemical Co., Ltd.), dipentaerythritol triacrylate (KAYARAD D-330 as a commercially available product; manufactured by Nippon Kayaku Co., Ltd.), dipentaerythritol tetraacrylate (KAYARAD D-320 as a commercially available product; manufactured by Nippon Kayaku Co., Ltd.), dipentaerythritol penta(meth)acrylate (KAYARAD D-310 as a commercially available product; manufactured by Nippon Kayaku Co., Ltd.), dipentaerythritol hexa(meth)acrylate (KAYARAD DPHA as a commercially available product; manufactured by Nippon Kayaku Co., Ltd.), and structures in which the above-described (meth)acryloyl groups are through ethylene glycol and propylene glycol residues. In addition, the oligomer types thereof can also be used.

Examples of the polymerizing compound include polyfunctional (meth)acrylates and the like obtained by reacting a polyfunctional carboxylic acid and a compound having a cyclic ether group such as glycidyl (meth)acrylate and an ethylenic unsaturated group.

In addition, as other preferred polymerizing monomers and the like, it is also possible to use compounds and curled polymers having a fluorene ring and a di- or more-functional ethylenic polymerizable group which are described in JP2010-160418A, JP2010-129825A, JP4364216B, and the like.

In addition, the compounds having a boiling point of 100°C or higher at normal pressure and having at least one addition-polymerizing ethylenic unsaturated group are also preferably the compounds described in Paragraphs [0254] to [0257] in JP2008-292970A.

The compounds obtained by adding an ethylene oxide or propylene oxide to the polyfunctional alcohol, which are described as General Formulae (1) and (2) together with specific examples thereof in JP1998-62986A (JP-H10-62986A), and then (meth)acrylating the ethylene oxide or propylene oxide can also be used as the polymerizing monomer.

The polymerizing monomer used in the present invention is preferably a polymerizing monomer represented by General Formulae (MO-1) to (MO-6).

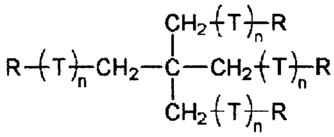

(MO-1)

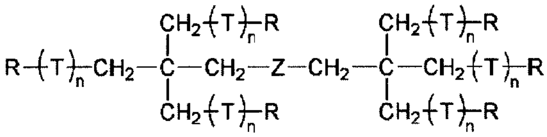

(MO-2)

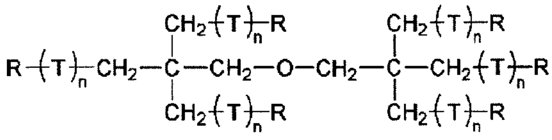

(MO-3)

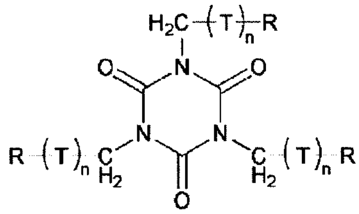

(MO-4)

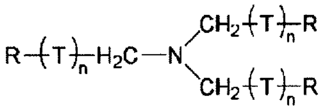

(MO-5)

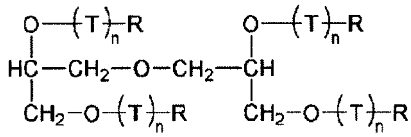

(MO-6)

R= 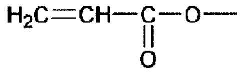 , 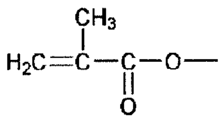 , 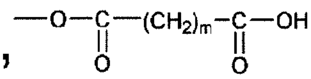

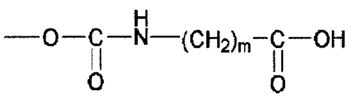 , $-OH$ , $-CH_3$

T= $-(CH_2)_m-$ , $-OCH_2-$ , $-O(CH_2)_2-$ , $-O(CH_2)_3-$ , $-O(CH_2)_4-$

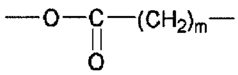 , 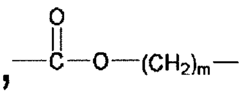 , 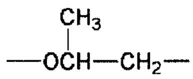 , 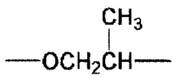

Z= 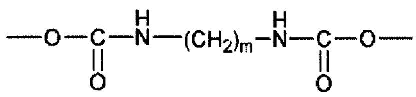

(In the formulae, ns are 0 to 14 respectively and ms are 1 to 8 respectively. The multiple R, T, and Z present in a molecule may be identical to or different from each other. In a case in which T is an oxyalkylene group, the terminal on the carbon atom side is bonded to R. At least one of the Rs is a polymerizable group.)

n is preferably 0 to 5 and more preferably 1 to 3.

m is preferably 1 to 5 and more preferably 1 to 3.

Rs are preferably the following four structures.

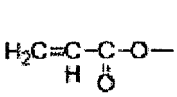 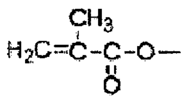 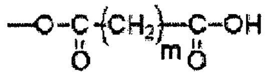 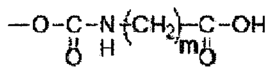

Rs are preferably the following two structures out of the above-described four structures.

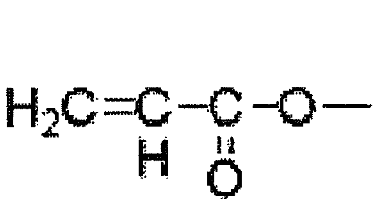 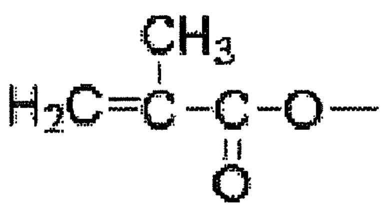

As specific examples of a radical polymerizing monomer represented by General Formulae (MO-1) to (MO-6), the compounds described in Paragraphs [0248] to [0251] in JP2007-269779A can also be preferably used in the present invention.

Among these, examples of the polymerizing monomer and the like include the polymerizing monomer and the like described in Paragraph [0477] in JP2012-208494A (Paragraph [0585] in the specification of the corresponding US2012/0235099A) and the content thereof is incorporated into the specification of the present application. In addition, diglycerin E0 (ethylene oxide)-denatured (meth)acrylate (M-460 as a commercially available product; manufactured by Toagosei Co., Ltd.) is preferred. Pentaerythritol tetraacrylate (manufactured by Shin-Nakamura Chemical Co., Ltd., A-TMMT) and 1,6-hexanediol diacrylate (manufactured by Nippon Kayaku Co., Ltd., KAYARAD HDDA) are also preferred. The oligomer types thereof can also be used.

Examples thereof include RP-1040 (manufactured by Nippon Kayaku Co., Ltd.).

The polymerizing monomer and the like are polyfunctional monomers and may have an acid group such as a carboxylic group, a sulfonic acid group, or a phosphorous acid group. Therefore, an ethylenic compound can be used as it is as long as the compound has an unreacted carboxylic group like a mixture-form compound. If necessary, it is also possible to introduce an acid group by reacting a hydroxyl group into the above-described ethylenic compound and a non-aromatic carboxy anhydride. In this case, specific examples of the non-aromatic carboxy anhydride being used include anhydrous tetrahydrophthalic acid, alkylated anhydrous tetrahydrophthalic acid, anhydrous hexahydrophthalic acid, alkylated anhydrous hexahydrophthalic acid, anhydrous succinic acid, and anhydrous maleic acid.

In the present invention, the monomer having an acid group is preferably an ester of an aliphatic polyhydroxy compound and an unsaturated carboxylic acid which is a polyfunctional monomer provided with an acid group by reacting an unreacted hydroxyl group in an aromatic polyhydroxy compound and a non-aromatic carboxy anhydride. In the above-described ester, the aliphatic polyhydroxy compound is particularly preferably pentaerythritol and/or dipentaerythritol. Examples of commercially available products thereof include ARONIX series M-305, M-510, M-520, and the like which are polybasic acid-denatured acryl oligomers manufactured by Toagosei Co., Ltd.

The acid value of the polyfunctional monomer having an acid group is preferably in a range of 0.1 mg-KOH/g to 40 mg-KOH/g and particularly preferably in a range of 5 mg-KOH/g to 30 mg-KOH/g. In a case in which two or more polyfunctional monomers having different acid groups are jointly used or polyfunctional monomers having no acid group are jointly used, it is preferable to prepare the polyfunctional monomer so that the acid value of the polyfunctional monomer falls in the above-described range as a whole.

In addition, the polymerizing monomer and the like preferably include a polyfunctional monomer having a caprolactam-denatured structure.

The polyfunctional monomer having a caprolactam-denatured structure is not particularly limited as long as the polyfunctional monomer has a caprolactam-denatured structure in the molecule. Examples of the polyfunctional monomer having a caprolactam-denatured structure include ε-caprolactam-denatured polyfunctional (meth)acrylates obtained by esterifying a polyvalent alcohol such as trimethylol ethane, ditrimethylol ethane, trimethylol propane, ditrimethylol propane, pentaerythritol, dipentaerythritol, tripentaerythritol, glycerin, diglycerol, or trimethylol melamine, (meth)acrylic acid, and ε-caprolactone. Among these, polyfunctional monomers having a caprolactam-denatured structure represented by Formula (1) described below are preferred.

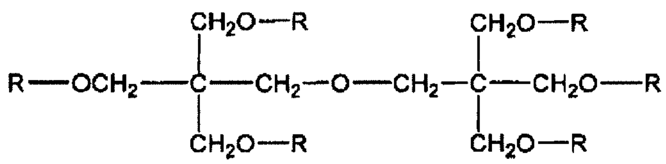
(1)

(In the formula, all of the six Rs are groups represented by Formula (2) described below or one to five of the six Rs are the groups represented by Formula (2) described below and the remaining Rs are groups represented by Formula (3) described below.)

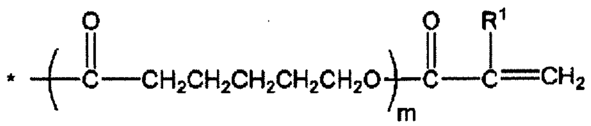
(2)

(In the formula, $R^1$ represents a hydrogen atom or a methyl group, m represents a number of 1 or 2, and "*" indicates a direct bond.)

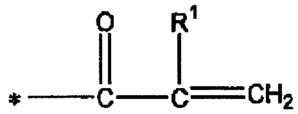

(3)

(In the formula, $R^1$ represents a hydrogen atom or a methyl group and "*" indicates a direct bond.)

The above-described polyfunctional monomer having a caprolactam-denatured structure is commercially available under the name of, for example, KAYARAD DPCA series manufactured by Nippon Kayaku Co., Ltd. and examples thereof include DPCA-20 (compound in which m=1 in Formulae (1) to (3), the number of the groups represented by Formula (2)=2, and all the $R^1$s are hydrogen atoms), DPCA-30 (compound in which m=1 in the same formulae, the number of the groups represented by Formula (2)=3, and all the $R^1$s are hydrogen atoms), DPCA-60 (compound in which m=1 in the same formulae, the number of the groups represented by Formula (2)=6, and all the $R^1$s are hydrogen atoms), DPCA-120 (compound in which m=2 in the same formulae, the number of the groups represented by Formula (2)=6, and all the $R^1$s are hydrogen atoms), and the like.

In the present invention, the polyfunctional monomer having a caprolactam-denatured structure can be used singly or a mixture of two or more monomers can be used.

In addition, the polymerizing monomer and the like in the present invention are preferably at least one selected from the group of compounds represented by General Formula (i) or (ii).

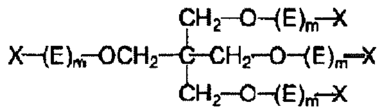

(i)

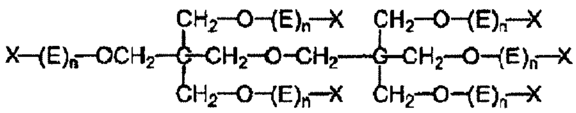

(ii)

In General Formulae (i) and (ii), each of the Es independently represents $-((CH_2)_yCH_2O)-$ or $((CH_2)_yCH(CH_3)O)-$, each of the ys independently represents an integer from 0 to 10, and each of the Xs independently represents an acryloyl group, a methacryloyl group, a hydrogen atom, or a carboxyl group.

In General Formula (i), the total number of the acryloyl groups and the methacryloyl groups is 3 or 4, each of the ms independently represents an integer from 0 to 10, and the total number of the respective ms is an integer from 0 to 40. In a case in which the total number of the respective ms is 0, any one of the Xs is a carboxyl group.

In General Formula (ii), the total number of the acryloyl groups and the methacryloyl groups is 5 or 6, each of the ns independently represents an integer from 0 to 10, and the total number of the respective ns is an integer from 0 to 60. In a case in which the total number of the respective ns is 0, any one of the Xs is a carboxyl group.

In General Formula (i), m is preferably an integer from 0 to 6 and more preferably an integer from 0 to 4. In addition, the total number of the respective ms is preferably an integer from 2 to 40, more preferably an integer from 2 to 16, and particularly preferably an integer from 4 to 8.

In General Formula (ii), n is preferably an integer from 0 to 6 and more preferably an integer from 0 to 4. In addition, the total number of the respective ns is preferably an integer from 3 to 60, more preferably an integer from 3 to 24, and particularly preferably an integer from 6 to 12.

In addition, in $-((CH_2)_yCH_2O)-$ or $-((CH_2)_yCH(CH_3)O)-$ in General Formulae (i) and (ii), the terminal on the oxygen atom side is preferably bonded to X.

The compound represented by General Formula (i) or (ii) may be used singly or two or more compounds may be jointly used. Particularly, in General Formula (ii), all of the six Xs are preferably acryloyl groups.

The compound represented by General Formula (i) or (ii) can be synthesized through a step of bonding a ring-opened skeleton using a ring-opening addition reaction between pentaerythritol or dipentaerythritol and ethylene oxide or propylene oxide and a step of introducing a (meth)acryloyl group using a reaction between a terminal hydroxyl group in the ring-opened skeleton and, for example, (meth)acryloyl chloride. The respective steps are well-known steps and a person skilled in the art can easily synthesize the compound represented by General Formula (i) or (ii).

Among the compounds represented by General Formula (i) or (ii), pentaerythritol derivatives and/or dipentaerythritol derivatives are more preferred.

Specific examples thereof include compounds represented by Formulae (a) to (f) described below (hereinafter, referred to as "Exemplary Compounds (a) to (f)") and, among these, Exemplary Compounds (a), (b), (e), and (f) are preferred.

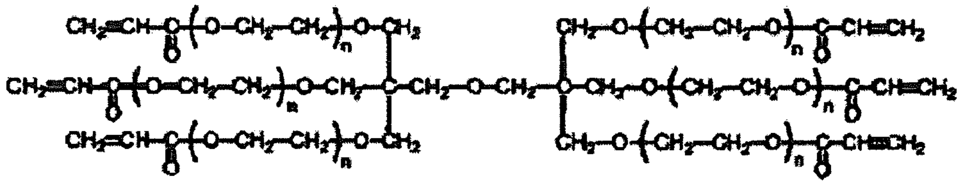

(a)

(the total of individual nS is 6)

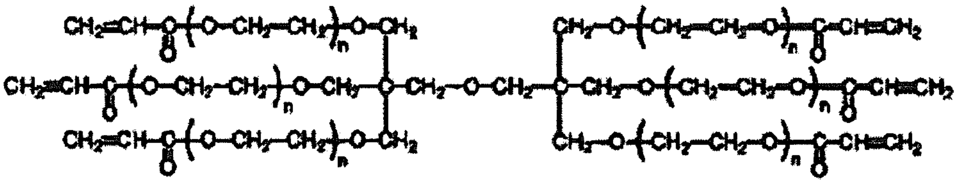

(b)

(the total of individual nS is 12)

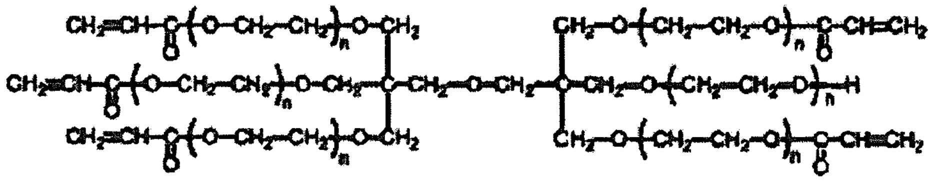

(c)

(the total of individual nS is 12)

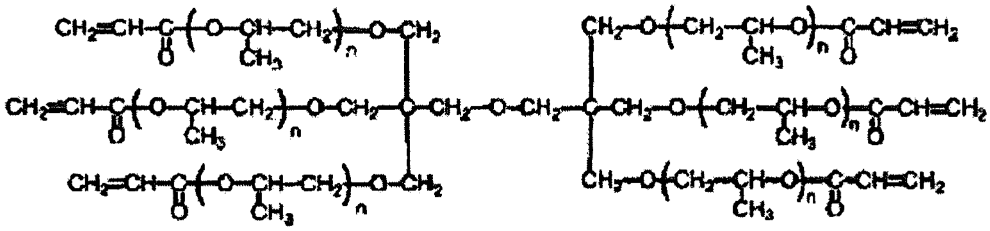

(d)

(the total of individual nS is 6)

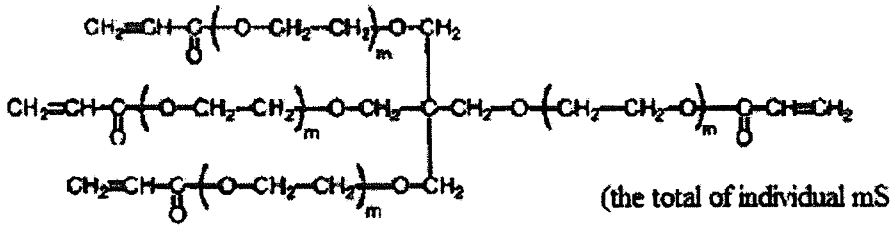

(e)

(the total of individual mS is 4)

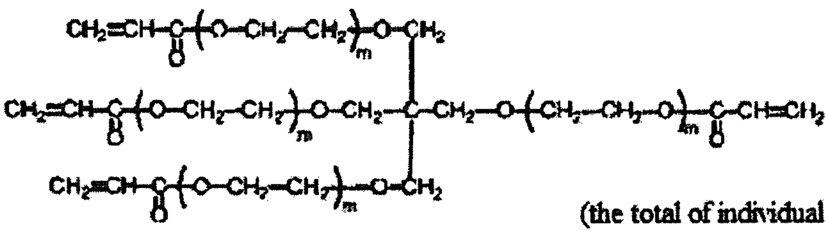

(f)

(the total of individual mS is 12)

Examples of the commercially available products of the polymerizing monomer and the like represented by General Formula (i) or (ii) include SR-494 manufactured by Sartomer Company, Inc. which is a tetrafunctional acrylate

having four ethyleneoxy chains, DPCA-60 which is a hexafunctional acrylate having six pentyleneoxy chains, and TPA-330 which is a trifunctional acrylate having three isobutyleneoxy chains both of which are manufactured by Nippon Kayaku Co., Ltd.

In addition, the polymerizing monomer and the like are also preferably urethane acrylates described in JP1973-41708B (JP-S48-41708B), JP1976-37193A (JP-S51-37193A), JP1990-32293B (JP-H2-32293B), and JP1990-16765B (JP-H2-16765B) and urethane compounds having an ethylene oxide-based skeleton described in JP1983-49860B (JP-S58-49860B), JP1981-17654B (JP-S56-17654B), JP1987-39417B (JP-S62-39417B), and JP1987-39418B (JP-S62-39418B). Furthermore, as the polymerizing monomer and the like, it is possible to obtain curable compositions having an extremely excellent photosensitive speed using an addition-polymerizing monomer having an amino structure or a sulfide structure in the molecule described in JP1988-277653A (JP-S63-277653A), JP1988-260909A (JP-S63-260909A), and JP1989-105238A(JP-H1-105238A).

Examples of the commercially available products of the polymerizing monomer and the like include urethane oligomers UAS-10, UAB-140 (manufactured by Sanyo-Kokusaku Pulp Co., Ltd.), UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600 (manufactured by Kyoeisha Chemical Co., Ltd.), and the like.

The polymerizing monomer and the like are preferably polyfunctional thiol compounds having two or more mercapto (SH) groups in the same molecule. Particularly, polyfunctional thiol compounds represented by General Formula (I) described below are preferred.

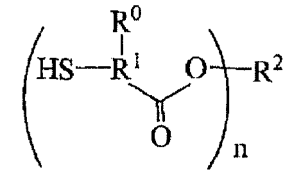

(I)

(In the formula, $R^1$ represents an alkyl group, $R^2$ represents an n-valent aliphatic group which may have an atom other than carbon, $R^0$ represents an alkyl group which is not hydrogen (H), and n represents 2 to 4.)

Examples of the polyfunctional thiol compounds represented by General Formula (I) include 1,4-bis(3-mercapto butyloxy)buthane having the following structural formula [Formula (II)], 1,3,5-tris(3-mercapto butyloxyethyl)-1,3,5-triazine-2,4,6(1H, 3H, 5H)-trione [Formula (III)], pentaerythritol tetrakis(3-mercaptobutylate) [Formula (IV)], and the like. The above-described polyfunctional thiols can be used singly or a combination of multiple polyfunctional thiols can be used.

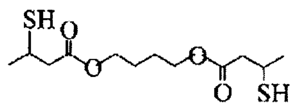

(II)

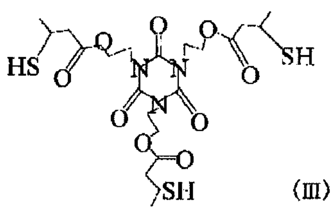

(III)

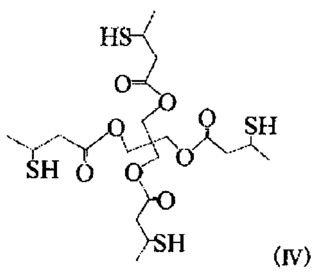

(IV)

In the present invention, as the polymerizing monomer and the like, a polymerizing monomer or oligomer having two or more epoxy groups or oxetanyl groups in the molecule is preferably used. Specific examples thereof are summarized in the section of compounds having an epoxy group or oxetanyl group described below.

<<B: Polymer having polymerizable group at side chain>>

A second preferred aspect of the composition of the present invention includes a polymer having a polymerizable group at the side chain as the polymerizing compound.

Examples of the polymerizable group include an ethylenic unsaturated double bond group and an epoxy groups or an oxetanyl groups.

The polymer having the latter group will be collectively described in the section of a compound having an epoxy group or an oxetanyl group described below.

The polymer having an ethylenic unsaturated bond at the side chain is preferably a macromolecular compound having at least one selected from functional groups represented by any one of General Formulae (1) to (3) described below as the unsaturated double bond portion.

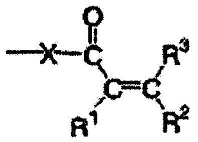 General Formula (1)

In General Formula (1), each of $R^1$ to $R^3$ independently represents a hydrogen atom or a monovalent organic group. Preferred examples of $R^1$ include a hydrogen atom, an alkyl group, and the like and, among these, a hydrogen atom and a methyl group are preferred due to their high radical reactivity. In addition, each of $R^2$ and $R^3$ independently represents a hydrogen atom, a halogen atom, an amino group, a carboxylic group, an alkoxycarbonyl group, a sulfo group, a nitro group, a cyano group, an alkyl group, an aryl group, an alkoxy group, an aryloxy group, an akylamino group, an arylamino group, an alkylsulfonyl group, an arylsulfonyl group, and the like and, among these, a hydrogen atom, a carboxylic group, an alkoxycarbonyl group, an alkyl group, and an aryl group are preferred due to their high radical reactivity.

X represents an oxygen atom, a sulfur atom, or $-N(R^{12})-$ and $R^{12}$ represents a hydrogen atom or a monovalent organic group. Examples of $R^{12}$ include an alkyl group and the like and, among these, a hydrogen atom, a methyl group, an ethyl group, and an isopropyl group are preferred due to their high radical reactivity.

Here, examples of an introducible substituent include an alkyl group, an alkenyl group, an alkynyl group, an aryl group, an alkoxy group, an aryloxy group, a halogen atom, an amino group, an alkylamino group, an arylamino group, a carboxyl group, an alkoxy carbonyl group, a sulfo group, a nitro group, a cyano group, an amide group, an alkyl sulfonyl group, an aryl sulfonyl group, and the like.

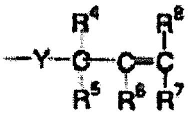 General Formula (2)

In General Formula (2), each of $R^4$ to $R^8$ independently represents a hydrogen atom or a monovalent organic group. Each of $R^4$ to $R^8$ is preferably a hydrogen atom, a halogen atom, an amino group, a dialkylamino group, a carboxyl group, an alkoxy carbonyl group, a sulfo group, a nitro group, a cyano group, an alkyl group, an aryl group, an alkoxy group, an aryloxy group, an alkylamino group, an arylamino group, an alkyl sulfonyl group, an aryl sulfonyl group, and the like and, among these, a hydrogen atom, a carboxyl group, an alkoxy carbonyl group, an alkyl group, and an aryl group are more preferred.

Examples of an introducible substituent include the same substituents as General Formula (1). In addition, Y represents an oxygen atom, a sulfur atom, or $-N(R^{12})-$. $R^{12}$ is identical to $R^{12}$ in General Formula (1) and the preferred range is also identical.

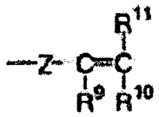 General Formula (3)

In General Formula (3), preferred examples of $R^9$ include a hydrogen atom, an alkyl group which may have a substituent, and the like and, among these, a hydrogen atom and a methyl group are preferred due to their high radical reactivity. Examples of each of $R^{10}$ and $R^{11}$ independently include a hydrogen atom, a halogen atom, an amino group, a dialkylamino group, a carboxyl group, an alkoxy carbonyl group, a sulfo group, a nitro group, a cyano group, an alkyl group, an aryl group, an alkoxy group, an aryloxy group, an alkylamino group, an arylamino group, an alkyl sulfonyl group, an aryl sulfonyl group, and the like and, among these, a hydrogen atom, a carboxyl group, an alkoxy carbonyl group, an alkyl group, and an aryl group are preferred due to their high radical reactivity.

Here, examples of an introducible substituent include the same substituents as General Formula (1). In addition, Z represents an oxygen atom, a sulfur atom, $-N(R^{13})-$, or a phenylene group. Examples of $R^{13}$ include an alkyl group and the like and, among these, a methyl group, an ethyl group, and an isopropyl group are preferred due to their high radical reactivity.

The polymer having an ethylenic unsaturated bond at the side chain in the present invention is preferably a compound having a configuration unit that includes a functional group represented by General Formulae (1) to (3) in a molecule in a range of 20 mol% to less than 95 mol%. The content of the configuration unit is more preferably in a range of 25 mol% to 90 mol% and still more preferably in a range of 30 mol% to less than 85 mol%.

A macromolecular compound having the configuration unit that includes the group represented by General Formulae (1) to (3) can be synthesized on the basis of the synthesis method described in Paragraphs [0027] to [0057] in JP2003-262958A. Among these, the macromolecular compound is preferably synthesized using the synthesis method 1) in the same publication.

The polymer having an ethylenic unsaturated bond used in the present invention may further include an acid group.

In the present specification, the acid group refers to an acid group having a dissociable group with a pKa of 14 or less, examples thereof include $-COOH$, $-SO_3H$, $-PO_3H_2$, $-OSO_3H$, $-OPO_2H_2$, $-PhOH$, $-SO_2H$, $-SO_2NH_2$, $-SO_2NHCO-$, $-SO_2NHSO_2-$, and the like, and among these, $-COOH$, $-SO_3H$, and $-PO_3H_2$ are preferred, and COOH is more preferred.

A polymer having the acid group and an ethylenic unsaturated bond at the side chain can be obtained by, for example, adding an ethylenic unsaturated group-containing epoxy compound to a carboxyl group in an alkali-soluble polymer having a carboxyl group.

Examples of the polymer having a carboxyl group include 1) polymers obtained by radical-polymerizing or ion-polymerizing monomers having a carboxyl group, 2) polymers obtained by radical-polymerizing or ion-polymerizing monomers having an acid anhydride and hydrolyzing or half-esterifying an acid anhydride unit, 3) epoxy acrylates obtained by denaturing an epoxy polymer using an unsaturated monocarboxylic acid and an acid anhydride, and the like.

Specific examples of a vinyl-based polymer having a carboxyl group include polymers obtained by singly polymerizing unsaturated carboxylic acids such as (meth)acrylic acid, 2-succinoyloxyethyl methacrylate, 2-maleinoyloxyethyl methacrylate, 2-phthaloyloxyethyl methacrylate, 2-hexahydrophthaloyloxyethyl methacrylate, maleic acid, fumaric acid, itaconic acid, or crotonic acid, which is a monomer having a carboxyl group, and polymers obtained by copolymerizing the above-described unsaturated carboxyl acid with a vinyl monomer having no carboxyl group such as styrene, $\alpha$-methylstyrene, methyl (meth)acrylate, ethyl (meth)acrylate, propyl (meth)acrylate, isopropyl (meth)acrylate, butyl (meth)acrylate, vinyl acetate, acrylonitrile, (meth)acrylamide, glycidyl (meth)acrylate, allyl glycidyl ether, ethyl glycidyl acrylate, glycidyl crotonate ester, (meth)acrylic acid chloride, benzyl (meth)acrylate, hydroxyethyl (meth)acrylate, N-methylol acrylamide, N,N-dimethylacrylamide, N-methacryloylmopholine, N,N-dimethylaminoethyl (meth)acrylate, or N,N-dimethylaminoethylacrylamide.

In addition, examples thereof also include polymers obtained by copolymerizing anhydrous maleic acid and styrene, $\alpha$-methyl styrene, or the like and half esterifying the anhydrous maleic acid unit portion with a monovalent alcohol such as methanol, ethanol, propanol, butanol, or hydroxyethyl (meth)acrylate or hydrolyzing the anhydrous maleic acid unit portion with water.

Among these, polymers having a carboxyl group, particularly, (meth)acrylic acid-(co)polymerized polymers including (meth)acrylate are preferred. Examples of the copolymers include methyl methacrylate/methacrylic acid copolymers described in JP1985-208748A (JP-S60-208748A), methyl methacrylate/methyl acrylate/methacrylic acid copolymers described in JP1985-214354A (JP-S60-214354A), benzyl methacrylate/methyl methacrylate/methacrylic acid/2-ethylhexyl acrylate copolymers described in JP1993-36581A (JP-H5-36581A), methyl methacrylate/ n-butyl methacrylate/2-ethylhexyl acrylate/methacrylic acid copolymers described in JP1993-333542A (JP-H5-333542A), styrene/methyl methacrylate/methyl acrylate/methacrylic acid copolymers described in JP1995-261407A (JP-H7-261407A), methyl methacrylate/n-butyl methacrylate/2-ethylhexyl acrylate/methacrylic acid copolymers described in JP1998-110008A (JP-H10-110008A), methyl methacrylate/n-butyl acrylate/2-ethylhexyl acrylate/styrene/methacrylic acid copolymers described in JP1998-198031A (JP-H10-198031A), and the like.

A polymer including the acid group and the polymerizable group at the side chain in the present invention is preferably a macromolecular compound having at least one selected from configuration units represented by any one of General Formulae (1-1) to (3-1) described below as the unsaturated double bond portion.

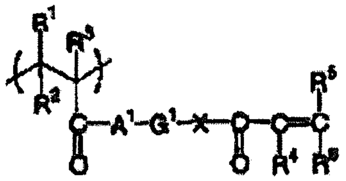

General Formula (1-1)

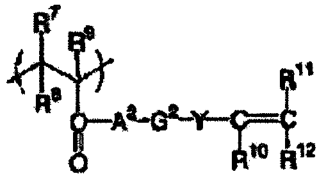

General Formula (2-1)

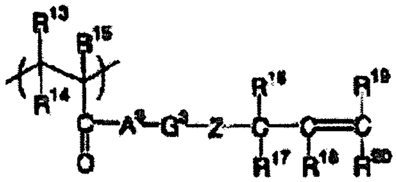

General Formula (3-1)

In General Formulae (1-1) to (3-1), each of $A^1$, $A^2$, and $A^3$ independently represents an oxygen atom, a sulfur atom, or $-N(R^{21})-$ and $R^{21}$ represents an alkyl group. Each of $G^1$, $G^2$, and $G^3$ independently represents a divalent organic group. Each of X and Z independently represents an oxygen atom, a sulfur atom, or $-N(R^{22})-$ and $R^{22}$ represents an alkyl group. Y represents an oxygen atom, a sulfur atom, a phenylene group, or $-N(R^{23})-$ and $R^{23}$ represents an alkyl group. Each of $R^1$ to $R^{20}$ independently represents a monovalent substituent.

In General Formula (1-1), each of $R^1$ to $R^3$ independently represents a monovalent substituent. Examples of $R^1$ to $R^3$ include alkyl groups and the like which may further have a hydrogen atom and a substituent and, among these, $R^1$ and $R^2$ are preferably hydrogen atoms and $R^3$ is preferably a hydrogen atom or a methyl group.

Each of $R^4$ to $R^6$ independently represents a monovalent substituent. Examples of $R^4$ include alkyl groups and the like which may further have a hydrogen atom and a substituent and, among these, a hydrogen atom, a methyl group, and an ethyl group are preferred. Examples of each of $R^5$ and $R^6$ independently include a hydrogen atom, a halogen atom, an alkoxy carbonyl group, a sulfo group, a nitro group, a cyano group, an alkyl group which may further have a substituent, an aryl group which may further have a substituent, an alkoxy group which may further have a substituent, an aryloxy group which may further have a substituent, an alkyl sulfonyl group which may further have a substituent, an aryl sulfonyl group which may further have a substituent, and the like and, among these, a hydrogen atom, an alkoxy carbonyl group, an alkyl group which may further have a substituent, and an aryl group which may further have a substituent are preferred.

Here, examples of an introducible substituent include a methoxy carbonyl group, an ethoxy carbonyl group, an isopropioxy carbonyl group, a methyl group, an ethyl group, a phenyl group, and the like.

$A^1$ represents an oxygen atom, a sulfur atom, or $-N(R^{21})-$ and X represents an oxygen atom, a sulfur atom, or $-N(R^{22})-$. Here, examples of $R^{21}$ and $R^{22}$ include an alkyl group.

$G^1$ represents a divalent organic group and is preferably an alkylene group. More preferred examples of $G^1$ include an alkylene group having 1 to 20 carbon atoms, a cycloalkylene group having 3 to 20 carbon atoms, an aromatic group having 6 to 20 carbon atoms, and the like and, among these, a linear or branched alkylene group having 1 to 10 carbon atoms, a cycloalkylene group having 3 to 10 carbon atoms, and an aromatic group having 6 to 12 carbon atoms are still more preferred in terms of performance such as strength and developing properties.

Here, the substituent in $G^1$ is preferably a hydroxyl group.

In General Formula (2-1), each of $R^7$ to $R^9$ independently represents a monovalent substituent. Examples of $R^7$ to $R^9$ include alkyl groups and the like which may further have a hydrogen atom and a substituent and, among these, $R^7$ and $R^8$ are preferably hydrogen atoms and $R^9$ is preferably a hydrogen atom or a methyl group.

Each of $R^{10}$ to $R^{12}$ independently represents a monovalent substituent. Examples of $R^{10}$ to $R^{12}$ include a hydrogen atom, a halogen atom, a dialkyl amino group, an alkoxy carbonyl group, a sulfo group, a nitro group, a cyano group, an alkyl group which may further have a substituent, an aryl group which may further have a substituent, an alkoxy group which may further have a substituent, an aryloxy group which may further have a substituent, an alkyl sulfonyl group which may further have a substituent, an aryl sulfonyl group which may further have a substituent, and the like and, among these, a hydrogen atom, an alkoxy carbonyl group, an alkyl group which may further have a substituent, and an aryl group which may further have a substituent are preferred.

Here, examples of an introducible substituent include the same substituents as represented by General Formula (1-1).

Each of $A^2$s represents an oxygen atom, a sulfur atom, or -N($R^{21}$)- and examples of $R^{21}$ include a hydrogen atom, an alkyl group, and the like.

$G^2$ represents a divalent organic group and is preferably an alkylene group. More preferred examples of $G^2$ include an alkylene group having 1 to 20 carbon atoms, a cycloalkylene group having 3 to 20 carbon atoms, an aromatic group having 6 o 20 carbon atoms, and the like and, among these, a linear or branched alkylene group having 1 to 10 carbon atoms, a cycloalkylene group having 3 to 10 carbon atoms, and an aromatic group having 6 to 12 carbon atoms are still more preferred in terms of performance such as strength and developing properties. The substituent in $G^2$ is preferably a hydroxyl group.

Y represents an oxygen atom, a sulfur atom, -N($R^{23}$)-, or a phenylene group, and examples of $R^{23}$ include a hydrogen atom, an alkyl group, and the like.

In General Formula (3-1), each of $R^{13}$ to $R^{15}$ independently represents a monovalent substituent. Examples of $R^{13}$ to $R^{15}$ include a hydrogen atom, an alkyl group, and the like and, among these, $R^{13}$ and $R^{14}$ are preferably hydrogen atoms and $R^{15}$ is preferably a hydrogen atom or a methyl group.

Each of $R^{16}$ to $R^{20}$ independently represents a monovalent substituent. Examples of $R^{16}$ to $R^{20}$ include a hydrogen atom, a halogen atom, a dialkyl amino group, an alkoxy carbonyl group, a sulfo group, a nitro group, a cyano group, an alkyl group which may further have a substituent, an aryl group which may further have a substituent, an alkoxy group which may further have a substituent, an aryloxy group which may further have a substituent, an alkyl sulfonyl group which may further have a substituent, an aryl sulfonyl group which may further have a substituent, and the like and, among these, a hydrogen atom, an alkoxy carbonyl group, an alkyl group which may further have a substituent, and an aryl group which may further have a substituent are preferred. Examples of an introducible substituent include the same substituents as represented by General Formula (1).

$A^3$ represents an oxygen atom, a sulfur atom, or -N($R^{21}$)- and Z represents an oxygen atom, a sulfur atom, or -N($R^{22}$)-. Examples of $R^{21}$ and $R^{22}$ include the same alkyl groups as represented by General Formula (1).

$G^3$ represents a divalent organic group and is preferably an alkylene group. More preferred examples of $G^3$ include an alkylene group having 1 to 20 carbon atoms, a cycloalkylene group having 3 to 20 carbon atoms, an aromatic group having 6 to 20 carbon atoms, and the like and, among these, a linear or branched alkylene group having 1 to 10 carbon atoms, a cycloalkylene group having 3 to 10 carbon atoms, and an aromatic group having 6 to 12 carbon atoms are still more preferred in terms of performance such as strength and developing properties. The substituent in $G^3$ is preferably a hydroxyl group.

Regarding preferred examples of the configuration example having an ethylenic unsaturated bond and the acid group, the description of Paragraphs [0060] to [0063] and the like in JP2009-265518A can be referenced.

The acid value of the polymer having the acid group and an ethylenic unsaturated bond at the side chain is in a range of 20 mg-KOH/g to 300 mg-KOH/g, preferably in a range of 40 mg-KOH/g to 200 mg-KOH/g, and more preferably in a range of 60 mg-KOH/g to 150 mg-KOH/g.

The polymer having a polymerizable group at the side chain used in the present invention is also preferably a polymer having an ethylenic unsaturated bond and a urethane group at the side chain (hereinafter, in some cases, referred to as the "urethane polymer").

The urethane polymer is a urethane polymer having a structural unit represented by a reaction product between at least one of the diisocyanate compounds represented by General Formula (4) described below and at least one of the diol compounds represented by General Formula (5) as a basic skeleton (hereinafter, in some cases, appropriately referred to as the "specific polyurethane polymer").

OCN-$X^0$-NCO General Formula (4)

HO-$Y^0$-OH General Formula (5)

In General Formulae (4) and (5), each of $X^0$ and $Y^0$ independently represents a divalent organic residue.

When at least any one of the diisocyanate compound represented by General Formula (4) and the diol compound represented by General Formula (5) has at least one of the groups represented by General Formulae (1) to (3) which illustrate the above-described unsaturated double bond portions, the specific polyurethane polymer in which the group represented by one of General Formulae (1) to (3) is introduced into the side chain is generated as a reaction product between the diisocyanate compound and the diol compound. According to the above-described method, it is also possible to easily produce the specific polyurethane polymer according to the present invention by substituting and introducing a desired side chain after the reaction and generation of the polyurethane polymer.

1) Diisocyanate compound

Examples of the diisocyanate compound represented by General Formula (4) include products obtained through an addition reaction between a triisocyanate compound and 1 equivalent weight of a monofunctional alcohol or a monofunctional amine compound which has an unsaturated group.

Regarding the triisocyanate compound, for example, the compounds described in Paragraphs [0099] to [0105] and the like in JP2009-265518A can be referenced.

Here, a method for introducing the unsaturated group into the side chain of the polyurethane polymer is preferably a method in which a diisocyanate compound having an unsaturated group at the side chain is used as a raw material for producing the polyurethane polymer. Regarding the diisocyanate compound which can be obtained by an addition reaction between a triisocyanate compound and 1 equivalent weight of a monofunctional alcohol or monofunctional amine compound having an unsaturated group and has an unsaturated group at the side chain, for example, the compounds described in Paragraphs [0107] to [0114] in JP2009-265518A can be referenced.

As the specific polyurethane polymer used in the present invention, it is possible to copolymerize diisocyanate compounds other than the above-described diisocyanate compound having an unsaturated group from the viewpoint of, for example, improving compatibility with other components in the polymerizing composition and improving preservation stability.

Examples of the diisocyanate compounds being copolymerized include the following compounds. A preferred compound is a diisocyanate compound represented by General Formula (6) described below.

$OCN\text{-}L^1\text{-}NCO$ General Formula (6)

In Formula (6), $L^1$ represents a divalent aliphatic or aromatic hydrocarbon group. If necessary, $L^1$ may include other functional groups that do not react with an isocyanate group, for example, an ester, urethane, an amide, or an ureido group.

Specific examples of the diisocyanate compound represented by General Formula (6) include compounds described below:

aromatic diisocyanate compounds such as 2,4-tolylenediisocyante, dimers of 2,4-tolylenediisocyante, 2,6-tolylenediisocyanate, p-xylenediisocyanate, m-xylenediisocyanate, 4,4'-diphenylmethanediisocyanate, 1,5-naphthylenediisocyanate, and 3,3-dimethylbiphenyl-4,4'-diisocyante;
aliphatic diisocyante compounds such as hexamethylene diisocyanate, trimethyl hexamethylenediisocyanate, lysine diisocyanate, and dimer acid diisocyanate; alicyclic diisocyanate compounds such as isophorone diisocyanate, 4,4'-methylene bis(cyclohexylisocyanate), methylcyclohexane-2,4(or 2,6) diisocyanate, and 1,3-(isocyanate methyl)cyclohexane; diisocyanate compounds which are reactants between a diol and diisocyante such as an adduct of 1 mol of 1,3-butylene glycol and 2 mol of tolylene diisocyanate; and the like.

2) Diol compound

Examples of the diol compound represented by General Formula (5) broadly include polyether diol compounds, polyester diol compounds, polycarbonate diol compounds, and the like.

Here, a method for introducing the unsaturated group into the side chain of the polyurethane polymer is also preferably, in addition to the above-described method, a method in which a diol compound having an unsaturated group at the side chain is used as a raw material for producing the polyurethane polymer. The above-described diol compound may be, for example, a commercially available diol compound such as trimethylol propane monoallyl ether or may be a compound that is easily produced by reacting a halogenated diol compound, a triol compound, or an amino diol compound and carboxylic acid having an unsaturated group, an acid chloride, isocyanate, an alcohol, an amine, a thiol, or a halogenated alkyl compound. Regarding specific examples of the above-described compound, the compounds described in Paragraphs [0122] to [0125] and the like in JP2009-265518A can be referenced.

In addition, examples of a more preferred polymer in the present invention include polyurethane resins obtained using a diol compound represented by General Formula (G) as at least one of the diol compounds having an ethylenic unsaturated bond group when the polyurethane is synthesized.

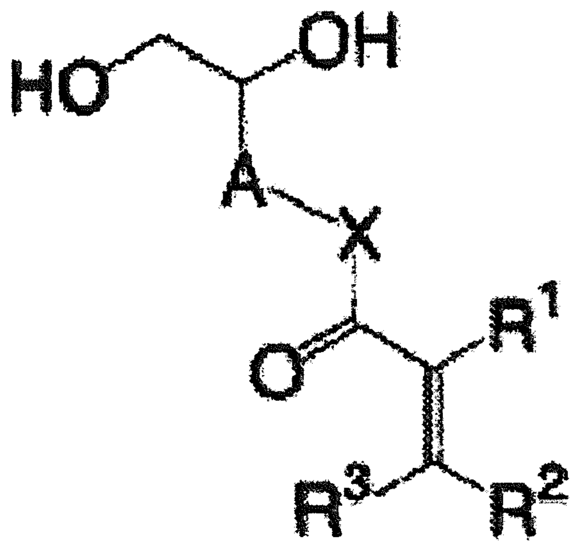

General Formula (G)

In General Formula (G), each of $R^1$ to $R^3$ independently represents a hydrogen atom or a monovalent organic group, A represents a divalent organic residue, X represents an oxygen atom, a sulfur atom, or $-N(R^{12})-$, and $R^{12}$ represents a hydrogen atom or a monovalent organic group.

Meanwhile, $R^1$ to $R^3$ and X in General Formula (G) are identical to $R^1$ to $R^3$ and X in General Formula (1) and the preferred range is also identical.

When the polyurethane polymer derived from the above-described diol compound is used, the excessive molecular movement of the polymer main chain caused by a secondary alcohol having a great steric hindrance is suppressed. Therefore, it is considered that the above-described polyurethane polymer is capable of improving the film strength of layers.

Regarding specific examples of the diol compound represented by General Formula (G) which is preferably used for the synthesis of the specific polyurethane polymer, the compounds described in Paragraphs [0129] to [0131] and the like in JP2009-265518A can be referenced.

As the specific polyurethane polymer used in the present invention, it is possible to copolymerize diol compounds other than the above-described diol compound having an unsaturated group from the viewpoint of, for example, improving compatibility with other components in the polymerizing composition and improving preservation stability.

Examples of the above-described diol compounds include polyether diol compounds, polyester diol compounds, and polycarbonate diol compounds described above.

Examples of the polyether diol compounds include compounds represented by Formulae (7), (8), (9), (10), and (11) and random copolymers of an ethylene oxide having a hydroxyl group at the terminal and propylene oxide.

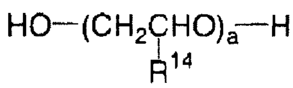

(7)

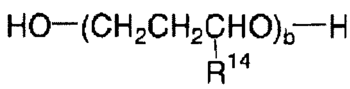

(8)

$HO-(CH_2CH_2CH_2CH_2O)_c-H$ (9)

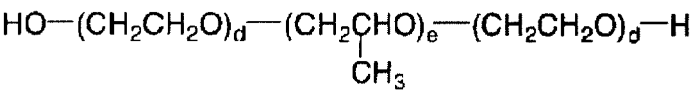

(10)

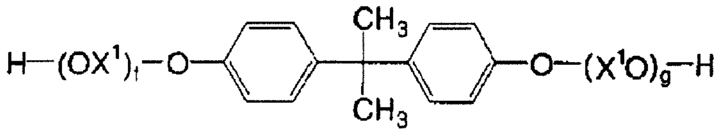

(1 1)

In Formulae (7) to (11), $R^{14}$ represents a hydrogen atom or a methyl group and $X^1$ represents the following group. In addition, each of a, b, c, d, e, f, and g represents an integer of 2 or more and each is preferably an integer from 2 to 100.

$-CH_2CH_2-$

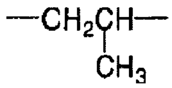

Regarding the polyether diol compounsd represented by General Formulae (7) to (11), specifically, the compounds described in Paragraphs [0137] to [0140] and the like in JP2009-265518A can be referenced.

Specific examples of the random copolymers of an ethylene oxide having a hydroxyl group at the terminal and propylene oxide include the following copolymers.

The examples are NEWPOL (trade name) 50HB-100, NEWPOL 50HB-260, NEWPOL 50HB-400, NEWPOL 50HB-660, NEWPOL 50HB-2000, NEWPOL 50B-5100, and the like, which are manufactured by Sanyo Chemical Industries, Ltd..

Examples of the polyester diol compounds include compounds represented by Formulae (12) and (13).

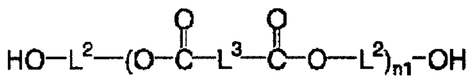

(1 2)

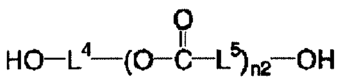

(1 3)

In Formulae (12) and (13), $L^2$, $L^3$, and $L^4$ may be identical to or different from each other and represent divalent aliphatic or aromatic hydrocarbon groups, and $L^5$ represents a divalent aliphatic hydrocarbon group. Preferably, each of $L^2$ to $L^4$ represents an alkylene group, an alkenyl group, an alkylene group, or an arylene group and $L^5$ represents an alkylene group. In addition, in $L^2$ to $L^5$, other functional groups that do not react with the isocyanate group, for example, ethers, carbonyl, esters, cyano, olefins, urethane, amides, ureido groups or halogen atoms may be present. Each of n1 and n2 is an integer of 2 or more and each is preferably an integer from 2 to 100.

The polycarbonate diol compound is a compound represented by Formula (14).

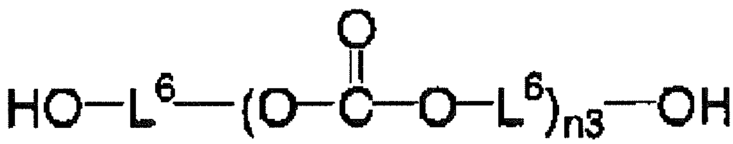

(1 4)

In Formula (14), $L^6$s may be identical to or different from each other and represent divalent aliphatic or aromatic hydrocarbon groups. Preferably, each of the $L^6$s represents an alkylene group, an alkenyl group, an alkylene group, or an arylene group. In addition, in $L^6$, other functional groups that do not react with the isocyanate group, for example, ethers, carbonyl, esters, cyano, olefins, urethane, amides, ureido groups or halogen atoms may be present. n3 is an integer of 2 or more and is preferably an integer from 2 to 100.

Regarding specific diol compounds represented by General Formula (12), (13), or (14), the compounds described in Paragraphs [0148] to [0150] and the like in JP2009-265518A can be referenced.

In addition, for the synthesis of the specific polyurethane polymer, it is also possible to jointly use a diol compound having a substituent that does not react with the isocyanate group in addition to the above-described diol compound. Examples of the above-described diol compound include compounds described below.

$$HO\text{-}L^7\text{-}O\text{-}CO\text{-}L^8\text{-}CO\text{-}O\text{-}L^7\text{-}OH \qquad (15)$$

$$HO\text{-}L^8\text{-}CO\text{-}O\text{-}L^7\text{-}OH \qquad (16)$$

In Formulae (15) and (16), $L^7$ and $L^8$ may be identical to or different from each other and represent divalent aliphatic hydrocarbon groups, aromatic hydrocarbon groups, or heterocyclic groups which may have a substituent (for example, an alkyl group, an aralkyl group, an aryl group, an alkoxy group, an aryloxy group, or individual groups of halogen atoms such as -F, -Cl, -Br, and -I). If necessary, in $L^7$ and $L^8$, other functional groups that do not react with the isocyanate group, for example, a carbonyl group, an ester group, an urethane group, an amide group, and an ureido group may be present. Meanwhile, $L^7$ and $L^8$ may form a ring.

Furthermore, for the synthesis of the specific polyurethane polymer, it is also possible to jointly use a diol compound having a carboxyl group in addition to the diol compound.

Examples of the above-described diol compound include compounds represented by Formulae (17) to (19) described below.

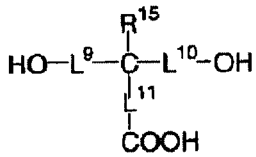

(1 7)

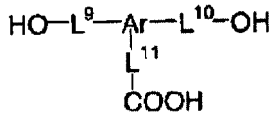

(1 8)

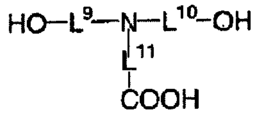

(1 9)

In Formulae (17) to (19), $R^{15}$ represents an alkyl group, an aralkyl group, an aryl group, an alkoxy group, or an aryloxy group which may have a substituent (for example, a cyano group, a nitro group, or individual groups of halogen atoms such as -F, -Cl, -Br, and -I, $-CONH_2$, $-COOR^{16}$, $-OR^{16}$, $-NHCONHR^{16}$, $-NHCOOR^{16}$, $-NHCOR^{16}$, $-OCONHR^{16}$ (here, $R^{16}$ represents an alkyl group having 1 to 10 carbon atoms or an aralkyl group having 7 to 15 carbon atoms)) and preferably represents a hydrogen atom, an alkyl group having 1 to 8 carbon atoms, or an aryl group having 6 to 15 carbon atoms. $L^9$, $L^{10}$, and $L^{11}$ may be identical to or different from each other. $L^9$, $L^{10}$, and $L^{11}$ represent single bonds or divalent aliphatic or aromatic hydrocarbon groups which may have a substituent (for example, individual groups such as alkyl groups, aralkyl groups, aryl groups, alkoxy groups, and halogen groups are preferred), preferably represent alkyl groups having 1 to 20 carbon atoms or arylene group having 6 to 15 carbon atoms, and more preferably represent alkylene groups having 1 to 8 carbon atoms. In addition, if necessary, in $L^9$ to $L^{11}$, other functional groups that do not react with the isocyanate group, for example, carbonyl, esters, urethane, amides, or ether groups may be present. Meanwhile, two or three out of $R^{15}$, $L^7$, $L^8$, and $L^9$ may form a ring.

Ar represents a trivalent aromatic hydrocarbon group and preferably represents an aromatic group having 6 to 15 carbon atoms.

Specific examples of the diol compound having a carboxyl group represented by Formulae (17) to (19) include the following compounds.

The examples are 3,5-dihydroxy benzoate, 2,2-bis(hydroxymethyl) propionate, 2,2-bis(2-hydroxyethyl) propionate, 2,2-bis(3-hydroxypropyl) propionate, bis(hydroxymethyl) acetate, bis(4-hydroxyphenyl) acetate, 2,2-bis(hydroxymethyl) acetate, 4,4-bis(4-hydroxyphenyl) pentanoate, tartaric acid, N,N-dihydroxyethyl glycine, N,N-bis(2-hydroxyethyl)-3-carboxy-propionamide, and the like.

The presence of the above-described carboxyl group is capable of imparting characteristics such as hydrogen-bonding properties and alkali-soluble properties to the polyurethane polymer and is thus preferred. Specifically, the polyurethane polymer having an ethylenic unsaturated bond at the side chain further has a carboxyl group at the side chain. More specifically, the polyurethane polymer having 0.3 meq/g or more of an ethylenic unsaturated bond group at the side chain and having 0.4 meq/g or more of a carboxyl group at the side chain is particularly preferably used as a

binder polymer of the present invention.

In addition, for the synthesis of the specific polyurethane polymer, it is also possible to jointly use a compound in which a tetracarboxylic dianhydride represented by Formulae (20) to (22) described below is ring-opened using a diol compound in addition to the diol compound.

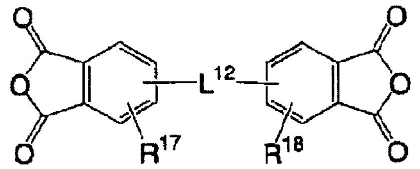

(20)

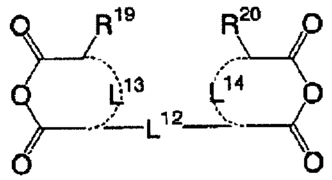

(21)

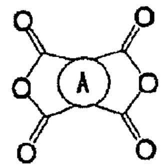

(22)

In Formulae (20) to (22), $L^{12}$ represent a single bonds, a divalent aliphatic or aromatic hydrocarbon group which may have a substituent (for example, alkyl groups, aralkyl groups, aryl groups, alkoxy groups, and individual groups of halogens, esters, and amides are preferred), -CO-, -SO-, $-SO_2-$, -O-, or S- and preferably represent a single bonds, a divalent aliphatic hydrocarbon group having 1 to 15 carbon atoms, -CO-, $-SO_2-$ -O-, or S-. $L^{17}$ and $L^{18}$ may be identical to or different from each other and represent hydrogen atoms, alkyl groups, aralkyl groups, aryl groups, alkoxy groups, or halogen groups and preferably represent hydrogen atoms, alkyl groups having 1 to 8 carbon atoms, aryl groups having 6 to 15 carbon atoms, alkoxy groups having 1 to 8 carbon atoms, or halogen groups. In addition, two out of $L^{12}$, $R^{17}$, and $R^{18}$ may be bonded to each other so as to form a ring.

$R^{19}$ and $R^{20}$ may be identical to or different from each other and represent hydrogen atoms, alkyl groups, aralkyl groups, aryl groups, or halogen groups and preferably represents hydrogen atoms, alkyl groups having 1 to 8 carbon atoms, or aryl groups having 6 to 15 carbon atoms. In addition, two out of $L^{12}$, $R^{19}$, and $R^{20}$ may be bonded to each other so as to form a ring. $L^{13}$ and $L^{14}$ may be identical to or different from each other, represent single bonds, double bonds, or divalent aliphatic hydrocarbon groups, and preferably represent single bonds, double bonds, or methylene groups. A represents a mononuclear or polynuclear aromatic ring and preferably represents an aromatic ring having 6 to 18 carbon atoms.

Regarding compounds represented by General Formula (20), (21), or (22), specifically, the description of Paragraphs [0163] and [0164] and the like in JP2009-265518A can be referenced and the content thereof is incorporated into the specification of the present application by reference.

Regarding a method for introducing a compound in which the above-described tetracarboxylic dianhydride is ring-opened using a diol compound into the polyurethane polymer, examples thereof include the following methods.

a) A method in which a compound at the alcohol terminal obtained by ring-opening tetracarboxylic dianhydride using a diol compound and a diisocyanate compound are reacted together.

b) A method in which a urethane compound at the alcohol terminal obtained by reacting diisocyanate compounds under conditions of an excessive amount of a diol compound and are tetracarboxylic dianhydride reacted together.

Regarding the diol compound used in the ring-opening reaction at this time, specifically, the description of Paragraphs [0166] and the like in JP2009-265518A can be referenced.

The specific polyurethane polymer that can be used in the present invention is synthesized by heating the diisocyanate compound and the diol compound in a non-protonic solvent after the addition of a well-known catalyst having activity in accordance with the reactivity of the components. The molar ratio ($M_a$:$M_b$) between the diisocyanate compound and the diol compound used in the synthesis is preferably in a range of 1:1 to 1.2:1. When the diisocyanate

compound and the diol compound used in the synthesis are treated using an alcohol, an amine, or the like, a product having desired properties such as molecular weight or viscosity is synthesized in a form in which an isocyanate group does not remain in the end.

Regarding the introduced amount of the ethylenic unsaturated bond included in the specific polyurethane polymer according to the present invention, the amount of the ethylenic unsaturated bond group included at the side chain is preferably 0.3 meq/g or more and more preferably in a range of 0.35 meq/g to 1.50 meq/g in terms of equivalent weight.

The molecular weight of the specific polyurethane polymer according to the present invention is preferably 10,000 or more and more preferably in a range of 40,000 to 200,000 in terms of weight-average molecular weight.

In the present invention, a styrene-based polymer having an ethylenic unsaturated bond at the side chain (hereinafter, in some cases, referred to as "styrene-based polymer") is also preferred and a styrene-based polymer having at least one of the styrenic double bonds represented by General Formula (23) (styrene and $\alpha$ methyl styrene-based double bond) and vinylpyridinium groups represented by General Formula (24) is more preferred.

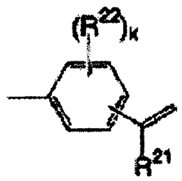

General Formula (23)

In General Formula (23), $R^{21}$ represents a hydrogen atom or a methyl group. $R^{22}$ represents an arbitrary substitutable atom or atomic group. k represents an integer from 0 to 4.

Meanwhile, the styrenic double bond represented by General Formula (23) is linked to the polymer main chain through a single bond or a linking group made of an arbitrary atom or atomic group and there is no particular limitation regarding the manner of bonding.

Regarding preferred examples of the repeating unit of a macromolecular compound having a functional group represented by General Formula (23), the description of Paragraphs [0179] to [0181] and the like in JP2009-265518A can be referenced.

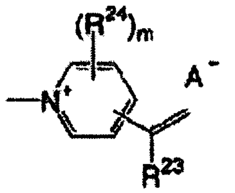

General Formula (24)

In General Formula (24), $R^{23}$ represents a hydrogen atom or a methyl group. $R^{24}$ represents an arbitrary substitutable atom or atomic group. m represents an integer from 0 to 4. $A^-$ represents an anion. In addition, a pyridinium ring may have a benzopyridium form in which a benzene ring is condensed as a substituent and, in this case, the pyridinium ring has a quinolinium group and an isoquinolinium group.

Meanwhile, the vinylpyridinium group represented by General Formula (24) is linked to the polymer main chain through a single bond or a linking group made of an arbitrary atom or atomic group and there is no particular limitation regarding the manner of bonding.

Regarding preferred examples of the repeating unit of a macromolecular compound having a functional group represented by General Formula (24), the description of Paragraphs [0184] and the like in JP2009-265518A can be referenced.

As a method for synthesizing the styrene-based polymer, there is a method in which monomers which have a functional group represented by General Formula (23) or (24) and have a functional group capable of copolymerizing other copolymerization components are copolymerized using a well-known copolymerization method. Here, the styrene-based polymer may be a homopolymer having only one kind of any one of the functional groups represented by General Formulae (23) and (24) or a copolymer having two or more kinds of either or both functional groups.

Furthermore, the styrene-based polymer may also be a copolymer with another copolymerization monomer that does not include the above-described functional group. In this case, for example, a carboxyl group-containing monomer is preferably selected as the copolymerization monomer for the purpose of making the polymer soluble in an alkali aqueous solution and examples thereof include acrylic acid, methacrylic acid, 2-carboxyethyl acrylate ester, 2-carboxyethyl methacrylate ester, crotonic acid, maleic acid, fumaric acid, monoalkyl maleate ester, monoalkyl fumarate

ester, 4-carboxystyrene, and the like.

It is also preferable to synthesize and use a (multicomponent) copolymer by introducing a monomer component other than the monomer having a carboxyl group into the copolymer. Regarding monomers that can be incorporated into the copolymer in this case, the description of Paragraphs [0187] and the like in JP2009-265518A can be referenced.

In a case in which the above-described copolymer is used as the styrene-based polymer, the fraction of the repeating unit having the functional group represented by General Formula (23) and/or General Formula (24) in the total copolymer composition is preferably 20% by mass or more and more preferably 40% by mass or more. In the above-described range, a high-sensitivity crosslinked composition can be obtained.

The molecular weight of the styrene-based polymer is preferably in a range of 10,000 to 300,000, more preferably in a range of 15,000 to 200,000, and most preferably in a range of 20,000 to 150,000 in terms of weight-average molecular weight.

Additional examples of the polymer having an ethylenic unsaturated bond at the side chain are as described below.

Examples of a novolac polymer having an ethylenic unsaturated group at the side chain include the polymers described in JP1997-269596A (JP-H9-269596A), polymers in which an ethylenic unsaturated bond is introduced into the side chain using the method described in JP2002-62648A, and the like.

In addition, examples of an acetal polymer having an ethylenic unsaturated bond at the side chain include the polymers described in JP2002-162741A and the like.

Furthermore, examples of a polyamide-based polymer having an ethylenic unsaturated bond at the side chain include the polymers described in JP2003-321022, polymers in which an ethylenic unsaturated bond is introduced into the side chain of a polyamide polymer cited in the above-described polymers using the method described in JP2002-62648A, and the like.

Examples of a polyimide polymer having an ethylenic unsaturated bond at the side chain include the polymers described in JP2003-339785A, polymers in which an ethylenic unsaturated bond is introduced into the side chain of a polyimide polymer cited in the above-described polymers using the method described in JP2002-62648A, and the like.

«C: Compound having epoxy group or oxetanyl group»

A third preferred aspect of the present invention includes a compound having an epoxy group or an oxetanyl group as the polymerizing compound. Examples of the compound having an epoxy group or an oxetanyl group include polymers having an epoxy group at the side chain and polymerizing monomers or oligomers having two or more epoxy groups in the molecule and specific examples thereof include bisphenol A-type epoxy resins, bisphenol F-type epoxy resins, phenol novolac-type epoxy resins, cresol novolac-type epoxy resins, aromatic epoxy resins, and the like. A monofunctional or polyfunctional glycidyl ether compound can also be used as the compound having an epoxy group or an oxetanyl group and a polyfunctional aliphatic glycidyl ether compound is preferred.

As the above-described compound, a commercially available product may be used or the compound can be obtained by introducing an epoxy group into the side chain in the polymer.

Regarding the commercially available product, for example, the description of Paragraphs [0191] and the like in JP2012-155288A can be referenced.

Examples of the commercially available product include polyfunctional aliphatic glycidyl ether compounds such as DENACOL EX-212L, EX-214L, EX-216L, EX-321L, and EX-850L (all manufactured by Nagase ChemteX Corporation). The above-described products are low-chlorine products and EX-212, EX-214, EX-216, EX-321, EX-850, and the like, which are not low-chlorine products, can also be used in a similar manner.

Additionally, examples thereof include ADEKA RESIN EP-4000S, ADEKA RESIN EP-4003S, ADEKA RESIN EP-4010S, ADEKA RESIN EP-4011S (all manufactured by Adeka Corporation), NC-2000, NC-3000, NC-7300, XD-1000, EPPN-501, EPPN-502 (all manufactured by Adeka Corporation), JER1031S, and the like.

Furthermore, examples of the commercially available product of the phenol novolac-type epoxy resins include JER-157S65, JER-152, JER-154, JER-157S70 (all manufactured by Mitsubishi Chemical Corporation), and the like.

As a specific example of a polymer having an oxetanyl group at the side chain and the above-described polymerizing monomer or oligomer having two or more oxetanyl groups in the molecule, it is possible to use ARON OXETANE OXT-121, OXT-221, OX-SQ, and PNOX (all manufactured by Toagosei Co., Ltd.).

In a case in which the compound is synthesized by introducing an epoxy group into the side chain in the polymer, the introduction reaction can be carried out by causing a reaction in an organic solvent at a reaction temperature in a range of 50°C to 150°C for several hours to several tens of hours using, for example, a ternary amine such as trimethylamine or benzylmethylamine, a quaternary ammonium salt such as dodecyl trimethyl ammonium chloride, tetramethyl ammonium chloride, or tetraethyl ammonium chloride, pyridine, or triphenylphosphine as a catalyst. The introduced amount of an alicyclic epoxy unsaturated compound is preferably controlled so that the acid value of the obtained polymer falls in a range of 5 KOH·mg/g to 200 KOH·mg/g. In addition, the weight-average molecular weight is in a range of 500

to 5,000,000 and, furthermore, preferably in a range of 1,000 to 500,000.

As the epoxy unsaturated compound, it is also possible to use a compound having a glycidyl group as an epoxy group such as glycidyl (meth)acrylate or allyl glycidyl ether. A preferred example of the epoxy unsaturated compound is an unsaturated compound having an alicyclic epoxy group. Regarding the above-described unsaturated compound, the description of Paragraphs [0045] and the like in JP2009-265518A and the like can be referenced.

For the above-described polymerizing compounds, the details of the structure and the use method such as whether the polymerizing compounds are used singly or jointly and the amount added can be arbitrarily designed in accordance with the final performance design of the near-infrared absorbing composition. For example, from the viewpoint of sensitivity, a structure having a large content of an unsaturated group in one molecule is preferred and, in many cases, a di- or more-functional compound is preferred. From the viewpoint of increasing the strength of the near-infrared blocking filter, a tri- or more-functional compound is preferred. When compounds having different functional groups and different polymerizable groups (for example, acrylic acid esters, methacrylic acid esters, styrene-based compounds, or vinyl ether-based compounds) are jointly used, it is also effective to adjust both sensitivity and strength. Regarding the compatibility with other components included in the near-infrared absorbing composition (for example, metal oxides, pigments, and polymerization initiators) and dispersibility as well, the selection and use method of the polymerizing compound are important factors and, for example, when a low-purity compound is used or two or more compounds are jointly used, compatibility can be improved. In addition, from the viewpoint of improving adhesiveness to the curable surface of a support or the like, it is also possible to select a specific structure.

The amount of the polymerizing compound added to the composition of the present invention is in a range of 1% by mass to 80% by mass, more preferably in a range of 5% by mass to 50% by mass, and particularly preferably in a range of 7% by mass to 40% by mass in relation to the total solid content excluding the solvent.

The number of the polymerizing compounds may be one or more and, in a case in which two or more polymerizing compounds are used, the total amount thereof needs to fall into the above-described range.

<Surfactant>

The composition of the present invention may include a surfactant. Only one surfactant may be used or a combination of two or more surfactants may be used. The amount of the surfactant added is preferably in a range of 0.0001% by mass to 2% by mass, more preferably in a range of 0.005% by mass to 1.0% by mass, and still more preferably in a range of 0.01% by mass to 0.1% by mass in relation to the solid content of the composition of the present invention.

As the surfactant, a variety of surfactants such as a fluorine-based surfactant, a nonionic surfactant, a cationic surfactant, an anionic surfactant, and a silicone-based surfactant can be used.

Particularly, when the composition of the present invention includes at least any of fluorine-based surfactants and silicone-based surfactants, the liquid characteristics (particularly, fluidity) are further improved when a coating fluid is produced. Therefore, the uniformity of the coating thickness or liquid-saving properties is further improved.

That is, in a case in which a film is formed using a coating fluid to which the composition including at least any one of fluorine-based surfactants and silicone-based surfactants is applied, the surface tension between a surface to be coated and the coating fluid decreases and thus the wetting properties to the surface to be coated improve and the coating properties to the surface to be coated improve. Therefore, in a case in which a thin film having a thickness of approximately several micrometers is formed using a small amount of the fluid as well, the inclusion of the surfactant is effective since a film having a uniform thickness with little thickness variation is more preferably formed.

The content ratio of fluorine in the fluorine-based surfactant is preferably in a range of 3% by mass to 40% by mass, more preferably in a range of 5% by mass to 30% by mass, and particularly preferably in a range of 7% by mass to 25% by mass. A fluorine-based surfactant having a content ratio of fluorine in the above-described range is effective in terms of the uniformity of the thickness of a coated film or liquid-saving properties and also has favorable solubility in the near-infrared absorbing composition.

Examples of the fluorine-based surfactant include MEGAFAC F171, MEGAFAC F172, MEGAFAC F173, MEGAFAC F176, MEGAFAC F177, MEGAFAC F141, MEGAFAC F142, MEGAFAC F143, MEGAFAC F144, MEGAFAC R30, MEGAFAC F437, MEGAFAC F479, MEGAFAC F482, MEGAFAC F554, MEGAFAC F780, MEGAFAC R08 (all manufactured by DIC Corporation), FLORADO FC430, FLORADO FC431, FLORADO FC171 (all manufactured by Sumitomo 3M Limited), SAFLON S-382, SAFLON S-141, SAFLON S-145, SAFLON SC-101, SAFLON SC-103, SAFLON SC-104, SAFLON SC-105, SAFLON SC1068, SAFLON SC-381, SAFLON SC-383, SAFLON S393, SAFLON KH-40 (all manufactured by Asahi Glass Co., Ltd.), EFTOP EF301, EFTOP EF303, EFTOP EF351, EFTOP EF352 (all manufactured by Jemco Inc.), PF636, PF656, PF6320, PF6520, PF7002 (manufactured by OMNOVA Solutions Inc.), and the like.

As the fluorine-based surfactant, a polymer having a fluoroaliphatic group is also preferred. Examples of the polymer having a fluoroaliphatic group include fluorine-based surfactants obtained from fluoroaliphatic compounds which

have a fluoroaliphatic group which is manufactured using a telomerization method (also called a telomer method) or an oligomerization method (also called an oligomer method).

Here, the "telomerization method" refers to a method for synthesizing a compound having 1 or 2 active groups in the molecule by polymerizing low-molecular-weight substances. In addition, the "oligomerization method" refers to a method for converting a monomer or a mixture of monomers to an oligomer.

Examples of the fluoroaliphatic group in the present invention include $-CF_3$ group, $-C_2F_5$ group, $-C_3F_7$ group, $-C_4F_9$ group, $-C_5F_{11}$ group, $-C_6F_{13}$ group, $-C_7F_{15}$ group, $-C_8F_{17}$ group, $C_9F_{19}$ group, and $C_{10}F_{21}$ group and, in terms of compatibility and coating properties, $-C_2F_5$ group, $-C_3F_7$ group, $-C_4F_9$ group, $-C_5F_{11}$ group, $-C_6F_{13}$ group, $-C_7F_{15}$ group, and $-C_8F_{17}$ group are preferred.

The fluoroaliphatic compound in the present invention can be synthesized using the method described in JP2002-90991 A.

The polymer having the fluoroaliphatic group in the present invention is preferably a copolymer of a monomer having the fluoroaliphatic group in the present invention and (poly(oxyalkylene)acrylate and/or (poly(oxyalkylene))methacrylate. The copolymer may be irregularly distributed or block-copolymerized. In addition, examples of the poly(oxyalkylene) group include a poly(oxyethylene) group, a poly(oxypropylene) group, a poly(oxybutylene) group, and the like and the poly(oxyalkylene) group may be a unit having alkylenes having different chain lengths in the same chain length such as a poly(a block-linked body of oxyethylene, oxypropylene, and oxyethylene) group or a poly (block-linked body of oxyethylene and oxypropylene) group. Furthermore, the copolymer of a monomer having the fluoroaliphatic group and (poly(oxyalkylene))acrylate (or methacrylate) may be not only a two-component copolymer but also a three or more-component copolymer of monomers having two different kinds of fluoroaliphatic groups or two different kinds of (poly(oxyalkylene))acrylate (or methacrylate).

Examples of commercially available surfactants including the polymer having the fluoroaliphatic group in the present invention include the surfactants described in Paragraph [0552] in JP2012-208494A ([0678] in the specification of US2012/0235099). In addition, it is possible to use a copolymer MEGAFAC F-781 (manufactured by DIC Corporation), acrylate (or methacrylate) having a $C_6F_{13}$ group, (poly(oxyethylene))acrylate (or methacrylate), and (poly(oxypropylene))acrylate (or methacrylate), a copolymer of acrylate (or methacrylate) having a $C_8F_{17}$ group and (poly(oxyalkylene))acrylate (or methacrylate), a copolymer of acrylate (or methacrylate) having a $C_8F_{17}$ group, (poly(oxyethylene))acrylate (or methacrylate), and (poly(oxypropylene))acrylate (or methacrylate), or the like.

Examples of nonionic surfactants include polyoxyethylene alkyl ethers, polyoxyethylene alkyl allyl ethers, polyoxyethylene aliphatic acid esters, sorbitan aliphatic esters, polyoxyethylene sorbitan aliphatic acid esters, polyoxyethylene alkyl amines, glycerin aliphatic acid esters, oxyethyleneoxy propylene block copolymers, acetylene glycol-based surfactants, acetylene-based polyoxyethylene oxides, and the like. The above-described surfactants can be used singly or two or more surfactants can be used.

Examples of specific commercially available products thereof include SURFYNOL 61, 82, 104, 104E, 104H, 104A, 104BC, 104DPM, 104PA, 104PG-50, 104S, 420, 440, 465, 485, 504, CT-111, CT-121, CT-131, CT-136, CT-141, CT-151, CT-171, CT-324, DF-37, DF-58, DF-75, DF-110D, DF-210, GA, OP-340, PSA-204, PSA-216, PSA-336, SE, SE-F, TG, GA, DYNOL 604 (all manufactured by Nissin Chemical Co., Ltd. and Air Products & Chemicals, Inc.), OLFIN A, B, AK-02, CT-151W, E1004, E1010, P, SPC, STG, Y, 32W, PD-001, PD-002W, PD-003, PD-004, EXP. 4001, EXP. 4036, EXP. 4051, AF-103, AF-104, SK-14, AE-3 (all manufactured by Nissin Chemical Co., Ltd.), ACETYLENOL E00, E13T, E40, E60, E81, E100, E200 (all are trade names and are manufactured by Kawaken Fine Chemicals Co., Ltd.), and the like. Among these, OLFIN E1010 is preferred.

Additionally, regarding the nonionic surfactants, specifically, the nonionic surfactants described in Paragraph [0553] in JP2012-208494A (Paragraph [0679] in the specification of the corresponding US2012/0235099) can be referenced.

Specific examples of cationic surfactants include the cationic surfactants described in Paragraph [0554] in JP2012-208494A (Paragraph [0680] in the specification of the corresponding US2012/0235099).

Specific examples of the anionic surfactants include W004, W005, W017 (manufactured by Yusho Co., Ltd.), and the like.

Examples of silicone-based surfactants include the silicone-based surfactants described in Paragraph [0556] in JP2012-208494A (Paragraph [0682] in the specification of the corresponding US2012/0235099). In addition, examples thereof also include "TORAY SILICONE SF8410", "TORAY SILICONE SF8427", "TORAY SILICONE SF8400", "ST80PA", "ST83PA", "ST86PA" all manufactured by Dow Coming Toray Co., Ltd., "TSF-400", "TSF-401", "TSF-410", "TSF-4446" manufactured by Momentive Performance Materials Worldwide Inc., "KP321", "KP323", "KP324", "KP340" manufactured by Shin-Etsu Chemical Co., Ltd. and the like.

<Polymerization initiator>

The composition of the present invention may include a polymerization initiator. The number of the polymerization initiators included may be one or more and, in a case in which the composition includes two or more polymerization initiators, the total amount thereof falls into the following range. The content of the polymerization initiator is preferably in a range of 0.01% by mass to 30% by mass, more preferably in a range of 0.1% by mass to 20% by mass, and particularly preferably in a range of 0.1% by mass to 15% by mass.

Any polymerization initiator that has the capability of initiating the polymerization of the polymerizing compounds using light and/or heat may be used. The polymerization initiator can be appropriately selected depending on the purpose. Among these, the polymerization initiator is preferably a photopolymerizing compound. In a case in which polymerization is initiated using light, the polymerization initiator preferably has photosensitivity to light rays in an ultraviolet to visible light range.

In addition, in a case in which polymerization is initiated using heat, a polymerization initiator that is decomposed at a temperature in a range of 150°C to 250°C is preferred.

The polymerization initiator that can be used in the present invention is preferably a compound having at least an aromatic group and examples thereof include acylphosphine compounds, acetophenone-based compounds, α-aminoketone compounds, benzophenone-based compounds, benzoin ether-based compounds, ketal derivative compounds, thioxanthone compounds, oxime compounds, hexaaryl biimidazole compounds, trihalomethyl compounds, azo compounds, organic peroxides, onium salt compounds such as diazonium compounds, iodonium compounds, sulfonium compounds, azinium compounds, benzoin ether-based compounds, ketal derivative compounds, and metallocene compunds, organic borate compounds, disulfo compounds, thiol compounds, and the like.

From the viewpoint of sensitivity, oxime compounds, acetophenone-based compounds, α-aminoketone compounds, trihalomethyl compounds, hexaaryl biimidazole compounds, and thiol compounds are preferred.

Regarding the acetophenone-based compounds, the trihalomethyl compounds, the hexaaryl biimidazole compounds, and the oxime compounds, specifically, the description of Paragraphs [0506] to [0510] in JP2012-208494A (Paragraphs [0622] to [0628] in the specification of the corresponding US2012/0235099A).

Preferably, furthermore, the polymerization initiator can also be preferably used for the cyclic oxime compounds described in JP2007-231000A and JP2007-322744A.

Additional examples thereof include the oxime compounds having a specific substituent described in JP2007-269779A and the oxime compounds having a thioaryl group described in JP2009-191061A.

Specifically, the oxime compounds are also preferably compounds represented by Formula (1) described below. Meanwhile, the N-O bond in an oxime may be an oxime compound of an (E) body, an oxime compound of a (Z) body, or a mixture of the (E) body and the (Z) body. Regarding the compound represented by Formula (1), the description of the compound represented by Formula (OX-1) or (OX-2) in Paragraphs [0513] (Paragraph [0632] in the specification of the corresponding US2012/235099A) and thereafter in JP2012-208494A can be referenced.

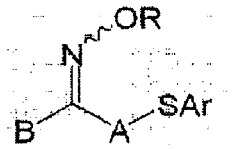

(1)

(In Formula (1), each of R and B independently represents a monovalent substituent, A represents a divalent organic group, and Ar represents an aryl group.)

The monovalent substituent represented by R is preferably a monovalent non-metal atomic group. Examples of the monovalent non-metal atomic group include alkyl groups having 1 to 30 carbon atoms, aryl groups having 6 to 30 carbon atoms, acyl groups having 2 to 20 carbon atoms, alkyoxcarbonyl groups having 2 to 20 carbon atoms, aryloxycarbonyl groups having 2 to 20 carbon atoms, heterocyclic groups, alkylthiocarbonyl groups, arylthiocarboxyl groups, and the like.

The monovalent substituent represented by B represents an aryl group, a heterocyclic group, an arylcarbonyl group, or a heterocyclic carbonyl group.

Examples of the divalent organic group represented by A include an alkylene group having 1 to 12 carbon atoms, a cyclohexylene group, and an alkylene group.

The above-described groups may have one or more substituents. In addition, the above-described substituent may be substituted with another substituent. Examples of the substituent include a halogen atom, an aryloxy group, an alkoxycarbonyl group, an aryloxy carbonyl group, an acyloxy group, an acyl group, an alkyl group, an aryl group, and the like.

Regarding specific examples of the oxime compounds that are preferably used, the description of Paragraph [0033] in JP2012-032556A, Paragraph [0033] in JP2012-122045A, and the like can be referenced. (Plox-1) to (Plox-13) will be illustrated below, but the present invention is not limited thereto.

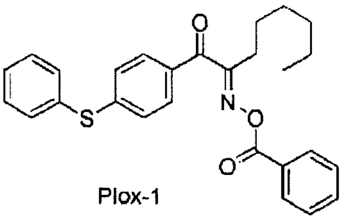

Plox-1

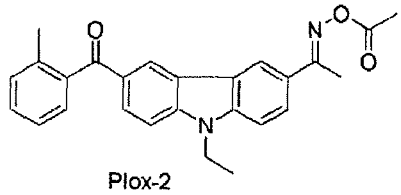

Plox-2

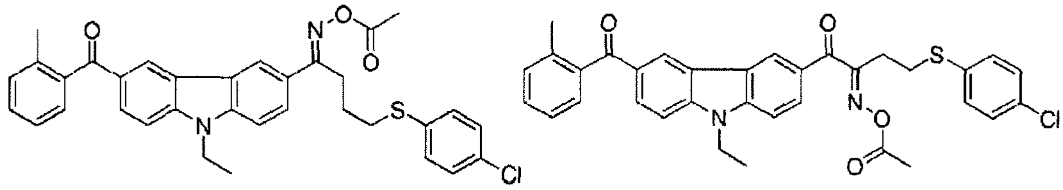

Plox-3 Plox-4

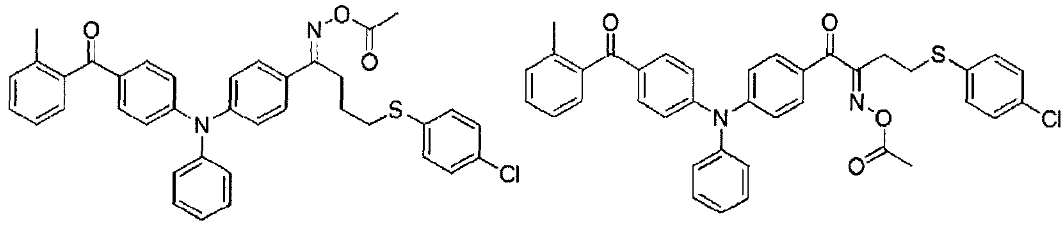

Plox-5 Plox-6

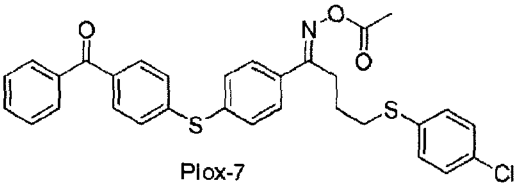

Plox-7

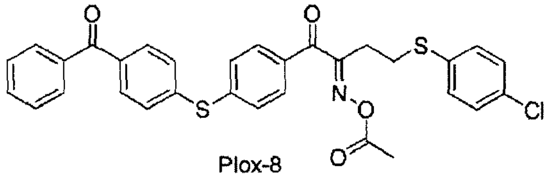

Plox-8

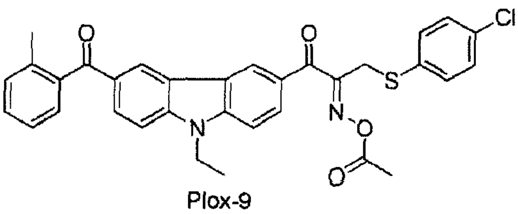

Plox-9

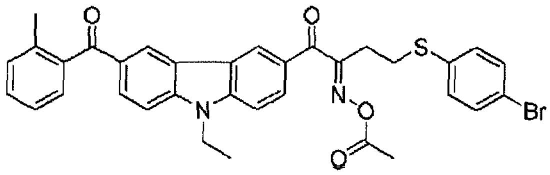

Plox-10

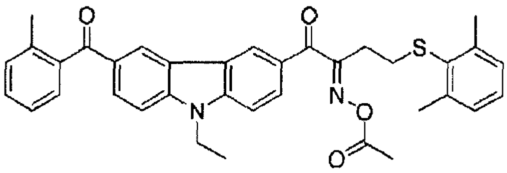

Plox-11

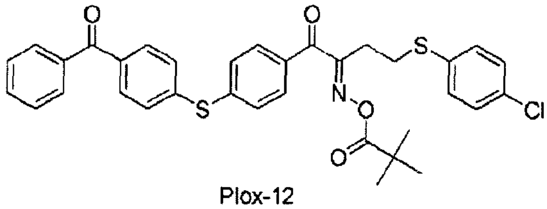

Plox-12

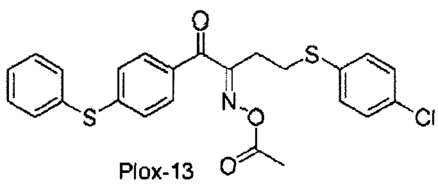

Plox-13

The oxime compound preferably has the maximum absorption wavelength in a wavelength range of 350 nm to 500 nm, more preferably has the maximum absorption wavelength in a wavelength range of 360 nm to 480 nm, and particularly preferably has high absorbance at 365 nm and 455 nm.

The mole absorption coefficient of the oxime compound at 365 nm or 405 nm is preferably in a range of 3,000 to 300,000, more preferably in a range of 5,000 to 300,000, and particularly preferably in a range of 10,000 to 200,000 from the viewpoint of sensitivity.

For the mole absorption coefficient of the compound, it is possible to use a well-known method and is preferably measured using, for example, a UV-visible spectrophotometer (Carry-5 spectrophotometer manufactured by Varian Inc.) and an ethyl acetate solvent at a concentration of 0.01 g/L.

A photopolymerization initiator is more preferably a compound selected from the group consisting of oxime compounds, acetophenone-based compounds, and acylphosphine compounds. For example, it is also possible to use the aminoacetophenone-based initiators described in JP1998-291969A (JP-H10-291969A), the acylphosphine oxide-based initiators described in JP4225898B, the above-described oxime-based initiators, and, furthermore, as the oxime-based initiators, the compounds described in JP2001-233842A.

As the oxime compound, it is possible to use a commercially available products of IRGACURE-OXE01 (manufactured by BASF) or IRGACURE-OXE02 (manufactured by BASF). As the acetophenone-based initiator, it is possible to use commercially available products of IRGACURE-907, IRGACURE-369, and IRGACURE-379 (trade name, all manufactured by BASF Japan). In addition, as the acylphosphine-based initiator, it is possible to use a commercially available product of IRGACURE-819, and DAROCUR-TPO (trade name, all manufactured by BASF Japan).

<Other components>

In the composition of the present invention, in addition to the above-described essential components and the above-described preferred additives, other components may be selectively used in an appropriate manner depending on the purpose as long as the effects of the present invention are not impaired.

Examples of the other components that can be used include a dispersing agent, a sensitizer, a crosslinking agent (an aqueous solution of a crosslinking agent), acetic anhydride, a silane compound, a curing accelerator, a filler, a thermal curing accelerator, a thermopolymerization inhibitor, a plasticizer, and the like and, furthermore, an adhesion accelerator to the surface of a base material and other auxiliary agents (for example, conductive particles, a defoamer, a flame retardant, a levelling agent, a peeling accelerator, an antioxidant, a fragrance, a surface tension adjuster, a chain transfer agent, and the like) may be jointly used.

When the composition of the present invention appropriately includes the above-described components, it is possible to adjust properties such as stability and film properties of the target near-infrared cut filter.

Regarding the above-described components, for example, the descriptions in Paragraphs [0183] and thereafter in JP2012-003225A, Paragraphs [0101] and [0102] in JP2008-250074A, Paragraphs [0103] and [0104] in JP2008-250074A, Paragraphs [0107] to [0109] in JP2008-250074A, and the like can be referenced.

Since the composition of the present invention may be in a liquid form, it is possible to easily produce the near-infrared blocking filter by, for example, directly applying and drying the composition of the present invention and the production aptitude that has not been sufficient in the above-described near-infrared blocking filter of the related art can be improved.

The use of the near-infrared absorbing composition of the present invention is not particularly limited and examples thereof include compositions for near-infrared blocking filters on the light-receiving side of a solid-state imaging element substrate (for example, compositions for near-infrared blocking filters for wafer-level lenses, and the like), compositions for near-infrared blocking filters on the back surface side of the solid-state imaging element substrate (the side opposite to the light-receiving side), and the like. The near-infrared absorbing composition of the present invention is preferably used for light-shielding films on the light-receiving side of the solid-state imaging element substrate. Particularly, the near-infrared absorbing composition of the present invention is preferably directly applied onto an image sensor for the solid-state imaging element using an aqueous solvent so as to form a coated film.

In a case in which an infrared blocking layer is formed through coating, the viscosity of the near-infrared absorbing composition of the present invention is preferably in a range of 1 mPa·s to 3000 mPa·s, more preferably in a range of 10 mPa·s to 2000 mPa·s, and still more preferably in a range of 100 mPa·s to 1500 mPa·s.

In a case in which the near-infrared absorbing composition of the present invention is used for near-infrared blocking filters on the light-receiving side of the solid-state imaging element substrate and an infrared blocking layer is formed through coating, the viscosity thereof is preferably in a range of 10 mPa·s to 3000 mPa·s, more preferably in a range of 500 mPa·s to 1500 mPa·s, and most preferably in a range of 700 mPa·s to 1400 mPa·s from the viewpoint of thick film formability and uniform coating properties.

The total solid content of the near-infrared absorbing composition of the present invention varies depending on the coating method and is preferably in a range of 1% by mass to 50% by mass, more preferably in a range of 1%

by mass to 30% by mass, and still more preferably in a range of 10% by mass to 30% by mass in relation to the composition.

The present invention may be a laminate including a near-infrared blocking layer obtained by curing the near-infrared absorbing composition and a dielectric multilayer film. Examples thereof include (i) an aspect in which a transparent support, a near-infrared blocking layer, and a dielectric multilayer film are sequentially provided and (ii) an aspect in which a near-infrared blocking layer, a transparent support, and a dielectric multilayer film are sequentially provided. As the transparent support, a glass substrate or a transparent resin substrate can be used.

The dielectric multilayer film is a film having the capability of reflecting and/or absorbing near-infrared rays.

As a material for the dielectric multilayer film, for example, ceramics can be used. Alternatively, a noble metal film that absorbs light in the near-infrared range may be used in consideration of the thickness and the number of layers so as to prevent the visible light transmissivity of the near-infrared blocking filter from being affected.

As the dielectric multilayer film, specifically, it is possible to preferably use a configuration in which high-refractive index material layers and low-refractive index material layers are alternately laminated.

As a material that configures the high-refractive index material layer, a material having a refractive index of 1.7 or more can be used and a material having a refractive index in a range of 1.7 to 2.5 is generally selected.

Examples of the material include titanium oxide (titania), zirconium oxide, tantalum pentaoxide, niobium pentaoxide, lanthanum oxide, yttrium oxide, zinc oxide, zinc sulfide, indium oxide, and materials which contain the above-described oxide as a main component and contain a small amount of titanium oxide, tin oxide, and/or cerium oxide. Among these, titanium oxide (titania) is preferred.

As a material configuring the low-refractive index material layer, it is possible to use a material having a refractive index of 1.6 or less and a material having a refractive index in a range of 1.2 to 1.6 is generally selected.

Examples of the material include silica, alumina, lanthanum fluoride, magnesium fluoride, and sodium aluminum hexafluoride. Among these, silica is preferred.

The thickness of each of the high-refractive index layer and the low-refractive index layer is generally as thick as 0.1λ to 0.5λ of the wavelength λ (nm) of an infrared ray which is planned to be shielded. When the thickness is outside the above-described range, the product (nxd) of the refractive index (n) and the film thickness (d) is significantly different from the optical film thickness computed using λ/4 and thus the optical characteristic relationship between reflection and refraction is no longer valid, and there is a tendency that it becomes difficult to control the shielding and transmitting of specific wavelengths.

In addition, the number of layers laminated in the dielectric multilayer film is preferably in a range of 5 to 50 and more preferably in a range of 10 to 45.

There is no particular limitation regarding the method for forming the dielectric multilayer film and examples thereof include a method in which a dielectric multilayer film in which high-refractive index layers and low-refractive index layers are alternately laminated is formed using a CVD method, a sputtering method, a vacuum deposition method, or the like and is attached to the film using an adhesive and a method in which a dielectric multilayer film in which high-refractive index layers and low-refractive index layers are alternately laminated is directly formed on the film using a CVD method, a sputtering method, a vacuum deposition method, or the like.

In a case in which a substrate is warped during the deposition of the dielectric multilayer film, in order to prevent the above-described warping, it is possible to employ methods in which the dielectric multilayer films are deposited on both surfaces of the substrate or the surface of the substrate and in which the surfaces the dielectric multilayer film is deposited are irradiated with a radioactive ray such as an infrared ray. Meanwhile, in a case in which the surface is irradiated with a radioactive ray, the surface may be irradiated with a radioactive ray while the dielectric multilayer film is deposited or the surface may be separately irradiated with a radioactive ray after the dielectric multilayer film is deposited.

The present invention relates to a method for producing a near-infrared blocking filter including a step of applying (preferably coating or printing and more preferably applicator-coating) the near-infrared absorbing composition of the present invention to the light-receiving side of a solid-state imaging element substrate so as to form a film and a step of drying the film. The film thickness, the lamination structure, and the like can be appropriately selected depending on the purpose.

A support may be a transparent substrate made of glass, a solid-state imaging element substrate, another substrate (for example, a glass substrate 30 described below) provided on the light-receiving side of the solid-state imaging element substrate, or a layer such as a flattened layer provided on the light-receiving side of the solid-state imaging element substrate.

The near-infrared absorbing composition (coating fluid) can be applied onto the support using, for example, a dropwise addition method (drop caster), a spin coater, a slit spin coater, a slit coater, screen printing, applicator application, or the like. In the case of the dropwise addition method (drop caster), it is preferable to form a dropwise addition region of the near-infrared absorbing composition in which an offset resist is used as a partition wall on a glass substrate so that a uniform film is obtained in a predetermined film thickness. Meanwhile, regarding the film thickness, a desired film thickness can be obtained by adjusting the amount of the composition dropwise-added, the concentration of the solid

content, and the area of the dropwise addition region.

In addition, the conditions for drying the coated film vary depending on the kind and fractions of individual components and a solvent; however, generally, the coated film is dried at a temperature in a range of 60°C to 150°C for approximately 30 seconds to 15 minutes.

The thickness of the film is not particularly limited and can be appropriately selected depending on the purpose. The thickness of the film is, for example, preferably in a range of 1 μm to 500 μm, more preferably in a range of 1 μm to 300 μm, and particularly preferably in a range of 1 μm to 200 μm. In the present invention, even in a case in which a film as thin as described above is produced, it is possible to maintain near-infrared shielding properties.

A method for forming the near-infrared blocking filter using the near-infrared absorbing composition of the present invention may include other steps. The other steps are not particularly limited and can be appropriately selected depending on the purpose. Examples of the other steps include a surface treatment step of the base material, a pretreatment step (prebaking step), a curing treatment step, a post heating step (post baking step), and the like.

<Preheating step and post heating step>

The heating temperatures in the preheating step and the post heating step are generally in a range of 80°C to 200°C and preferably in a range of 90°C to 150°C.

The heating times in the preheating step and the post heating step are generally in a range of 30 seconds to 240 seconds and preferably in a range of 60 seconds to 180 seconds.

<Curing treatment step>

The curing treatment step refers to a step of carrying out a curing treatment on the formed film as necessary and the curing treatment improves the mechanical strength of the near-infrared blocking filter.

The curing treatment step is not particularly limited and can be appropriately selected depending on the purpose and preferred examples thereof include a full-surface exposure treatment, a full-surface thermal treatment, and the like. In the present invention, the meaning of "exposure" includes the irradiation of the surface with a radioactive ray such as an electron beam or an X ray as well as light rays having a variety of wavelengths.

The exposure is preferably carried out through irradiation using an radioactive ray and, as the radioactive ray that can be used in the exposure, particularly, an ultraviolet ray such as an electron beam, KrF, ArF, a g-ray, an h-ray, or an i-ray or visible light is preferably used. Among these, KrF, a g-ray, an h-ray, and an i-ray are preferred.

Examples of the exposure method include stepper exposure, exposure using a high-pressure mercury lamp, and the like.

The exposure amount is preferably in a range of 5 $J/cm^2$ to 3000 $mJ/cm^2$, more preferably in a range of 10 $J/cm^2$ to 2000 $mJ/cm^2$, and particularly preferably in a range of 50 $J/cm^2$ to 1000 $mJ/cm^2$.

Examples of a method for the full-surface exposure treatment include a method in which the full surface of the above-described formed film is exposed. In a case in which the near-infrared absorbing composition includes the polymerizing compound, the full-surface exposure accelerates the curing of a polymerizing component in the film formed of the composition, makes the film cured to a greater extent, and improves the mechanical strength and the durability.

An apparatus for carrying out the full-surface exposure is not particularly limited and can be appropriately selected depending on the purpose, and preferred examples thereof include UV steppers such as ultrahigh-pressure mercury lamps.

In addition, examples of the method for the full-surface thermal treatment include a method in which the full surface of the above-described formed film is heated. The heating of the full surface increases the film strength of a pattern.

The heating temperature in the full-surface heating is preferably in a range of 120°C to 250°C and more preferably in a range of 160°C to 220°C. When the heating temperature is 120°C or higher, the film strength is improved by the heating treatment and, when the heating temperature is 250°C or lower, components in the film are decomposed and it is possible to prevent film qualities from becoming weak and brittle.

The heating time in the full-surface heating is preferably in a range of 3 minutes to 180 minutes and more preferably in a range of 5 minutes to 120 minutes.

An apparatus for carrying out the full-surface heating is not particularly limited and can be appropriately selected from well-known apparatuses depending on the purpose, and examples thereof include a dry oven, a hot plate, an IR heater, and the like.

The present invention also relates to a camera module including a solid-state imaging element substrate and a near-infrared blocking filter disposed on the light-receiving side of the solid-state imaging element substrate, in which the near-infrared blocking filter is the near-infrared blocking filter of the present invention.

Hereinafter, a camera module according to an embodiment of the present invention will be described with reference to Figs. 1 and 2, but the present invention is not limited by specific examples described below.

In Figs. 1 and 2, common portions are given common reference signs.
In addition, in the description, "upper", "upward", and "upper side" indicate the side far from a silicon substrate 10 and "lower", "downward", and "lower side" indicate the side close to the silicon substrate 10.
Fig. 1 is a schematic sectional view illustrating the configuration of a camera module including a solid-state imaging element.
A camera module 200 illustrated in Fig. 1 is connected to a circuit board 70 which is a mounting board through solder balls 60 that are connection members.
In detail, the camera module 200 includes a solid-state imaging element substrate 100 having an imaging element section on a first main surface of a silicon substrate, a flattening layer provided on the first main surface side (light-receiving side) of the solid-state imaging element substrate 100 (not illustrated in Fig. 1), a near-infrared blocking filter 42 provided on the flattening layer, a lens holder 50 which is disposed above the near-infrared blocking filter 42 and includes an imaging lens 40 in the inner space, and a light shielding and electromagnetic shield 44 disposed so as to surround the peripheries of the solid-state imaging element substrate 100 and a glass substrate 30. The glass substrate 30 (light transmissive substrate) may be provided on the flattening layer. The respective members are adhered
The present invention also relates to a step of forming a film by applying the near-infrared absorbing composition of the present invention to the light-receiving side of the solid-state imaging element substrate in a method for manufacturing the camera module including the solid-state imaging element substrate and the near-infrared blocking filter disposed on the light-receiving side of the solid-state imaging element substrate.
Therefore, in the camera module according to the present embodiment, for example, the near-infrared blocking filter 42 can be formed by applying the near-infrared absorbing composition of the present invention so as to form a film on the flattening layer. A method for forming the near-infrared blocking filter 42 by applying the near-infrared absorbing composition is as described above.
In the camera module 200, incident light hv coming from the outside sequentially passes through the imaging lens 40, the near-infrared blocking filter 42, the glass substrate 30, and the flattening layer and then reaches the imaging element section in the solid-state imaging element substrate 100. In addition, the camera module 200 is connected to the circuit board 70 through the solder balls 60 (connection material) on a second main surface side of the solid-state imaging element substrate 100.
The camera module 200 may include the near-infrared blocking filter directly provided on the flattening layer without the glass substrate 30 or may include the near-infrared blocking filter directly provided on the glass substrate 30 without the flattening layer.
Fig. 2 is an enlarged view of the solid-state imaging element substrate 100 in Fig. 1.
The solid-state imaging element substrate 100 includes the silicon substrate 10 which is a basic body, imaging elements 12, an interlayer insulating film 13, a base layer 14, a red color filter 15R, a green color filter 15G, a blue color filter 15B, an overcoat 16, micro lenses 17, a light-shielding film 18, an insulating film 22, a metal electrode 23, a solder resist layer 24, an internal electrode 26, and an element surface electrode 27.
Here, the solder resist layer 24 may not be provided.
Regarding the solid-state imaging element substrate 100, the description of the solid-state imaging element substrate 100 in Paragraphs [0245] (Paragraph [0407] in the specification of the corresponding US2012/068292) and thereafter in JP2012-068418A can be referenced.

## Examples

Hereinafter, the present invention will be more specifically described using examples. Materials, amounts used, fractions, treatment contents, treatment orders, and the like described in the following examples can be appropriately changed within the scope of the gist of the present invention. Therefore, the scope of the present invention is not limited to specific examples described below.
In the present examples, the following abbreviations will be employed.

<Near-infrared absorbing substance>

In Table 2 described below, for example, the organic group ($-CH_3$) in A-1 represents R in the following general formula. In addition, "*" in each of the organic groups represented by A-107 and A-112 represents a bonding portion with a sulfur atom in the following general formula.

[Table 2]

| 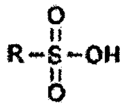 | | | |
|---|---|---|---|
| **Sulfonic add** | **R** | **Sulfonic acid** | **R** |
| A-1 | $-CH_2$ | A-96 | $-CF_3$ |
| A-107 | 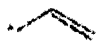 | A-112 | 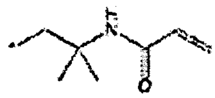 |

(Synthesis of sulfonic acid copper complex 1)

The above-described sulfonic acid A-1 was dissolved in methanol. After the solution was heated to 50°C, a methanol solution of copper acetate was added dropwise and the components were reacted at 50°C for 2 hours. After the end of the reaction, the generated acetic acid and the solvent were distilled away using an evaporator, thereby obtaining a sulfonic acid copper complex 1.

Sulfonic acid copper complexes 2 to 4 were obtained in the same manner as the sulfonic acid copper complex 1 except for the fact that sulfonic acid A-1 was changed to A-96, A-107, and A-112 described in Table 2.

<Evaluation of near-infrared absorbing composition>

<<Preparation of near-infrared absorbing composition>>

The following compounds were mixed together so as to prepare a near-infrared absorbing composition.

(Preparation Example 1)

A 50 wt% aqueous solution of polyacrylamide (AQ nylon A-90 manufactured by Toray Fine Chemicals Co., Ltd.) (5.00 g) and pure water (2.50 g) were added to the above-described sulfonic acid copper complex 1 (2.50 g), thereby obtaining a near-infrared absorbing composition 1 including the sulfonic acid copper complex and a binder resin at a ratio of 1:1 and a solid content concentration of 50 wt%. The prepared near-infrared absorbing composition 1 was a bluish transparent liquid.

(Preparation Example 2)

After gelatin GEL820 (0.97 g) and pure water (5.52 g) were added to the above-described sulfonic acid copper complex 1 (1.07 g) and the components were stirred at 40°C for 2 hours, an aqueous solution of a crosslinking agent (4 wt%, special crosslinking agent VS-C, Fujifilm Finechemicals Co., Ltd.) (2.44 g) was added, thereby obtaining a near-infrared absorbing composition 2 including the sulfonic acid copper complex and a binder resin at a ratio of 1:1 and a solid content concentration of 21.4 wt%. The prepared near-infrared absorbing composition 2 was a bluish transparent liquid.

(Preparation Example 3)

After anhydrous acetic acid (0.02 g) and tetraethoxysilane (0.79 g) were added to pure water (0.81 g) and the components were stirred at 60°C for 1 hour 15 minutes, a 12 wt% aqueous solution of polyvinyl alcohol (6.76 g) and the sulfonic acid copper complex 1 (1.62 g) were added, thereby obtaining a near-infrared absorbing composition 3 including the sulfonic acid copper complex and a binder resin at a ratio of 1:1 and a solid content concentration of 32.4 wt%. The prepared near-infrared absorbing composition 3 was a bluish transparent liquid.

(Preparation Example 4)

A water-soluble epoxy resin (DENACOL EX313, Nagase ChemteX Corporation, 2.50 g) and pure water (5.00

g) were added to the sulfonic acid copper complex 1 (2.50 g), thereby obtaining a near-infrared absorbing composition 4 including the sulfonic acid copper complex and a binder resin at a ratio of 1:1 and a solid content concentration of 50 wt%. The prepared near-infrared absorbing composition 4 was a bluish transparent liquid.

(Preparation Example 5)

<<Preparation of subsidiary near-infrared absorbing composition>>

The following compounds were mixed together so as to prepare a subsidiary near-infrared absorbing composition.

An acryl polymer solution (acryl-based FF-187: Fujikura Kasei Co., Ltd.) (1.19 g), an acryl monomer (KAYARAD DPHA: Nippon Kayaku Co., Ltd.) (0.49 g), an oxime ester compound (IRGACURE-OXE01: Ciba Specialty Chemical Corporation) (0.12 g), a surfactant (Megafac F-781: DIC Corporation) (0.0034 g), and cyclohexanone (4.97 g) were added to a cesium tungsten oxide liquid dispersion (YMF-02A: Sumitomo Metal Mining Co., Ltd.) (3.23 g), thereby obtaining a subsidiary near-infrared absorbing composition having a solid content concentration of 20 wt%. The prepared subsidiary near-infrared absorbing composition 4 was a black liquid.

<<Production of near-infrared blocking filter>>

Near-infrared blocking filters of Examples 1 to 5 were produced using the near-infrared absorbing compositions prepared in Preparation Examples 1 to 5 and the subsidiary near-infrared absorbing composition.

<Example 1>

The near-infrared absorbing composition 1 prepared in Preparation Example 1 was applicator-applied onto a glass substrate using an applicator-coating method (baker applicator manufactured by Yoshimitsu Seiki Co., Ltd., used after a YBA-3 type was adjusted to a slit width of 400 μm), was prebaked in an oven at 100°C for 30 minutes, and, furthermore, was post-baked in the oven at 120°C for 15 minutes, thereby producing a near-infrared blocking filter 1. The film thickness of the obtained near-infrared blocking filter was 146.5 μm.

<Example 2>

The near-infrared absorbing composition 2 prepared in Preparation Example 2 was applicator-applied onto a glass substrate using an applicator-coating method (a slit width of 400 μm), was prebaked in an oven at 100°C for 30 minutes, and, furthermore, was post-baked in the oven at 140°C for 15 minutes, thereby producing a near-infrared blocking filter 2. The film thickness of the obtained near-infrared blocking filter was 140.4 μm.

<Example 3>

The near-infrared absorbing composition 3 prepared in Preparation Example 3 was applicator-applied onto a glass substrate using an applicator-coating method (a slit width of 300 μm), was prebaked in an oven at 100°C for 30 minutes, and, furthermore, was post-baked in the oven at 140°C for 15 minutes, thereby producing a near-infrared blocking filter 3. The film thickness of the obtained near-infrared blocking filter was 97.1 μm.

<Example 4>

The near-infrared absorbing composition 4 prepared in Preparation Example 4 was applicator-applied onto a glass substrate using an applicator-coating method (a slit width of 300 μm), was prebaked in an oven at 100°C for 30 minutes, and, furthermore, was post-baked in the oven at 180°C for 15 minutes, thereby producing a near-infrared blocking filter 4. The film thickness of the obtained near-infrared blocking filter was 89.2 μm.

<Example 5>

After the near-infrared absorbing composition 1 prepared in Preparation Example 1 was applicator-applied onto a glass substrate using an applicator-coating method (a slit width of 400 μm), was prebaked in an oven at 100°C for 30 minutes, and, furthermore, was post-baked in the oven at 120°C for 15 minutes, the subsidiary near-infrared absorbing composition prepared in Preparation Example 5 was applied using a spin coater (spin coater 1H-D7 manufactured by Mikasa Co., Ltd.) (3000 rpm, 20 seconds), was prebaked on a hot plate at 100°C for 2 minutes, was exposed to UV rays

(using a HB-50101BY stepper manufactured by Ushio Inc.) (1000 mJ/cm$^2$), and was post-baked at 120°C for 15 minutes, thereby producing a near-infrared blocking filter 5. The film thickness of the obtained near-infrared blocking filter was 147.2 μm.

<<Evaluation of near-infrared shielding properties>>

The spectral transmissivities of the near-infrared blocking filters obtained as described above were measured using a spectrophotometer U-4100 (manufactured by Hitachi High-Technologies Corporation). The obtained spectra are illustrated in Figs. 3 and 4.
In addition, the transmissivities at individual wavelengths in the spectra illustrated in Figs. 3 and 4 are described in Table 3 below.

[Table 3]

| | Transmissivities at individual wavelengths | | | | | |
|---|---|---|---|---|---|---|
| | 450 nm | 550 nm | 700 nm | 800 nm | 900 nm | 1100 nm |
| Example 1 | 97.60% | 95.50% | 17.20% | 5.50% | 8.40% | 28.70% |
| Example 2 | 86.60% | 85.90% | 9.10% | 13.50% | 28.40% | 67.50% |
| Example 3 | 94.10% | 96.30% | 36.10% | 8.00% | 8.50% | 23.00% |
| Example 4 | 94.60% | 95.90% | 39.80% | 9.10% | 8.70% | 22.90% |
| Example 5 | 95.00% | 91.50% | 16.20% | 4.50% | 5.60% | 17.00% |

As is clear from Table 3, it was found that, in the near-infrared blocking filters of Examples 1 to 5, the film thicknesses were 300 μm or less, 200 μm or less in more detail, and 150 μm or less in still more detail and the visible light transmissivities in the entire wavelength range of 450 nm to 550 nm, in more detail, the visible light transmissivities in a wavelength range of 450 nm to 575 nm were 85% or more.
It was found that, in the near-infrared blocking filters of Examples 1, 3 to 5, the visible light transmissivities in a wavelength range of 450 nm to 550 nm were 90% or more.
It was found that, in the near-infrared blocking filter of Example 5, the visible light transmissivity in a wavelength range of 700 nm to 1100 nm was 20% or less.
It was found that, in the near-infrared blocking filters of Examples 1, 3 to 5, the visible light transmissivities in a wavelength range of 800 nm to 900 nm were 10% or less. In addition, even in a case in which another sulfonic acid copper complex is used as the near-infrared absorbing substance, the same effects could be obtained.
Near-infrared absorbing compositions were obtained in the same manner as in Preparation Examples 1 to 5 except for the fact that the sulfonic acid copper complex 1 was converted to the sulfonic acid copper complexes 2 to 4 in Preparation Examples 1 to 5. Near-infrared blocking filters were produced in the same manner as in Examples 1 to 5 using these near-infrared absorbing compositions. Even in these cases, near-infrared blocking filters having excellent characteristics could be obtained in the same manner as in Examples 1 to 5.
In these near-infrared blocking filters, the incidence angle dependency was reduced and the near-infrared blocking filters could be practically used as near-infrared blocking filters for camera modules without a reflection film made of a deposited film.

<<Synthesis of polymer A-1>>

Polyether sulfone (manufactured by BASF, Ultrason E6020P) (5.0 g) was dissolved in sulfuric acid (46 g) and chlorosulfonic acid (16.83 g) was added dropwise at room temperature under a nitrogen flow. After the components were reacted at room temperature for 48 hours, the reaction solution was added dropwise to 1 L of a liquid mixture of hexane and ethyl acetate (1:1) which was cooled using icy water. The supernatant was removed and the obtained precipitate was dissolved in methanol. The obtained solution was added dropwise to 0.5 L of ethyl acetate and the obtained precipitate was collected through filtration. The obtained solid was dried at reduced pressure, thereby obtaining a polymer A-1 (4.9 g). The content (meq/g) of sulfonic acid group in the polymer was computed through neutralization titration. The weight-average molecular weight (Mw) was measured through gel permeation chromatography.

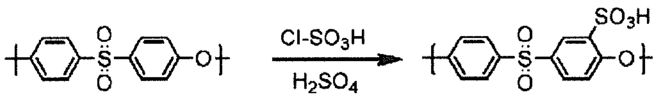


**A-1**

$SO_3H$ : 3.0 meq/g

Mw : 53000

«Synthesis of polymer A-2»

A polymer A-2 was obtained in the same manner as in the synthesis of the polymer A-1 except for the fact that the amount of chlorosulfonic acid was changed to 25.1 g and the reaction temperature and time were changed to 70°C and 7 hours.

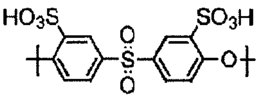

**A-2**

$SO_3H$ : 4.5 meq/g

Mw : 55000

«Synthesis of polymer A-3»

A polymer A-3 was obtained in the same manner as in the synthesis of the polymer A-1 except for the fact that chlorosulfonic acid was changed to 30% fuming sulfuric acid (14.4 g) and the reaction time was changed to 8 hours.

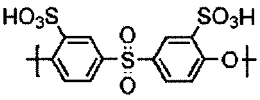

**A-3**

$SO_3H$ : 5.1 meq/g

Mw : 57000

<<Synthesis of polymer A-4>>

Polysulfone (manufactured by Sigma-Aldrich Co., LLC.) (8.0 g) was dissolved in chloroform (92.0 g) and chlorosulfonic acid (8.43 g) was added dropwise at room temperature under a nitrogen flow. When the components were reacted at room temperature for 1 hour, a solid was educed. The supernatant was removed and the obtained solid was washed using chloroform and then was dissolved in methanol. The solution was added dropwise to 0.5 L of ethyl acetate and the obtained precipitate was collected through filtration. The obtained solid was dried at reduced pressure, thereby obtaining a polymer A-4 (8.3 g).

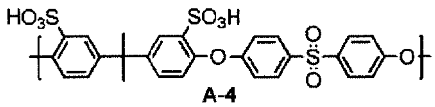

**A-4**

$SO_3H$ : 3.1 meq/g

Mw : 39000

<<Synthesis of polymer A-5>>

Hexafluoro bisphenol A (3.42 g), diphenyl sulfone-4,4'-dichloro-3,3'-disodium disulfonate (5.00 g), potassium carbonate (1.69 g), toluene (10 g), and N-methylpyrrolidone (25 g) were added to a three-neck flask equipped with a Dean-Stark tube and were refluxed for 4 hours under a nitrogen flow. After toluene in the system was removed, the components were heated to 180°C and were stirred for 15 hours. After the reaction solution was returned to room temperature, the reaction solution was filtered using a Hirsch funnel covered with celite and the filtrate was added dropwise to 300 ml of saturated saline water. The obtained precipitate was filtered, was dissolved in methanol, and then

was added dropwise to 500 ml of acetone. The obtained precipitate was filtered, was dissolved in methanol, and then was salt-exchanged to a proton type using Amberlyst 15 (hydrogen form) (manufactured by Sigma-Aldrich Co., LLC.), thereby obtaining a polymer A-5 (6.4 g).

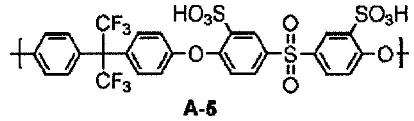

**A-5**

$SO_3H$ : 2.8 meq/g
Mw : 15000

«Synthesis of polymer A-6»

A polymer A-6 (3.9 g) was obtained in the same manner as in the synthesis of the polymer A-5 except for the fact that hexafluoro bisphenol A (3.42 g) was changed to hydroquinone (1.12 g).

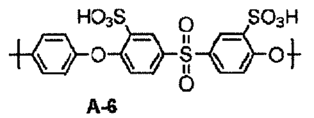

**A-6**

$SO_3H$ : 4.1 meq/g
Mw : 14000

<<Synthesis of polymer A-7>>

Diphenolic acid (4.66 g), diphenyl sulfone-4,4'-dichloro-3,3'-disodium disulfonate (8.00 g), potassium carbonate (2.48 g), toluene (10 g), and N-methylpyrrolidone (25 g) were added to a three-neck flask equipped with a Dean-Stark tube and were refluxed for 4 hours under a nitrogen flow. After toluene in the system was removed, the components were heated to 180°C and were stirred for 15 hours. After the reaction solution was returned to room temperature, the reaction solution was filtered using a Hirsch funnel covered with celite and the filtrate was added dropwise to 300 ml of saturated saline water. The obtained precipitate was filtered, was dissolved in methanol, and then was added dropwise to 500 ml of acetone. The obtained precipitate was filtered and was dried at reduced pressure, thereby obtaining a polymer.

The obtained polymer was dissolved in sulfuric acid (73.6 g) and chlorosulfonic acid (4.56 g) was added dropwise. After the components were reacted at room temperature for 6 hours, the reaction solution was added dropwise to 1.5 L of a liquid mixture of hexane and ethyl acetate (1:1) which was cooled using icy water. The supernatant was removed and the obtained precipitate was dissolved in methanol. The obtained solution was added dropwise to 0.5 L of ethyl acetate and the obtained precipitate was collected through filtration. The obtained solid was dried at reduced pressure, thereby obtaining a polymer A-7 (7.5 g).

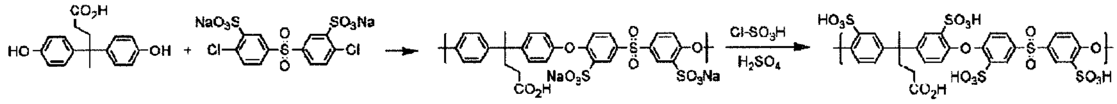


**A 7**

$SO_3H$ : 4.8 meq/g
$CO_2H$ : 1.2 meq/g
Mw : 21000

<<Synthesis of polymer A-8>>

4.4'-biphenol (3.53 g), benzophenone-4,4'-difluoro-3,3'-disodium disulfonate (8.00 g), potassium carbonate (3.14 g), toluene (10 g), and dimethyl sulfoxide (30 g) were added to a three-neck flask equipped with a Dean-Stark tube and were refluxed for 4 hours under a nitrogen flow. After toluene in the system was removed, the components were heated to 170°C and were stirred for 15 hours. After the reaction solution was returned to room temperature, the reaction solution was filtered using a Hirsch funnel covered with celite and the filtrate was added dropwise to 500 ml of saturated saline water. The obtained precipitate was filtered, was dissolved in methanol, and then was added dropwise to 800 ml of acetone. The obtained precipitate was filtered, was dissolved in methanol, and then was salt-exchanged to a proton type using Amberlyst 15 (hydrogen form) (manufactured by Sigma-Aldrich Co., LLC.), thereby obtaining a polymer A-8 (7.2 g).

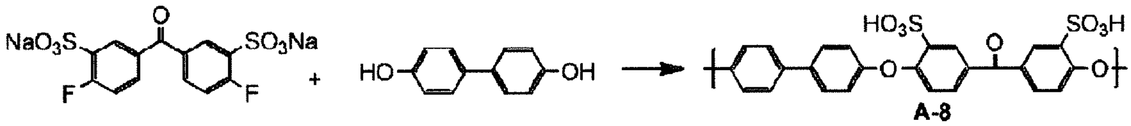

**A-8**

$SO_3H$ : 3.8 meq/g
Mw : 18000

«Synthesis of polymer A-9»

Polyether ether ketone was sulfonated according to the method described in J. Membr. Sci. 229, 2004, 95 and thereafter, thereby obtaining a polymer A-9.

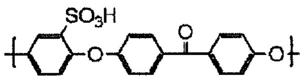

**A-9**

$SO_3H$ : 2.7 meq/g
Mw : 23000

<<Synthesis of polymer A-10>>

Polyphenylene oxide was sulfonated according to the method described in Chinese J. Polym. Sci. 20, No. 1, 2002, 53 and thereafter, thereby obtaining a polymer A-10.

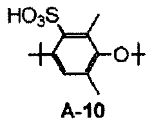

**A-10**

$SO_3H$ : 3.2 meq/g
Mw : 33000

<<Synthesis of polymer A-11>>

A polymer A-11 was obtained according to the method described in Example 2 in JP2008-533225A.

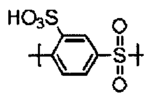

**A-11**

$SO_3H$ : 4.5 meq/g
Mw : 28000

<<Synthesis of polymer A-12>>

Polysulfone was sulfomethylated according to the method described in JP2004-131662A, thereby obtaining a polymer A-12.

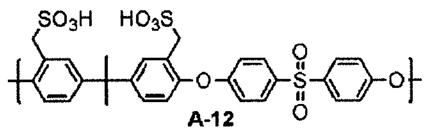

**A-12**

$SO_3H$ : 3.0 meq/g
Mw : 42000

<<Synthesis of polymer A-13>>

A polymer A-13 was obtained according to the method described in JP2008-27890A.

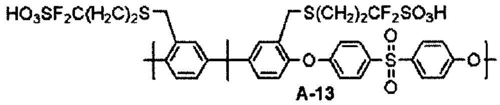

A-13
$SO_3H$ : 2.4 meq/g
Mw : 43000

<<Synthesis of polymer A-14>>

4.4'-diaminobiphenyl-2,2'-disulfonic acid (6.89 g), 120 ml of m-cresol, and trimethylamine (4.86 g) were added to a three-neck flask and were stirred under a nitrogen flow until the solution became homogeneous. 4.4'-oxydiphthalate (6.20 g) and benzoic acid (6.84 g) were added to the solution and the components were reacted at 80°C for 4 hours and then at 180°C for 20 hours. After the reaction temperature was returned to room temperature, the reaction solution was added dropwise to acetone. The obtained precipitate was filtered, was dissolved in methanol, and then was salt-exchanged to a proton type using Amberlyst 15 (hydrogen form) (manufactured by Sigma-Aldrich Co., LLC.), thereby obtaining a polymer A-14 (9.2 g).

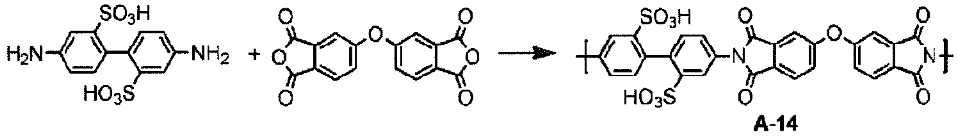

A-14
$SO_3H$ : 3.1 meq/g
Mw : 18000

<<Synthesis of polymer A-15>>

Polysulfone was phosphomethylated according to the method described in J. Membr. Sci. 360, 2010, 26 and thereafter, thereby obtaining a polymer A-15.

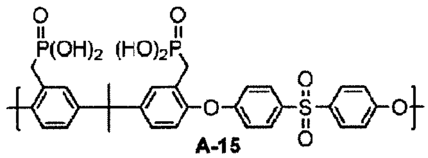

A-15
$P(=O)(OH)_2$ : 2.6 meq/g
Mw : 39000

<Synthesis of copper complex>

<<Synthesis of copper complex Cu-1>>

Copper hydroxide (556 mg) was added to a 20% aqueous solution of the polymer A-1 (20 g) and the components were stirred at room temperature for 3 hours, thereby dissolving copper hydroxide. Therefore, an aqueous solution of a copper complex (hereinafter, also referred to as engineering plastic copper complex) was obtained.

<<Synthesis of Cu-2 to Cu-15>>

Copper complexes Cu-2 to Cu-15 were synthesized in the same manner as in the synthesis of the copper complex Cu-1 except for the fact that the ratios between the equivalent weight of an acid group in the polymer A-1 and the equivalent weight of a copper atom were adjusted as described in Table 4.

[Table 4]

| Copper complex | Polymer used (A1) | Acid group equivalent weight of polymer (A1) /equivalent weight of copper atom |
|---|---|---|
| Cu-2 | A-2 | 1/0.475 |
| Cu-3 | A-3 | 1/0.475 |

(continued)

| Copper complex | Polymer used (A1) | Acid group equivalent weight of polymer (A1) /equivalent weight of copper atom |
|---|---|---|
| Cu-4 | A-4 | 1/0.475 |
| Cu-5 | A-5 | 1/0.475 |
| Cu-6 | A-6 | 1/0.475 |
| Cu-7 | A-7 | 1/0.38 |
| Cu-8 | A-8 | 1/0.475 |
| Cu-9 | A-9 | 1/0.475 |
| Cu-10 | A-10 | 1/0.475 |
| Cu-11 | A-11 | 1/0.475 |
| Cu-12 | A-12 | 1/0.475 |
| Cu-13 | A-13 | 1/0.475 |
| Cu-14 | A-14 | 1/0.475 |
| Cu-15 | A-15 | 1/0.475 |

<<Preparation Example 10>>

The following components were mixed together according to the formulation described in Table 5 below, thereby preparing a near-infrared absorbing composition 10.

- Copper complex A (copper complex having the following sulfophthalic acid as a ligand)
- Engineering plastic copper complex Cu-1 described above
- Binder A described below
- Surfactant A described below
- Solvent (water)

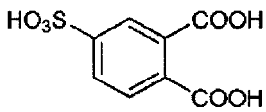

Binder A: the following compound (Mw: 24,000)

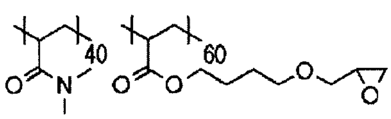

Surfactant A: OLEFIN E1010 (manufactured by Nissin Chemical Co., Ltd.)

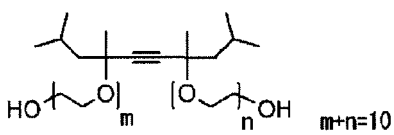

The copper complex A was synthesized as described below.

A 53.1% aqueous solution of sulfophthalic acid (13.49 g, 29.1 mmol) was dissolved in 50 mL of methanol, the solution was heated to 50°C, then, copper hydroxide (2.84 g, 29.1 mmol) was added, and the components were reacted at 50°C for 2 hours. After the end of the reaction, the solvent and the generated water were distilled away using an

evaporator, thereby obtaining a copper complex A (8.57 g).

<<Preparation Examples 11 to 24>>

Near-infrared absorbing compositions 11 to 24 were prepared in the same manner as in Preparation Example 10 except for the fact that the engineering plastic copper complexes Cu-2 to Cu-15 were respectively used instead of the engineering plastic copper complex Cu-1 in the near-infrared absorbing composition 10.

It was confirmed that, in the near-infrared absorbing compositions 10 to 24 (Compositions 10 to 24 in Table 5), the near-infrared absorbing performance was improved.

[Table 5]

| | Copper complex (29.7 parts by mass) | Engineering plastic copper complex (9.9 parts by mass) | Binder (59.7 parts by mass) | Surfactant (1 part by mass) | Solvent (amount at which the solid content concentration in the composition reaches 20% by mass) |
|---|---|---|---|---|---|
| Composition 10 | Copper complex A | Cu-1 | Binder A | Surfactant A | Water |
| Composition 11 | Copper complex A | Cu-2 | Binder A | Surfactant A | Water |
| Composition 12 | Copper complex A | Cu-3 | Binder A | Surfactant A | Water |
| Composition 13 | Copper complex A | Cu-4 | Binder A | Surfactant A | Water |
| Composition 14 | Copper complex A | Cu-5 | Binder A | Surfactant A | Water |
| Composition 15 | Copper complex A | Cu-6 | Binder A | Surfactant A | Water |
| Composition 16 | Copper complex A | Cu-7 | Binder A | Surfactant A | Water |
| Composition 17 | Copper complex A | Cu-8 | Binder A | Surfactant A | Water |
| Composition 18 | Copper complex A | Cu-9 | Binder A | Surfactant A | Water |
| Composition 19 | Copper complex A | Cu-10 | Binder A | Surfactant A | Water |
| Composition 20 | Copper complex A | Cu-11 | Binder A | Surfactant A | Water |
| Composition 21 | Copper complex A | Cu-12 | Binder A | Surfactant A | Water |
| Composition 22 | Copper complex A | Cu-13 | Binder A | Surfactant A | Water |
| Composition 23 | Copper complex A | Cu-14 | Binder A | Surfactant A | Water |
| Composition 24 | Copper complex A | Cu-15 | Binder A | Surfactant A | Water |

<<Production of near-infrared blocking filter>>

Near-infrared blocking filters of Examples 10 to 25 were produced using the near-infrared absorbing compositions prepared in Preparation Examples 10 to 24.

<Examples 10 to 24>

A photoresist was applied to a glass substrate and was patterned through lithography so as to form partition walls of the photoresist, thereby forming a dropwise addition region of the near-infrared absorbing composition. Each of the near-infrared absorbing compositions of Preparation Examples 10 to 24 (3 ml) was added dropwise. After the coated film-attached substrate was left to stand at room temperature for 24 hours so as to be dried, the thickness of the coated film was evaluated and the film thickness was 191 μm. For the obtained near-infrared absorbing filters of Examples 10 to 24, the visible light transmissivities in a wavelength range of 450 nm to 550 nm were 85% or more and the visible light transmissivities in a wavelength range of 800 nm to 900 nm were 20% or less.

Particularly, in the near-infrared absorbing filter of Example 10, the transmissivity in the entire wavelength range of 400 nm to 550 nm was 90% or more, the transmissivity at a wavelength of 700 nm was 15% or less, and the transmissivity in the entire wavelength range of 750 nm to 850 nm was 10% or less.

## Claims

**1.** A near-infrared blocking filter comprising:

(i) a near-infrared absorbing substance which is a copper compound represented by the following formula (A):

$$Cu(L)_{n1}\cdot(X)_{n2} \qquad \text{Formula (A)}$$

wherein L represents a ligand that coordinates copper; X is absent or represents a halogen atom, $H_2O$, $NO_3$, $ClO_4$, $SO_4$, CN, SCN, $BF_4$, $PF_6$, $BPh_4$ or an alcohol; and n1 and n2 are independently an integer from 1 to 4; and
(ii) a water-soluble binder selected from gelatin derived from an animal protein and a sol-gel substance obtained by hydrolyzing and polycondensing one or more alkoxide compounds of an element selected from Si, Ti, Zr and Al;
wherein:

the filter has a film thickness of 300 μm or less,
the visible light transmissivity of the filter in the wavelength range of 450 nm to 550 nm is 85% or more,
the light transmissivity of the filter at a wavelength of 800 nm is 20% or less, and
the light transmissivity of the filter at a wavelength of 850 nm is 20% or less.

**2.** A near-infrared blocking filter according to claim 1, wherein the ligand L is a phosphoric acid compound, a sulfonic acid compound, or a salt thereof.

**3.** A near-infrared blocking filter according to claim 1, wherein the ligand L is represented by the following formula (i):

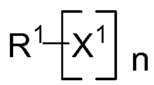

Formula (i)

wherein $R^1$ represents an n-valent organic group, each $X^1$ represents an acid group, and n represents an integer of from 1 to 6.

**4.** A near-infrared blocking filter according to claim 3, wherein each $X^1$ is a sulfonic acid group or a carboxylic acid group, and n is an integer from 2 to 6.

**5.** A near-infrared blocking filter according to any preceding claim, wherein the ligand comprises a sulfonic acid group and a carboxylic acid group.

**6.** A near-infrared blocking filter according to claim 4, wherein the ligand is sulfophthalic acid having the following structure:

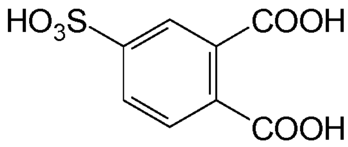

7. A near-infrared blocking filter according to any preceding claim, which has a film thickness of 200 μm or less.

8. A near-infrared blocking filter according to any preceding claim, wherein the visible light transmissivity in the wavelength range of 400 nm to 575 nm is 85% or more.

9. A near-infrared blocking filter according to any preceding claim, wherein the visible light transmissivity in the wavelength range of 450 nm to 550 nm is 90% or more.

10. A near-infrared blocking filter according to any preceding claim, wherein the light transmissivity in the wavelength range of 700 nm to 1100 nm is 20% or less.

11. A near-infrared blocking filter according to any preceding claim, wherein the light transmissivity in the wavelength range of 800 nm to 900 nm is 10% or less.

12. A near-infrared blocking filter according to any preceding claim, wherein the light transmissivity at a wavelength of 900 nm is 20% or less.

13. A near-infrared blocking filter according to any preceding claim, further comprising a subsidiary near-infrared absorbing substance.

14. A near-infrared blocking filter according to claim 13, wherein the subsidiary near-infrared absorbing substance is a metallic oxide.

15. A near-infrared blocking filter according to claim 14, wherein the subsidiary near-infrared absorbing substance is cesium tungsten oxide.

16. A method of producing a near-infrared blocking filter as defined in claim 1 comprising the steps of:

applying a near-infrared absorbing composition onto a support, the composition comprising a near-infrared absorbing substance and a water-soluble binder as defined in claim 1; and
drying the near-infrared absorbing composition on the support so as to form the near-infrared blocking filter.

17. A near-infrared absorbing composition comprising a near-infrared absorbing substance and a water-soluble binder as defined in claim 1, wherein a film having a thickness of 300 μm or less formed from the composition has a visible light transmissivity in the wavelength range of 450 nm to 550 nm of 85% or more, a light transmissivity at a wavelength of 800 nm of 20% or less, and a light transmissivity at a wavelength of 850 nm of 20% or less.

18. A near-infrared absorbing composition according to claim 17, wherein the amount of the copper compound blended in the solid content of the composition is in the range of 30% by mass to 90% by mass.

19. A camera module comprising:

a solid-state imaging element substrate; and
a near-infrared blocking filter according to any of claims 1-15 disposed on a light-receiving side of the solid-state imaging element substrate.

20. A method of producing a camera module as defined in claim 19 comprising the step of applying a composition comprising a near-infrared absorbing substance and a water-soluble binder as defined in claim 1 onto the light-receiving side of a solid-state imaging element substrate.

**Patentansprüche**

1. Nahinfrarot-blockierender Filter, umfassend:

   (i) eine Nahinfrarot-absorbierende Substanz, welche eine durch die folgende Formel (A) dargestellte Kupferverbindung ist:

   $Cu(L)_{n1} \cdot (X)_{n2}$ Formel (A)

   worin L einen Liganden darstellt, der an Kupfer koordiniert; X nicht vorliegt oder ein Halogenatom, $H_2O$, $NO_3$, $ClO_4$, $SO_4$, CN, SCN, $BF_4$, $PF_6$, $BPh_4$ oder einen Alkohol darstellt; und n1 und n2 unabhängig eine ganze Zahl von 1 bis 4 sind; und
   (ii) ein wasserlösliches Bindemittel, ausgewählt aus Gelatine, erhalten aus einem tierischen Protein, und einer Sol-Gel-Substanz, erhalten durch Hydrolysieren und Polykondensieren von einer oder mehrerer Alkoxidverbindungen eines Elements, ausgewählt aus Si, Ti, Zr und Al;
   worin:

   der Filter eine Filmdicke von 300 $\mu$m oder weniger aufweist;
   die Durchlässigkeit des Filters für sichtbares Licht im Wellenlängenbereich von 400 nm bis 550 nm 85 % oder mehr beträgt,
   die Lichtdurchlässigkeit des Filters bei einer Wellenlänge von 800 nm beträgt 20 % oder weniger und
   die Lichtdurchlässigkeit des Filters bei einer Wellenlänge von 850 nm beträgt 20 % oder weniger.

2. Nahinfrarot-blockierender Filter gemäß Anspruch 1, worin der Ligand (L) eine Phosphorsäureverbindung, eine Sulfonsäureverbindung oder ein Salz hiervon ist.

3. Nahinfrarot-blockierender Filter gemäß Anspruch 1, worin der Ligand (L) durch die folgende Formel (i) dargestellt wird:

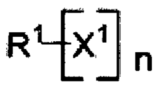
Formel (i)

   worin $R^1$ eine n-valente organische Gruppe darstellt; jedes $X^1$ eine Säuregruppe darstellt, und n eine ganze Zahl von 1 bis 6 darstellt.

4. Nahinfrarot-blockierender Filter gemäß Anspruch 3, worin jedes $X^1$ eine Sulfonsäuregruppe oder eine Carbonsäuregruppe ist und n eine ganze Zahl von 2 bis 6 ist.

5. Nahinfrarot-blockierender Filter gemäß irgendeinem vorstehenden Anspruch, worin der Ligand eine Sulfonsäuregruppe und eine Carbonsäuregruppe umfasst.

6. Nahinfrarot-blockierender Filter gemäß Anspruch 4, worin der Ligand eine Sulfophthalsäure mit der folgenden Struktur ist:

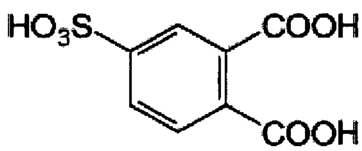

7. Nahinfrarot-blockierender Filter gemäß irgendeinem vorstehenden Anspruch, welcher eine Filmdicke von 200 $\mu$m oder kleiner aufweist.

8. Nahinfrarot-blockierender Filter gemäß irgendeinem vorstehenden Anspruch, worin die Durchlässigkeit für sichtbares Licht im Wellenlängenbereich von 400 nm bis 575 nm 85 % oder mehr beträgt.

**9.** Nahinfrarot-blockierender Filter gemäß irgendeinem vorstehenden Anspruch, worin die Durchlässigkeit für sichtbares Licht im Wellenlängenbereich von 450 nm bis 550 nm 90 % oder mehr beträgt.

**10.** Nahinfrarot-blockierender Filter gemäß irgendeinem vorstehenden Anspruch, worin die Lichtdurchlässigkeit im Wellenlängenbereich von 700 nm bis 1.100 nm 20 % oder weniger beträgt.

**11.** Nahinfrarot-blockierender Filter gemäß irgendeinem vorstehenden Anspruch, worin die Lichtdurchlässigkeit im Wellenlängenbereich von 800 nm bis 900 nm 10 % oder weniger beträgt.

**12.** Nahinfrarot-blockierender Filter gemäß irgendeinem vorstehenden Anspruch, worin die Lichtdurchlässigkeit bei einer Wellenlänge von 900 nm 20 % oder weniger beträgt.

**13.** Nahinfrarot-blockierender Filter gemäß irgendeinem vorstehenden Anspruch, ferner umfassend eine subsidiäre Nahinfrarot-absorbierende Substanz.

**14.** Nahinfrarot-blockierender Filter gemäß Anspruch 13, worin die subsidiäre Nahinfrarot-absorbierende Substanz ein metallisches Oxid ist.

**15.** Nahinfrarot-blockierender Filter gemäß Anspruch 14, worin die subsidiäre Nahinfrarot-absorbierende Substanz Cäsium-Wolframoxid ist.

**16.** Verfahren zur Herstellung eines Nahinfrarot-blockierenden Filters, wie er in Anspruch 1 definiert ist, umfassend die schritte:

Auftragen einer Nahinfrarot-absorbierenden Zusammensetzung auf einen Träger, wobei die Zusammensetzung eine Nahinfrarot-absorbierende Substanz und ein wasserlösliches Bindemittel, wie in Anspruch 1 definiert, umfasst; und
Trocknen der Nahinfrarot-absorbierenden Zusammensetzung auf dem Träger, um so den Nahinfrarot-blockierenden Filter zu bilden.

**17.** Nahinfrarot-absorbierende Zusammensetzung, umfassend eine Nahinfrarot-absorbierende Substanz und ein wasserlösliches Bindemittel, wie in Anspruch 1 definiert, worin ein aus der Zusammensetzung gebildeter Film mit einer Dicke von 300 $\mu$m oder weniger eine Durchlässigkeit für sichtbares Licht im Wellenlängenbereich von 450 nm bis 550 nm von 85 % oder mehr, eine Lichtdurchlässigkeit bei einer Wellenlänge von 800 nm von 20 % oder weniger und eine Lichtdurchlässigkeit bei einer Wellenlänge von 850 nm von 20 % oder weniger aufweist.

**18.** Nahinfrarot-absorbierende Zusammensetzung gemäß Anspruch 17, worin die eingemischte Menge der Kupferverbindung im Feststoffgehalt der Zusammensetzung im Bereich von 30 Masse-% bis 90 Masse-% liegt.

**19.** Kameramodul, umfassend:

ein Festphasen-Bildgebungselement-Substrat; und
einen Nahinfrarot-blockierenden Filter gemäß irgendeinem der Ansprüche 1 bis 15, angeordnet auf der lichtaufnehmenden Seite des Festphasen-Bildgebungselement-Substrats.

**20.** Verfahren zur Herstellung eines wie in Anspruch 19 definierten Kameramoduls, umfassend den Schritt des Auftragens einer Zusammensetzung, die einen Nahinfrarot-absorbierende Substanz und ein wasserlösliches Bindemittel umfasst, wie in Anspruch 1 definiert, auf die lichtaufnehmende Seite eines Festphasen-Bildgebungselement-Substrats.

**Revendications**

**1.** Filtre de blocage du proche infrarouge comprenant :

(i) une substance absorbant le proche infrarouge qui est un composé de cuivre représenté par la formule (A) suivante :

$Cu(L)_{n1} \cdot (X)_{n2}$ Formule (A)

dans laquelle L représente un ligand qui se coordonne au cuivre, X est absent ou représente un atome d'halogène, $H_2O$, $NO_3$, $ClO_4$, $SO_4$, CN, SCN, $BF_4$, $PF_6$, $BPh_4$ ou un alcool ; et n1 et n2 sont indépendamment un nombre entier allant de 1 à 4 ; et
(ii) un liant hydrosoluble sélectionné parmi une gélatine dérivée d'une protéine animale et une substance sol-gel obtenue par l'hydrolyse et la polycondensation d'un ou de plusieurs composés d'alcoxyde d'un élément sélectionné parmi Si, Ti, Zr et Al ;
dans lequel :

le film présente une épaisseur de film de 300 µm ou moins,
la transmissivité de la lumière visible du filtre dans la plage de longueurs d'onde allant de 450 nm à 550 nm est de 85 % ou plus,
la transmissivité de la lumière du filtre à une longueur d'onde de 800 nm est de 20 % ou moins, et
la transmissivité de la lumière du filtre à une longueur d'onde de 850 nm est de 20 % ou moins.

**2.** Filtre de blocage du proche infrarouge selon la revendication 1, dans lequel le ligand L est un composé d'acide phosphorique, un composé d'acide sulfonique, ou un sel de ceux-ci.

**3.** Filtre de blocage du proche infrarouge selon la revendication 1, dans lequel le ligand L est représenté par la formule (i) suivante :

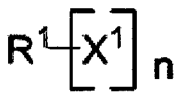

Formule (i)

dans laquelle $R^1$ représente un groupe organique n-valent, chaque $X^1$ représente un groupe acide, et n représente un nombre entier allant de 1 à 6.

**4.** Filtre de blocage du proche infrarouge selon la revendication 3, dans lequel chaque $X^1$ est un groupe acide sulfonique ou un groupe acide carboxylique, et n est un nombre entier allant de 2 à 6.

**5.** Filtre de blocage du proche infrarouge selon n'importe quelle revendication précédente, dans lequel le ligand comprend un groupe acide sulfonique et un groupe acide carboxylique.

**6.** Filtre de blocage du proche infrarouge selon la revendication 4, dans lequel le ligand est un acide sulfophtalique ayant la structure suivante :

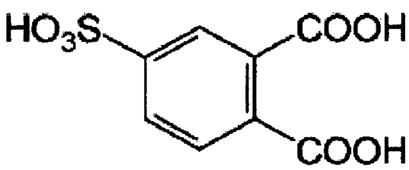

**7.** Filtre de blocage du proche infrarouge selon n'importe quelle revendication précédente, qui présente une épaisseur de film de 200 µm ou moins.

**8.** Filtre de blocage du proche infrarouge selon n'importe quelle revendication précédente, dans lequel la transmissivité de la lumière visible dans la plage de longueurs d'onde allant de 400 nm à 575 nm est de 85 % ou plus.

**9.** Filtre de blocage du proche infrarouge selon n'importe quelle revendication précédente, dans lequel la transmissivité de la lumière visible dans la plage de longueurs d'onde allant de 450 nm à 550 nm est de 90 % ou plus.

**10.** Filtre de blocage du proche infrarouge selon n'importe quelle revendication précédente, dans lequel la transmissivité de la lumière dans la plage de longueurs d'onde allant de 700 nm à 1100 nm est de 20 % ou moins.

11. Filtre de blocage du proche infrarouge selon n'importe quelle revendication précédente, dans lequel la transmissivité de la lumière dans la plage de longueurs d'onde allant de 800 nm à 900 nm est de 10 % ou moins.

12. Filtre de blocage du proche infrarouge selon n'importe quelle revendication précédente, dans lequel la transmissivité de la lumière à une longueur d'onde de 900 nm est de 20 % ou moins.

13. Filtre de blocage du proche infrarouge selon n'importe quelle revendication précédente, comprenant en outre une substance auxiliaire absorbant le proche infrarouge.

14. Filtre de blocage du proche infrarouge selon la revendication 13, dans lequel la substance auxiliaire absorbant le proche infrarouge est un oxyde métallique.

15. Filtre de blocage du proche infrarouge selon la revendication 14, dans lequel la substance auxiliaire absorbant le proche infrarouge est l'oxyde de césium et de tungstène.

16. Procédé de production d'un filtre de blocage du proche infrarouge tel que défini dans la revendication 1 comprenant les étapes suivantes :

l'application d'une composition absorbant le proche infrarouge sur un support, la composition comprenant une substance absorbant le proche infrarouge et un liant hydrosoluble tels que définis dans la revendication 1 ; et
le séchage de la composition absorbant le proche infrarouge sur le support afin de former le filtre de blocage du proche infrarouge.

17. Composition absorbant le proche infrarouge comprenant une substance absorbant le proche infrarouge et un liant hydrosoluble tels que définis dans la revendication 1, dans laquelle un film ayant une épaisseur de 300 $\mu$m ou moins formé à partir de la composition présente une transmissivité de la lumière visible dans la plage de longueurs d'onde allant de 450 nm à 550 nm de 85 % ou plus, une transmissivité de la lumière à une longueur d'onde de 800 nm de 20 % ou moins, et une transmissivité de la lumière à une longueur d'onde de 850 nm de 20 % ou moins.

18. Composition absorbant le proche infrarouge selon la revendication 17, dans laquelle la quantité du composé de cuivre mélangé dans le contenu solide de la composition est située dans la plage allant de 30 % en masse à 90 % en masse.

19. Module de caméra comprenant :

un substrat d'élément d'imagerie à semi-conducteurs ; et
un filtre de blocage du proche infrarouge selon l'une quelconque des revendications 1 à 15 disposé sur un côté de réception de lumière du substrat d'élément d'imagerie à semi-conducteurs.

20. Procédé de production d'un module de caméra tel que défini dans la revendication 19 comprenant l'étape d'application d'une composition comprenant une substance absorbant le proche infrarouge et un liant hydrosoluble tels que définis dans la revendication 1 sur le côté de réception de lumière d'un substrat d'élément d'imagerie à semi-conducteurs.

FIG. 1

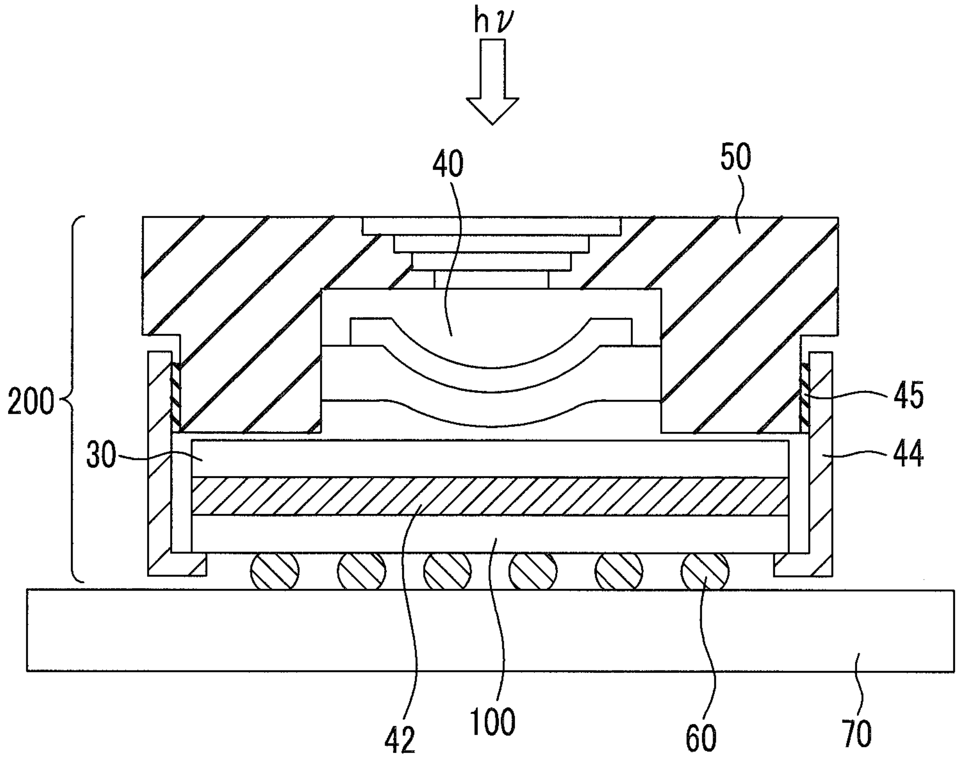

FIG. 2

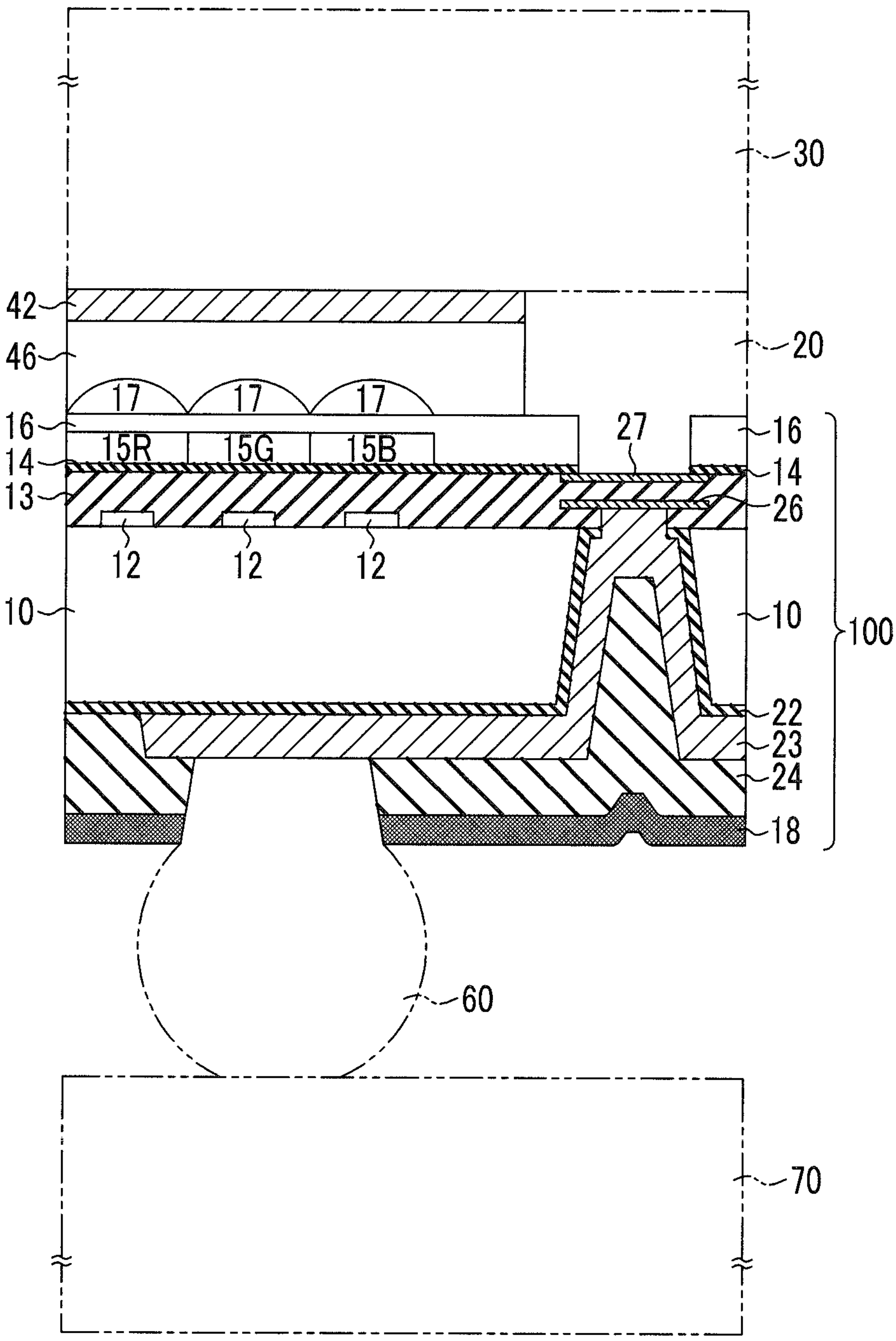
30
42
20
46
17
17
17
16
27
16
15R
15G
15B
14
14
13
26
12
12
12
10
10
100
22
23
24
18
60
70

FIG. 3

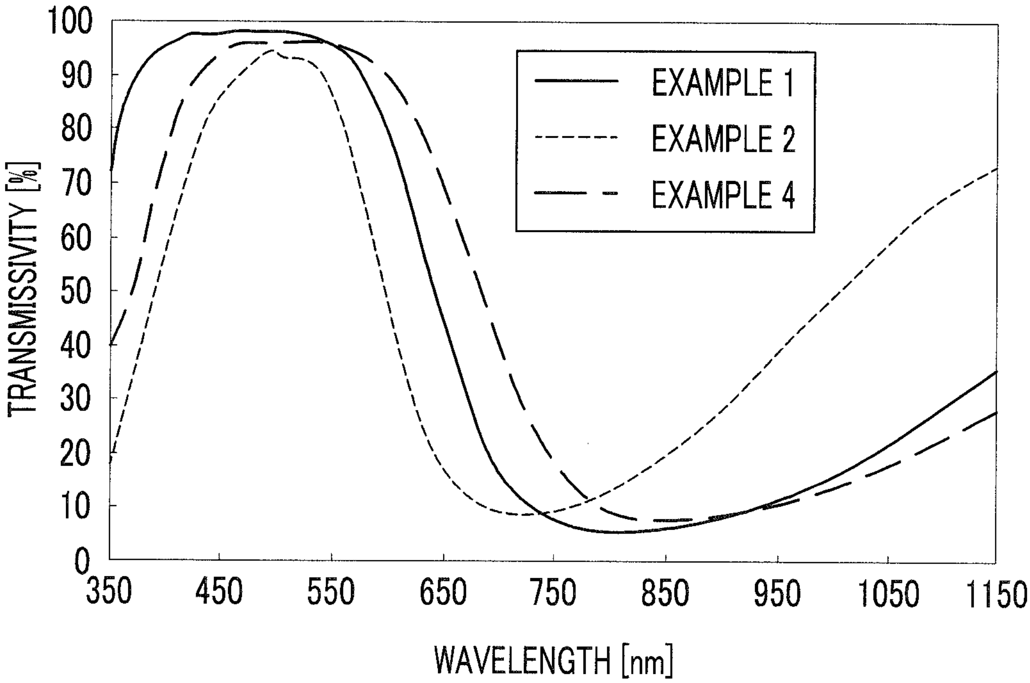
100
90
80
70
60
50
40
30
20
10
0
TRANSMISSIVITY [%]
350
450
550
650
750
850
950
1050
1150
WAVELENGTH [nm]
EXAMPLE 1
EXAMPLE 2
EXAMPLE 4

FIG. 4

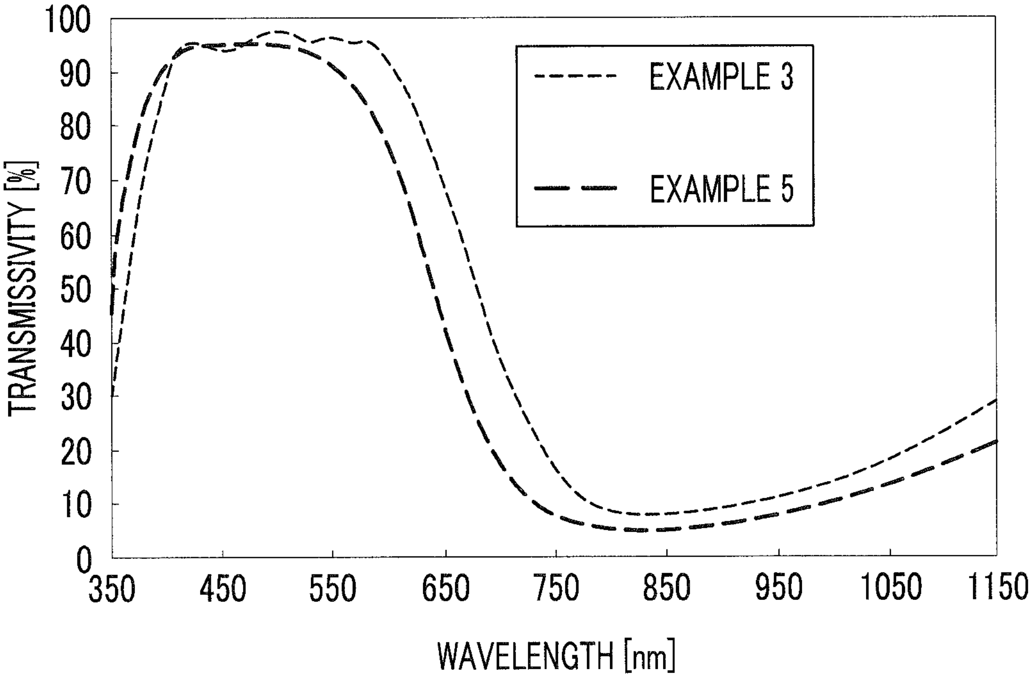
100
90
80
70
60
50
40
30
20
10
0
350
450
550
650
750
850
950
1050
1150
TRANSMISSIVITY [%]
WAVELENGTH [nm]
EXAMPLE 3
EXAMPLE 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2010134457 A
- WO 2005030898 A
- JP 2010106268 A
- US 20110124824 A
- JP 2006310068 A
- JP 2008027890 A
- JP 2002367627 A
- JP 2004035891 A
- JP 2012238579 A
- JP 4096205 B
- JP 2012194534 A
- JP 2009288705 A
- JP 48041708 B
- JP S4841708 B
- JP 50006034 B
- JP S506034 B
- JP 51037193 B
- JP S5137193 B
- JP 48064183 B
- JP S4864183 B
- JP 49043191 B
- JP 52030490 B
- JP S5230490 B
- JP 2010160418 A
- JP 2010129825 A
- JP 4364216 B
- JP 2008292970 A
- JP 10062986 A
- JP H1062986 A
- JP 2007269779 A
- JP 2012208494 A
- US 20120235099 A
- JP 51037193 A
- JP S5137193 A
- JP 2032293 B
- JP H232293 B
- JP 2016765 B
- JP H216765 B
- JP 58049860 B
- JP S5849860 B
- JP 56017654 B
- JP S5617654 B
- JP 62039417 B
- JP S6239417 B
- JP 62039418 B
- JP S6239418 B
- JP 63277653 A
- JP S63277653 A
- JP 63260909 A
- JP 1105238 A
- JP H1105238 A
- JP 2003262958 A
- JP 60208748 A
- JP 60214354 A
- JP 5036581 A
- JP H536581 A
- JP 5333542 A
- JP H5333542 A
- JP 7261407 A
- JP H7261407A B
- JP 10110008 A
- JP H10110008A B
- JP 10198031 A
- JP H10198031 A
- JP 2009265518 A
- JP 9269596 A
- JP H9269596 A
- JP 2002062648 A
- JP 2002162741 A
- JP 2003321022 A
- JP 2003339785 A
- JP 2012155288 A
- JP 2002090991 A
- JP 2007231000 A
- JP 2007322744 A
- JP 2009191061 A
- US 2012235099 A
- JP 2012032556 A
- JP 2012122045 A
- JP 10291969 A
- JP H10291969 A
- JP 4225898 B
- JP 2001233842 A
- JP 2012003225 A
- JP 2008250074 A
- US 2012068292 A
- JP 2012068418 A
- JP 2008533225 A
- JP 2004131662 A

**Non-patent literature cited in the description**

- *J. Membr. Sci,* 2004, vol. 229, 95
- *Chinese J. Polym. Sci,* 2002, vol. 20 (1
- *J. Membr. Sci,* 2010, vol. 360, 26